# EUROPEAN PATENT APPLICATION

(11) **EP 4 772 516 A1**
(43) Date of publication of application: **08.07.2026**
(21) Application number: 24860426.6
(22) Date of filing: 29.08.2024
(51) Int. Cl.: C07F 7/08, H10K 85/40, H10K 85/60, H10K 50/16

(54) **ORGANIC LIGHT-EMITTING COMPOUND AND ORGANIC ELECTROLUMINESCENT DEVICE USING SAME**

(30) Priority: 30.08.2023 KR 20230114689
(71) Applicant: Solus Advanced Materials Co., Ltd., Iksan-si, Jeollabuk-do 54584 (KR)
(72) Inventor: YANG, Seunggyu, Seongnam-si, Gyeonggi-do 13636 (KR); SIM, Jaeyi, Seongnam-si, Gyeonggi-do 13636 (KR); SIM, Sangeun, Seongnam-si, Gyeonggi-do 13636 (KR); LEE, Uigeon, Seongnam-si, Gyeonggi-do 13636 (KR)
(74) Representative: Office Freylinger
(86) International application number: PCT/KR2024/012942
(87) International publication number: WO 2025/048507

(57) **Abstract**

The present invention relates to: a novel compound exhibiting excellent carrier transport ability, light-emitting ability, and thermal stability; and an organic electroluminescent device comprising same in one or more organic layers, thereby having improved properties of luminous efficiency, driving voltages, lifespan and the like.

## Description

### Technical Field

The present invention relates to a novel organic compound and an organic electroluminescent device using the same and, more specifically, to a novel compound with excellent electron transporting ability, and an organic electroluminescent device exhibiting improved characteristics, such as luminous efficiency, driving voltages, and lifespan, by containing the novel compound in one or more organic layers.

### Background Art

In an organic electroluminescent device, upon the application of voltage between two electrodes, holes from an anode and electrons from a cathode are injected into organic layers. The injected holes and electrons combine with each other to form excitons, and the excitons fall down to the ground state to emit light. Particularly, materials used for the organic layers may be classified into light emission materials, hole injection materials, hole transport materials, electron transport materials, electron injection materials, and the like according to the function thereof.

Materials for forming an emissive layer of the organic electroluminescent device may be classified into blue, green and red light emission materials according to the color of light emission. Additionally, yellow and orange light emission materials may be used as light emission materials for displaying better natural colors. Additionally, host/dopant-based light emission materials may be used as light emission materials to increase color purity and improve luminous efficiency through energy transfer.

Dopant materials may be classified into fluorescent dopants using organic materials and phosphorescent dopants using metal complex compounds containing heavy atoms, such as Ir and Pt. These phosphorescent materials can theoretically improve the luminous efficiency up to four times compared to fluorescent materials, so research has been conducted on phosphorescent host materials as well as phosphorescent dopants.

Until today, NPB, BCP, Alq3, and the like have been widely known as materials for use in a hole injection layer, a hole transport layer, and an electron transport layer, and anthracene derivatives have been reported as the light emitting layer materials. In particular, among the light emitting layer materials, metal complex compounds containing Ir, such as Firpic, Ir(ppy)₃, (acac)Ir(btp)₂, and the like, which have advantages in terms of improving efficiency, are used as blue, green, and red phosphorescent dopant material, and 4,4-dicarbazollybiphenyl (CBP) is used as the phosphorescent host material.

However, conventional light emission materials have advantages in terms of light emission characteristics, but are not satisfactory in terms of lifespan of organic electroluminescent devices due to low glass transition temperatures and very poor thermal stability. Accordingly, there is a need to develop light emission materials with excellent performance.

### Disclosure of Invention

### Technical Problem

The present invention has been made to solve the above-mentioned problems, and an aspect of the present invention is to provide a novel compound, which can be used as a material for an organic layer of an organic electroluminescent device, specifically, a material for a light emitting layer (an emission layer), a lifespan improvement layer, a light emitting auxiliary layer, an electron transport layer, a electron transport auxiliary layer, or an emissive layer, due to excellent heat resistance, carrier transporting ability, and light emitting ability.

Another aspect of the present invention is to provide an organic electroluminescent device exhibiting a low driving voltage, high luminous efficiency, and improved lifespan by containing the above-described novel compound.

Other purposes and advantages of the present invention will be clarified by following detailed description and claims.

### Solution to Problem

To achieve the above objectives, the present invention provides a compound represented by the following Chemical Formula 1: 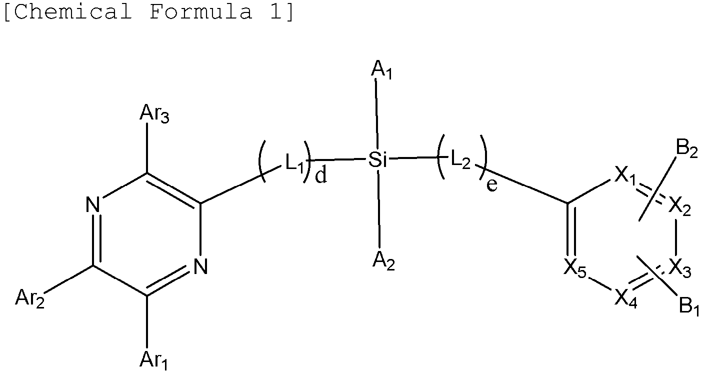 wherein in Chemical Formula 1,
Ar₁ to Ar₃ are the same as or different from each other and are each independently selected from the group consisting of a hydrogen, a deuterium (D), a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 ring atoms, a C₆-C₆₀ aryl group, a heteroaryl group having 5 to 60 ring atoms, a C₁-C₄₀ alkyloxy group, a C₆-C₆₀ aryloxy group, a C₃-C₄₀ alkylsilyl group, a C₆-C₆₀ arylsilyl group, a C₁-C₄₀ alkylboron group, a C₆-C₆₀ arylboron group, a C₆-C₆₀ arylphosphine group, a C₆-C₆₀ arylphosphine oxide group, and a C₆-C₆₀ arylamine group, provided that cases where at least two of Ar₁ to Ar₃ are hydrogen are excluded,
X₁ to X₃ are the same as or different from each other and are each independently C(R₁) or N, provided that at least two of X₁ to X₅ are N;
When there are a plurality of R₁, the plurality of R₁ are the same as or different from one another and are each independently selected from the group consisting of a hydrogen, a deuterium (D), a halogen, a cyano group, a nitro group, a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 ring atoms, a C₆-C₆₀ aryl group, a heteroaryl group having 5 to 60 ring atoms, a C₁-C₄₀ alkyloxy group, a C₆-C₆₀ aryloxy group, a C₃-C₄₀ alkylsilyl group, a C₆-C₆₀ arylsilyl group, a C₁-C₄₀ alkylboron group, a C₆-C₆₀ arylboron group, a C₆-C₆₀ aryl phosphine group, a C₆-C₆₀ arylphosphine oxide group, and a C₆-C₆₀ arylamine group, wherein two of the plurality of R₁ are represented by B₁ and B₂ respectively,
A₁ to A₂ and B₁ to B₂ are the same as or different from one another and are each independently selected from the group consisting of a hydrogen, a deuterium (D), a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 ring atoms, a C₆-C₆₀ aryl group, a heteroaryl group having 5 to 60 ring atoms, a C₁-C₄₀ alkyloxy group, a C₆-C₆₀ aryloxy group, a C₃-C₄₀ alkylsilyl group, a C₆-C₆₀ arylsilyl group, a C₁-C₄₀ alkylboron group, a C₆-C₆₀ arylboron group, a C₆-C₆₀ aryl phosphine group, a C₆-C₆₀ arylphosphine oxide group, and a C₆-C₆₀ arylamine group,
L₁ and L₂ are the same as or different from one another and are each independently a single bond, or selected from the group consisting of a C₆ to C₁₈ arylene group and a heteroarylene group having 5 to 18 nuclear atoms,
d and e are each independently an integer of 0 to 4, and
the arylene group, the heteroarylene group of L₁ and L₂; and the alkyl group, alkenyl group, alkynyl group, aryl group, heteroaryl group, aryloxy group, alkyloxy group, cycloalkyl group, heterocycloalkyl group, alkylsilyl group, arylsilyl group, alkylboron group, arylboron group, arylphosphine group, arylphosphine oxide group, and arylamine group of Ar₁ to Ar₃, R₁, A₁ to A₂, and B₁ to B₂ may be each independently substituted with at least one substituent selected from the group consisting of a deuterium (D), a halogen, a cyano group, a nitro group, a C₁ to C₄₀ alkyl group, a C₂ to C₄₀ alkenyl group, a C₂ to C₄₀ alkynyl group, a C₃ to C₄₀ cycloalkyl group, a heterocycloalkyl group having 3 to 40 ring atoms, a C₆ to C₆₀ aryl group, a heteroaryl group having 5 to 60 ring atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a C₆ to C₆₀ arylphosphine group, a C₆ to C₆₀ arylphosphine oxide group, and a C₆ to C₆₀ arylamine group, and wherein when the substituent is present in a plural number, they may be the same or different from each other.

In addition, the present invention also provides an organic electroluminescent device including: an anode, a cathode, and one or more organic layers disposed between the anode and the cathode, wherein at least one of the one or more organic layers includes the compound represented by Chemical Formula 1.

In such a case, the organic layer including the compound represented by Chemical Formula 1 may be selected from a light emitting layer, a light emitting auxiliary layer, a hole injection layer, a hole transport layer, an electron injection layer, a lifespan improvement layer, an electron transport layer, and an auxiliary electron transport layer. In this case, the compound represented by Chemical Formula 1 may be included as at least one material selected from the group consisting of a phosphorescent host material of the light emitting layer, an electron transport layer, and an electron transport auxiliary layer.

### EFFECTS OF THE INVENTION

According to an embodiment of the present invention, a compound represented by Chemical Formula 1 has excellent characteristics such as an electron transport ability, luminescence ability, heat resistance, and the like, and thereby is applicable as an organic layer material of an organic electroluminescent device.

In particular, when the compound represented by Chemical Formula 1 of the present invention is used as an electron transport layer material, an electron transport auxiliary layer material, or a light emitting auxiliary layer material, it may exhibit high thermal stability, low driving voltage, rapid mobility, high current efficiency and long lifespan characteristics compared to conventional host materials or electron transport materials.

Accordingly, the organic electroluminescent device including the compound of Chemical Formula 1 may be significantly improved in aspects such as excellent light emitting performance, low driving voltage, long lifespan, and high efficiency, and thus may be effectively applied to full color display panels and the like.

Effects according to the present invention are not limited by the description exemplified above, and more diverse effects are included in the present specification.

### DETAILED DESCRIPTION OF THE INVENTION

Hereinafter, the present invention will be described in detail.

### <Novel organic compound>

The compound of Formula 1 according to the present invention forms a basic skeleton in which two azine-based moieties (e.g., a pyrazine group, or a pyrimidine/triazine group) having electron withdrawing groups (EWG) are present at both terminals of the molecule, with a silane group interposed therebetween, wherein these components are either directly connected or linked via separate linkers (e.g., L₁ to L₂).

The compound of Chemical Formula 1 having such a structure includes, in its molecular structure, a triazine/pyrimidine group and a pyrazine group as functional groups each having strong electron-withdrawing capability, thereby constituting a dual-EWG structure [e.g., triazine/pyrimidine group (EWG1) - silane group - pyrazine group (EWG2)]. As a result, the compound exhibits advantageous characteristics in electron injection and transport, thereby enhancing electron transportability to the light-emitting layer and providing an excellent effect in improving the initial driving voltage of the device.

Further, as different dual electron-withdrawing groups (EWGs), for example, a triazine/pyrimidine group and a pyrazine group, are disposed on opposite sides of the silane group, an asymmetric structure is formed along the molecular long axis. The compound of the present invention combines a high triplet (T1) energy level derived from such structural asymmetry with the low-voltage characteristics of the pyrazine group, thereby lowering the driving voltage of the device while enhancing the strong electron-withdrawing properties of azine groups such as triazine and pyrimidine, resulting in a synergistic improvement in device efficiency. Accordingly, when the compound of Chemical Formula 1 is applied as a material for an electron transport layer or an electron transport auxiliary layer, electrons can be readily accepted from the cathode and smoothly delivered to the light-emitting layer, thereby lowering the driving voltage and enabling high efficiency and long device lifetime. In particular, since the compound according to the present invention has an asymmetric structure, it exhibits no crystallization temperature (Tc) in its thermal characteristics, thereby providing advantages in terms of processability.

In addition, since the present invention employs an aromatic hydrocarbon group and a fused, structurally stable framework rather than a simple aliphatic ring group, the thermal stability of the material can be enhanced. Furthermore, as the material exhibits no crystallization temperature (Tc), it is advantageous for device processability as well as for improving device lifetime.

Additionally, the compound represented by Chemical Formula 1 includes a silyl (Si)-based moiety at the center of the molecule, thereby interrupting electron conjugation and providing a high triplet (T1) energy level through steric hindrance. As a result, the compound not only provides effective hole-blocking capability but also retains a capacity to quench excess excitons when they are generated, thereby preventing excitons formed in the emission layer from diffusing into an adjacent electron transport layer or hole transport layer. Consequently, the number of excitons contributing to light emission within the emission layer may be increased, leading to improved luminous efficiency of the device while enhancing device durability and stability, thereby contributing to an extended device lifetime. Furthermore, the introduction of the silane-based moiety increases the molecular weight and secures a high glass transition temperature (Tg), significantly improving heat resistance.

Furthermore, the compound represented by Chemical Formula 1 is highly advantageous for electron transport and exhibits low driving voltage, high efficiency, and long device lifetime characteristics. The excellent electron-transport capability of the compound enables high efficiency and fast mobility in an organic electroluminescent device, and allows for facile control of HOMO and LUMO energy levels depending on the orientation or position of substituents. Accordingly, an organic electroluminescent device employing the compound may exhibit superior electron-transport properties.

The compound represented by Formula 1 according to the present invention includes two different nitrogen-containing heteroaromatic rings (e.g., pyrimidine/triazine and pyrazine) and a silane-based moiety, and has a basic skeleton structure in which these components are either directly connected or linked via separate linkers (e.g., L₁ to L₂).

The silane-based moiety positioned at the center of the compound represented by Chemical Formula 1 may be any conventionally known tetravalent silyl or silane moiety (-SiA₁A₂-) without particular limitation. In the silane-based moiety, A₁ and A₂ may each be independently substituted. A₁ to A₂ may be the same as or different from each other and may be each independently selected from the group consisting of a hydrogen, a deuterium (D), a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 ring atoms, a C₆-C₆₀ aryl group, a heteroaryl group having 5 to 60 ring atoms, a C₁-C₄₀ alkyloxy group, a C₆-C₆₀ aryloxy group, a C₃-C₄₀ alkylsilyl group, a C₆-C₆₀ arylsilyl group, a C₁-C₄₀ alkylboron group, a C₆-C₆₀ arylboron group, a C₆-C₆₀ aryl phosphine group, a C₆-C₆₀ arylphosphine oxide group, and a C₆-C₆₀ arylamine group. Specifically, A₁ to A₂ may be the same as or different from each other and may be each independently selected from the group consisting of a C₆-C₆₀ aryl group, and a heteroaryl group having 5 to 60 ring atoms, more specifically they may be a C₆-C₄₀ aryl group.

In an embodiment of the present invention, A₁ and A₂ may be the same as or different from each other and may each independently be more specifically embodied as any one of the following structural formulas. However, it is not limited thereto. 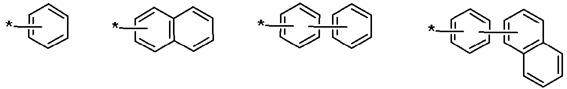 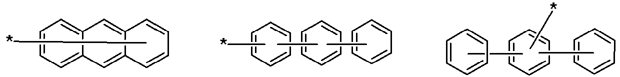 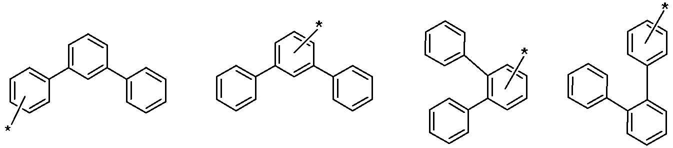 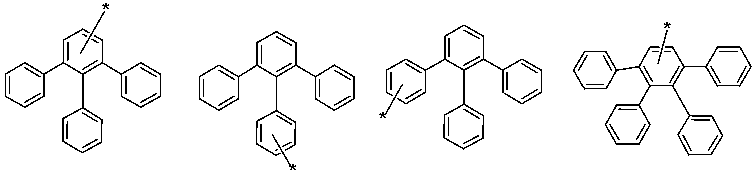 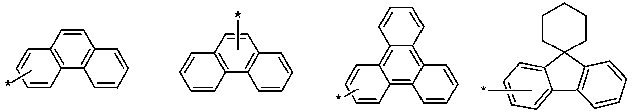 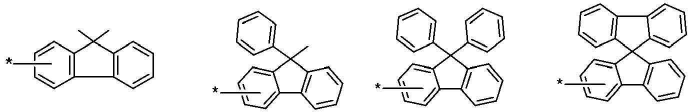 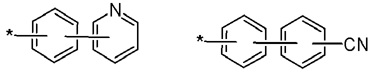 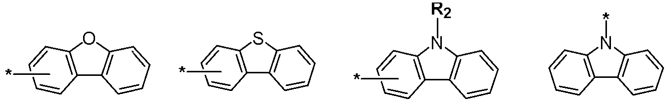 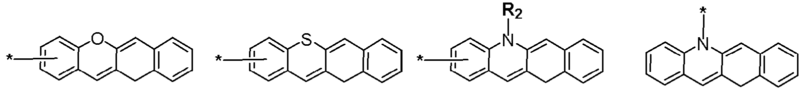 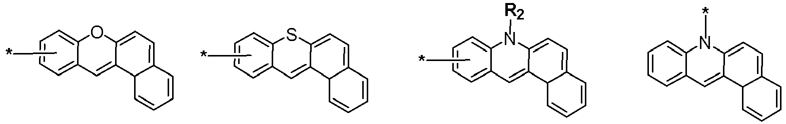 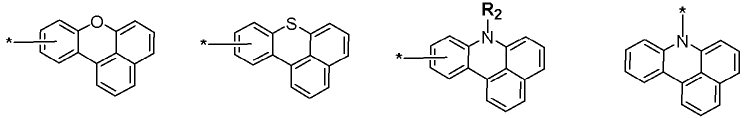 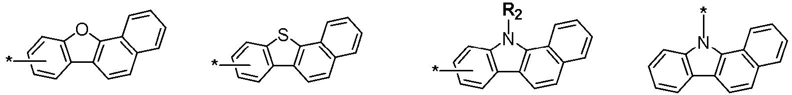 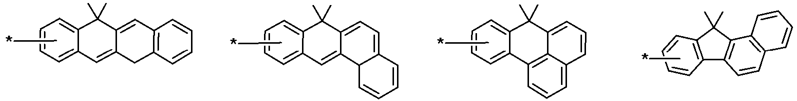 wherein the formulas,
* indicates a site where a bond with Chemical Formula 1 is made, and
R₂ is selected from the group consisting of a hydrogen, a deuterium (D), a C₁-C₄₀ alkyl group, a C₆-C₆₀ aryl group, and a heteroaryl group having 5 to 60 nuclear atoms. In addition, although not shown in the above structural formulas, at least one substituent known in the art (e.g., the same as the definition of R₁) may be substituted.

Two different EWG groups (e.g., nitrogen-containing heterocycles) are substituted on one side and the other side of the silane-based moiety to form an asymmetric dual EWG structure. Examples of these two EWG groups may include a pyrazine group and a pyrimidine/triazine group (e.g., a ring containing X₁ to X₃).

The ring containing X₁ to X₅, which is a type of azine group, may be a monocyclic nitrogen-containing heteroaromatic ring conmprising at least two nitrogen atoms. For an example of the nitrogen-containing heteroaromatic ring (e.g., X₁ to X₅-containing ring), X₁ to X₅ may be the same as or different from each other, and may each independently be C(R₁) or N, provided that at least two of X₁ to X₅ are N. For specific example, X₁ to X₅ includes two to three nitrogen atoms (N). As such, since the heterocycle containing two to three nitrogen atoms (N) is included, more excellent electron absorption characteristics may be exhibited, which is advantageous for electron injection and transport.

Each R₁ positioned on the nitrogen-containing heteroaromatic ring (e.g., a ring containing X₁ to X₅) may be the same as or different from each other and may be each independently selected from the group consisting of a hydrogen, a deuterium (D), a halogen, a cyano group, a nitro group, a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 ring atoms, a C₆-C₆₀ aryl group, a heteroaryl group having 5 to 60 ring atoms, a C₁-C₄₀ alkyloxy group, a C₆-C₆₀ aryloxy group, a C₃-C₄₀ alkylsilyl group, a C₆-C₆₀ arylsilyl group, a C₁-C₄₀ alkylboron group, a C₆-C₆₀ arylboron group, a C₆-C₆₀ aryl phosphine group, a C₆-C₆₀ arylphosphine oxide group, and a C₆-C₆₀ arylamine group. Specifically, R₁ may preferably be selected from the group consisting of a hydrogen, a deuterium (D), a halogen, a cyano group, a C₆-C₆₀ aryl group, and a heteroaryl group having 5 to 60 ring atoms.

In this case, two of the plurality of R₁ groups located on the nitrogen-containing heteroaromatic ring (e.g., a ring containing X₁ to X₅) may be represented by B₁ and B₂. B₁ to B₂ may be the same as or different from each other and may be each independently selected from the group consisting of a hydrogen, a deuterium (D), a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 ring atoms, a C₆-C₆₀ aryl group, a heteroaryl group having 5 to 60 ring atoms, a C₁-C₄₀ alkyloxy group, a C₆-C₆₀ aryloxy group, a C₃-C₄₀ alkylsilyl group, a C₆-C₆₀ arylsilyl group, a C₁-C₄₀ alkylboron group, a C₆-C₆₀ arylboron group, a C₆-C₆₀ aryl phosphine group, a C₆-C₆₀ arylphosphine oxide group, and a C₆-C₆₀ arylamine group. Specifically, B₁ to B₂ may be the same as or different from each other and may be each independently selected from the group consisting of a non-hydrogen substituent, for example, a C₆-C₆₀ aryl group, and a heteroaryl group having 5 to 60 ring atoms, and more specifically may be a C₆-C₄₀ aryl group.

In an embodiment of the present invention, the nitrogen-containing heteroaromatic ring (e.g., X₁ to X₅-containing ring) may be any one selected from the following structural formulas. However, it is not limited thereto. 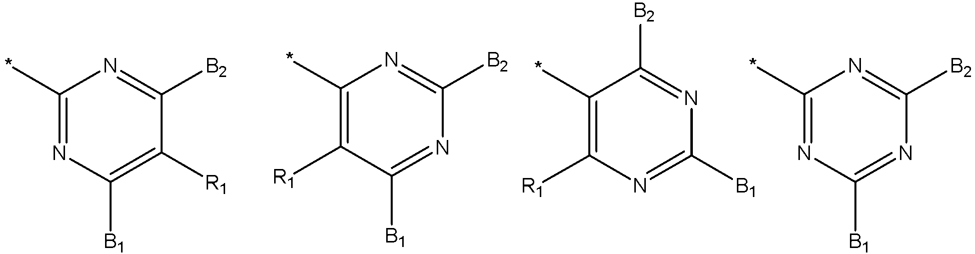 wherein the formulas,
* indicates a site where a bond with Chemical Formula 1 is made, and
R₁, B₁ and B₂ are each as defined in Chemical Formula 1. Specifically, R₁ is selected from the group consisting of hydrogen, a deuterium (D), a halogen, a cyano group, a C₁-C₄₀ alkyl group, a C₆-C₆₀ aryl group, and a heteroaryl group having 5 to 60 nuclear atoms. B₁ and B₂ may each independently be a non-hydrogen substituent, and specifically, it is preferable that each of B₁ and B₂ is selected from the group consisting of a C₆-C₆₀ aryl group, and a heteroaryl group having 5 to 60 nuclear atoms.

In a more specific embodiment of the present invention, B₁ and B₂ may be the same as or different from each other and may each independently be more specifically embodied as any one of the following structural formulas. However, it is not limited thereto. 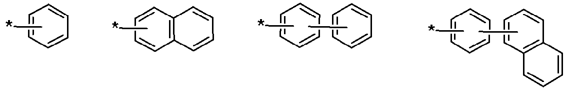 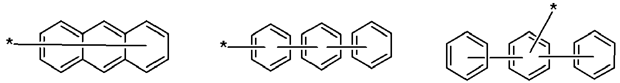 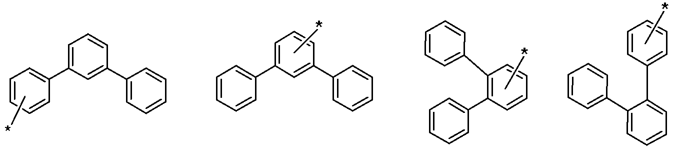 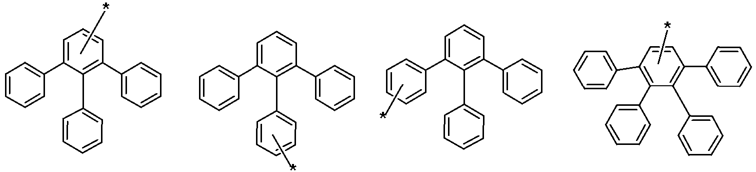 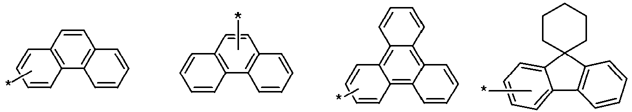 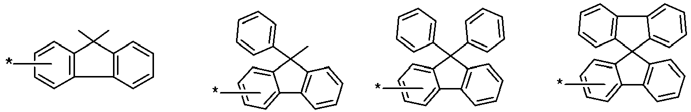 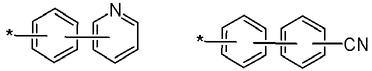 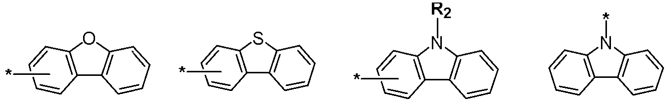 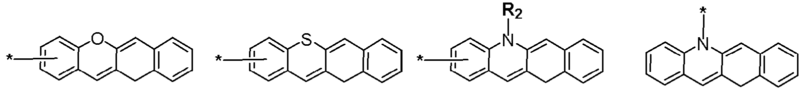 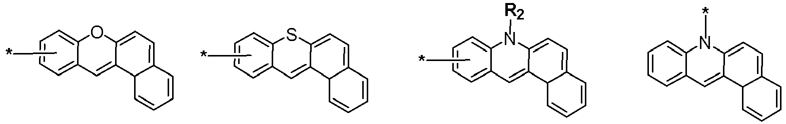 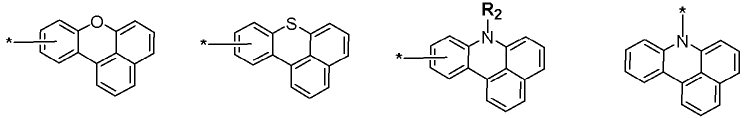 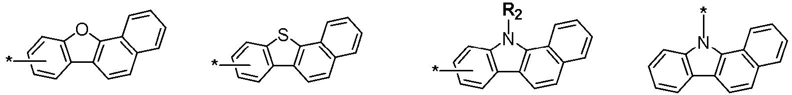 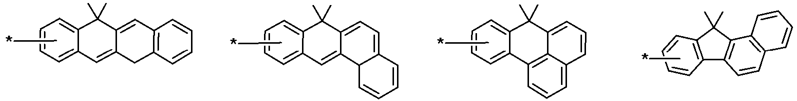 wherein the formulas,
* indicates a site where a bond with Chemical Formula 1 is made, and
R₂ is selected from the group consisting of a hydrogen, a deuterium (D), a C₁-C₄₀ alkyl group, a C₆-C₆₀ aryl group, and a heteroaryl group having 5 to 60 nuclear atoms. In addition, although not shown in the above structural formulas, at least one substituent known in the art (e.g., the same as the definition of R₁) may be substituted.

Meanwhile, the pyrazine group bonded to the other side of the silane-based moiety may be substituted with Ar₁ to Ar₃, each independently as a substituent. Ar₁ to Ar₃ may be the same as or different from each other may be each independently selected from the group consisting of a hydrogen, a deuterium (D), a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 ring atoms, a C₆-C₆₀ aryl group, a heteroaryl group having 5 to 60 ring atoms, a C₁-C₄₀ alkyloxy group, a C₆-C₆₀ aryloxy group, a C₃-C₄₀ alkylsilyl group, a C₆-C₆₀ arylsilyl group, a C₁-C₄₀ alkylboron group, a C₆-C₆₀ arylboron group, a C₆-C₆₀ arylphosphine group, a C₆-C₆₀ arylphosphine oxide group, and a C₆-C₆₀ arylamine group, provided that cases where at least two of Ar₁ to Ar₃ are hydrogen are excluded. Specifically, Ar₁ to Ar₃ may be the same as or different from each other may be each independently selected from the group consisting of a hydrogen, a deuterium (D), a C₁-C₄₀ alkyl group, a C₆-C₆₀ aryl group, and a heteroaryl group having 5 to 60 ring atoms, and more specifically may be a C₆-C₆₀ aryl group, or a heteroaryl group having 5 to 60 ring atoms.

In an embodiment of the present invention, Ar₁ to Ar₃ may be the same as or different from each other and may each independently be more specifically embodied as any one of the following structural formulas. However, it is not limited thereto. 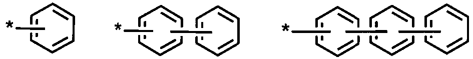 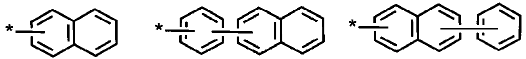 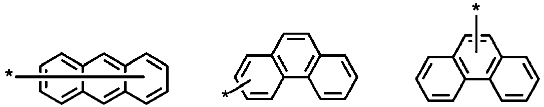 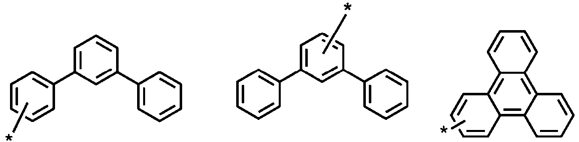 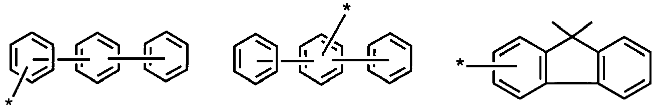 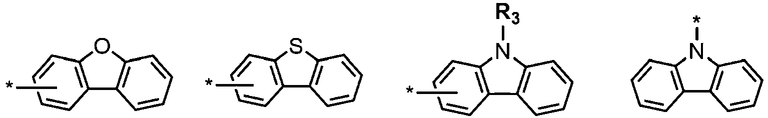 wherein the formulas,
* indicates a site where a bond with Chemical Formula 1 is made, and
R₃ is selected from the group consisting of a hydrogen, a deuterium (D), a C₁-C₄₀ alkyl group, a C₆-C₆₀ aryl group, and a heteroaryl group having 5 to 60 nuclear atoms. In addition, although not shown in the above structural formulas, at least one substituent known in the art (e.g., the same as the definition of R₁) may be substituted.

In the compound represented by Chemical Formula 1 according to the present invention,

In the compound represented by Chemical Formula 1 according to the present invention, a pyrazine group and a pyrimidine/triazine group disposed at both ends based on the silane-based moiety are directly bonded or connected through a separate linker (e.g., L₁ to L₂). As such, when a separate linker (e.g., L₁ to L₂) is present between the pyrazine group and the pyrimidine/triazine group, a HOMO region may be expanded to give a benefit to a HOMO-LUMO distribution, and charge transfer efficiency may be increased through an appropriate overlap of HOMO-LUMO.

These linkers (e.g., L₁ to L₂) are not particularly limited, and may be a single bond or a conventional divalent linking group known in the art. Specifically, L₁ to L₂ may be the same as or different from one another and may be each independently a single bond (a direct bond), or selected from the group consisting of a C₆ to C₁₈ arylene group and a heteroarylene group having 5 to 18 nuclear atoms. Specific examples of the arylene group and heteroarylene group include a phenylene group, a biphenylene group, a pyrrolylene group, an imidazolylene group, an oxazolylene group, a thiazolylene group, a triazolylene group, a pyridinylene group, a pyrimidinylene group, and the like. More specifically, L₁ to L₂ may be the same as or different from each other, and may be each independently selected from the group consisting of a single bond, a C₆ to C₁₂ arylene group, and a heteroarylene group having 5 to 12 ring atoms.

In this case, the number of linkers (e.g., d and e) may each be an integer from 0 to 4. Specifically, d + e ≥ 1, and more specifically, d and e may each be an integer from 1 to 3. For example, when d and e are 0, L₁ and L₂ may each be a single bond. In addition, when d and e are greater than 0 and 4 or less, each of the plurality of L₁ to L₂ groups may be the same as or different from each other, and may be each independently selected from the substituents defined above for the linkers, excluding a single bond.

In an embodiment of the present invention, L₁ and L₂ may be the same as or different from each other, and each may independently be a single bond (a direct bond) or a linker selected from the group consisting of the following structural formulas. 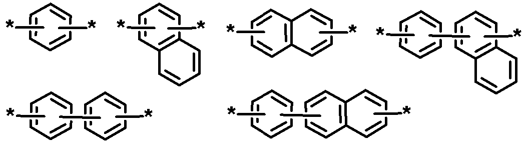 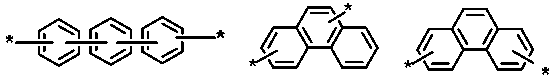 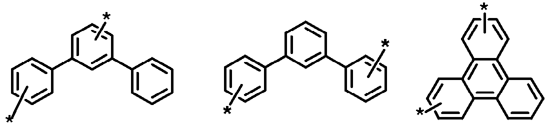 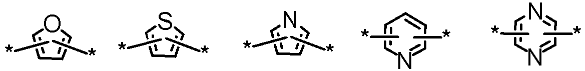 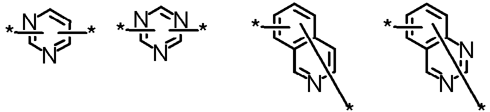 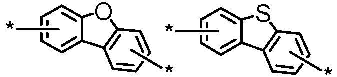 wherein the formulas,
* indicates a site where a bond with Chemical Formula 1 is made. In addition, although not shown in the above structural formulas, at least one substituent known in the art (e.g., the same as the definition of R₁) may be substituted.

In the above Chemical Formula 1, the arylene, the heteroarylene groups of L₁ to L₂, the alkyl, alkenyl, alkynyl, aryl, heteroaryl, alkyloxy, aryloxy, cycloalkyl, heterocycloalkyl, alkylsilyl, arylsilyl, alkylboron, arylboron, phospine, phosphine oxide, arylphosphine, arylphosphine oxide, and arylamine groups of Ar₁ to Ar₃, R₁, A₁ to A₂, B₁ to B₃ are optionally each independently unsubstituted or substituted with at least one selected from the group consisting of: a deuterium (D), a halogen, a cyano group, a nitro group, a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 nuclear atoms, a C₆-C₆₀ aryl group, a heteroaryl group having 5 to 60 nuclear atoms, a C₁-C₄₀ alkyloxy group, a C₆-C₆₀ aryloxy group, a C₁-C₄₀ alkylsilyl group, a C₆-C₆₀ arylsilyl group, a C₁-C₄₀ alkylboron group, a C₆-C₆₀ arylboron group, a C₁-C₄₀ arylphosphine group, a C₆-C₆₀ aryl phosphine oxide group, and a C₆-C₆₀ arylamine group, and provided that when the substituent is present in a plural number, they are optionally the same or different from each other.

In an embodiment of the present invention, the compound represented by Chemical Formula 1 may be more specifically represented by the following Chemical Formula 2, depending on the type of the linker (e.g., L₁ and L₂) introduced into the compound. However, the present invention is not limited thereto. 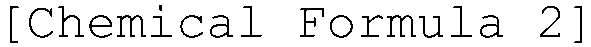 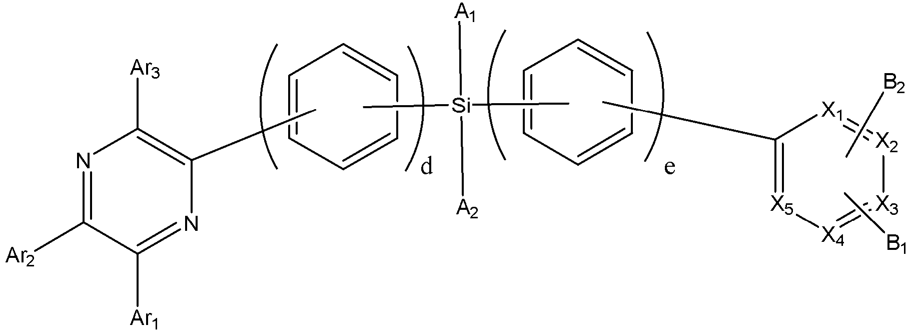 wherein the formulas,
X₁ to X₅, Ar₁ to Ar₃, A₁ to A₂, B₁ to B₂, d and e are each as defined in Chemical Formula 1.

In an embodiment of the present invention, 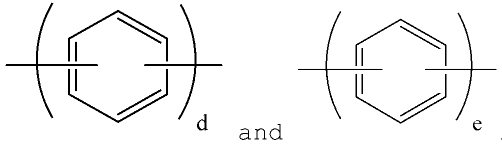 in Chemical formula 2 (in cases where d and e are each 1 or more) may be the same as or different from each other, and may be each independently selected from the following structural formulae: 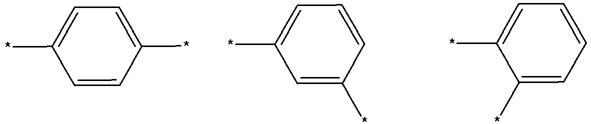 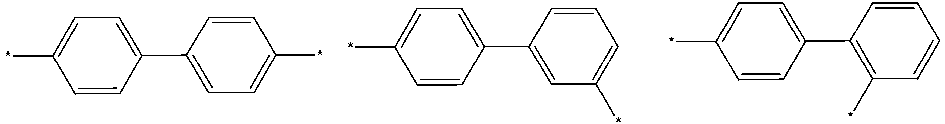 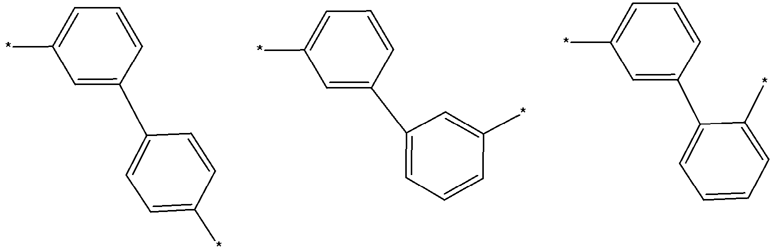 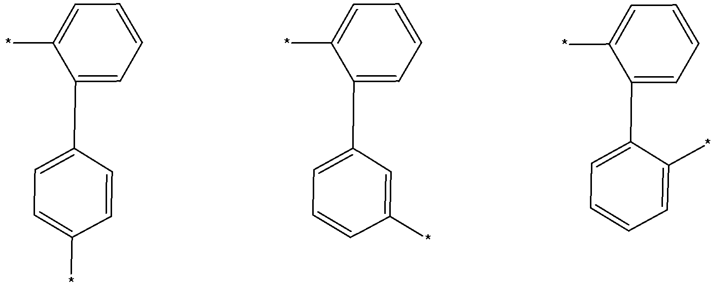 wherein the formulas,
* indicates a site where a bond with Chemical Formula 2 is made.

In another embodiment of the present invention, the compound represented by Chemical Formula 1 may be further embodied as any one of the following Chemical Formulas 3 to 5 depending on the bonding position of the linker (e.g., L₂) connected to the nitrogen-containing heterocycle (e.g., the ring containing X₁ to X₅). However, it is not limited thereto. 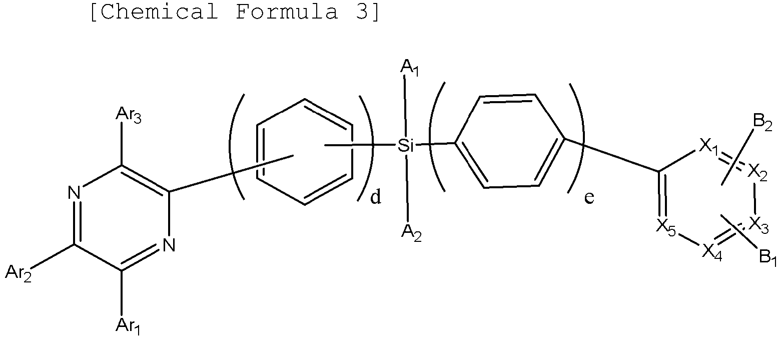 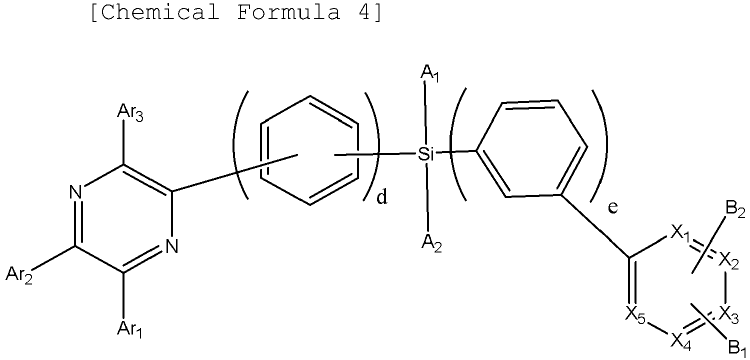 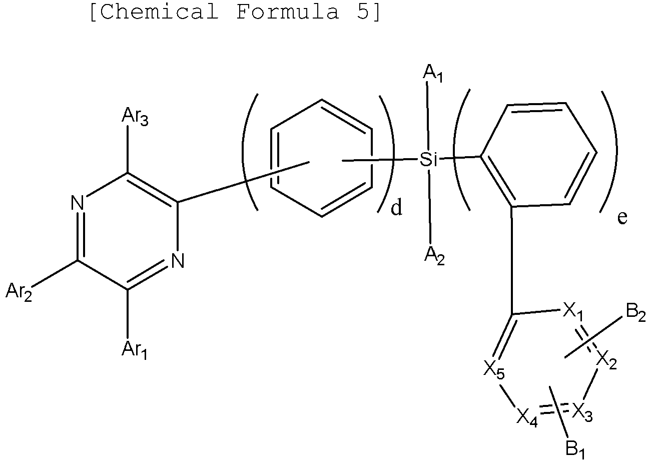 wherein the formulas,
X₁ to X₅, Ar₁ to Ar₃, A₁ to A₂, B₁ to B₂, d and e are each as defined in Chemical Formula 1.

In another embodiment of the present invention, the compound represented by Chemical Formula 1 may be further embodied as any one of the following Chemical Formulas 6a to 61 depending on the number of linkers (e.g., e = 1-2) positioned between a silane group and a nitrogen-containing heterocyle (e.g., the ring containing X₁ to X₅) and the bonding position thereof. However, it is not limited thereto. 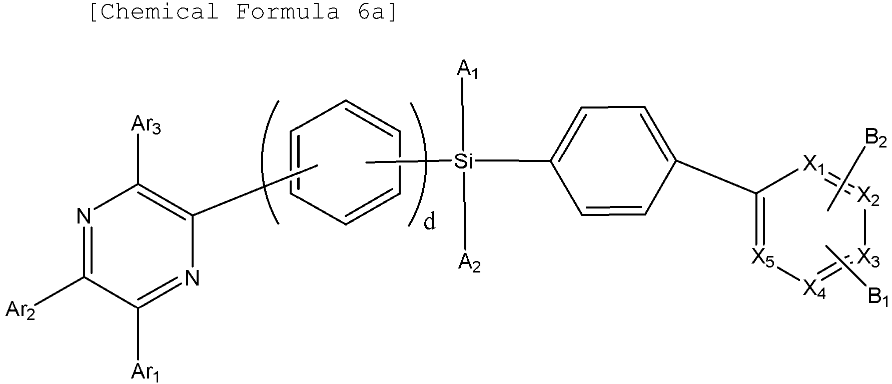 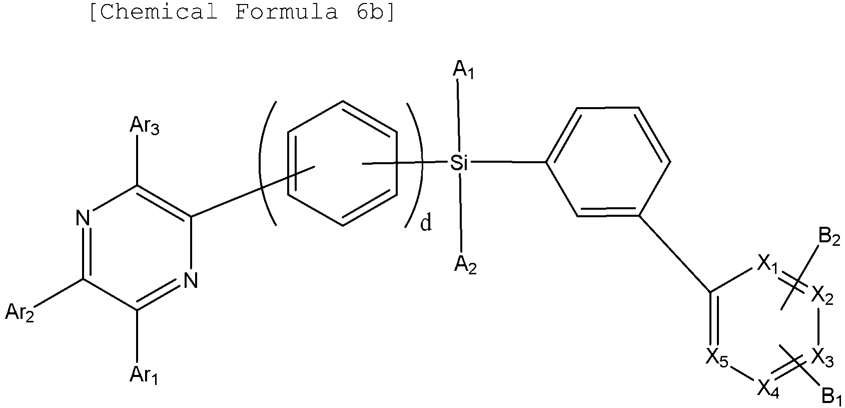 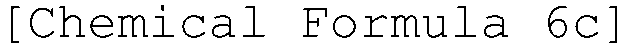 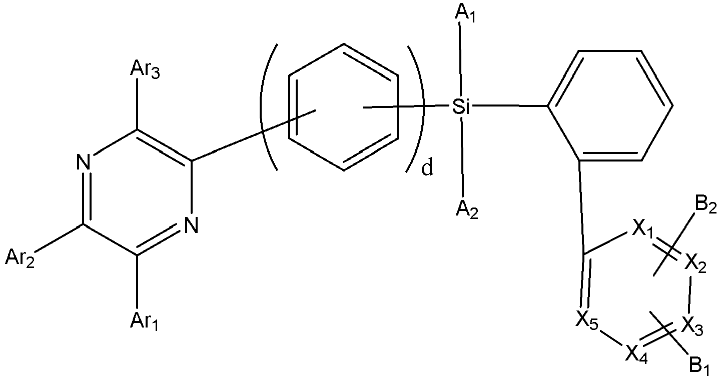 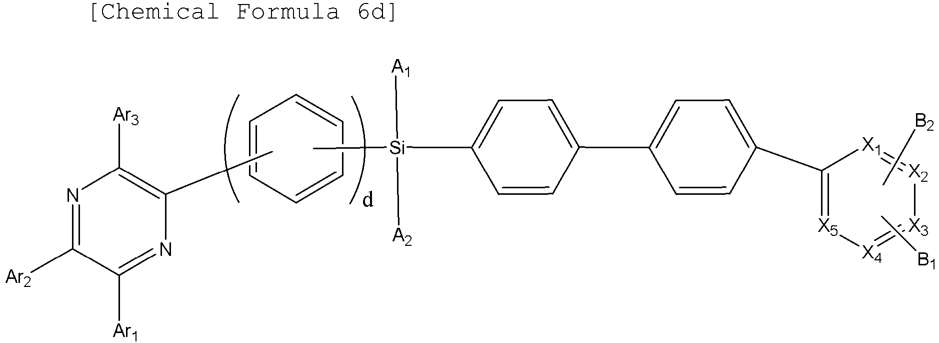 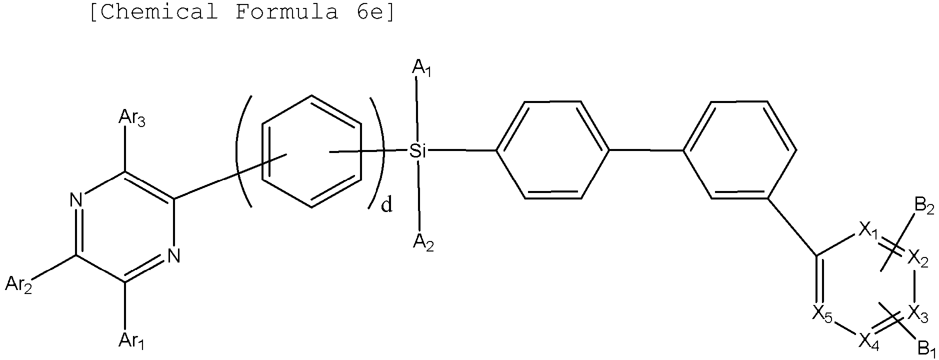 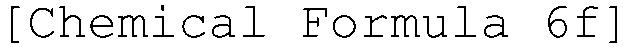 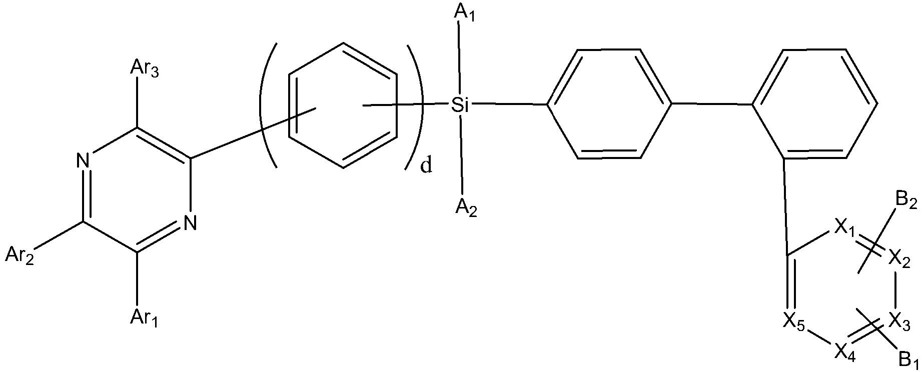 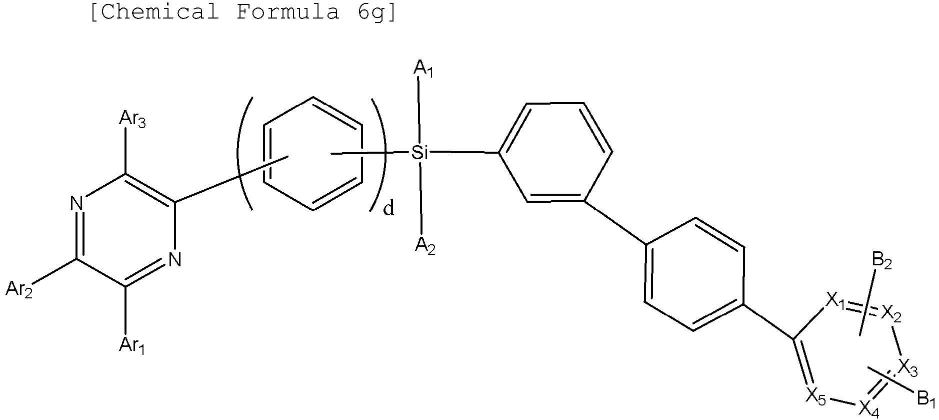 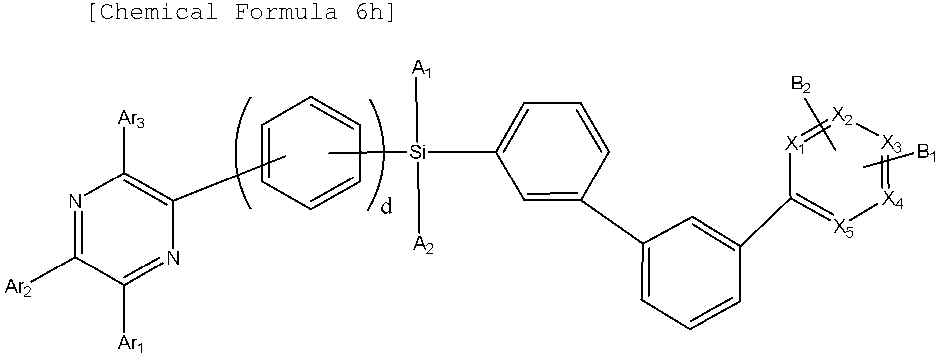 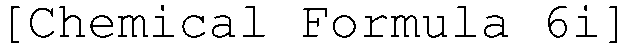 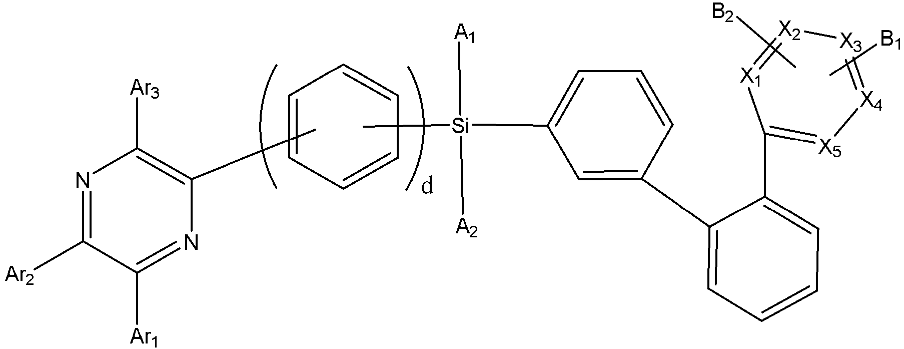 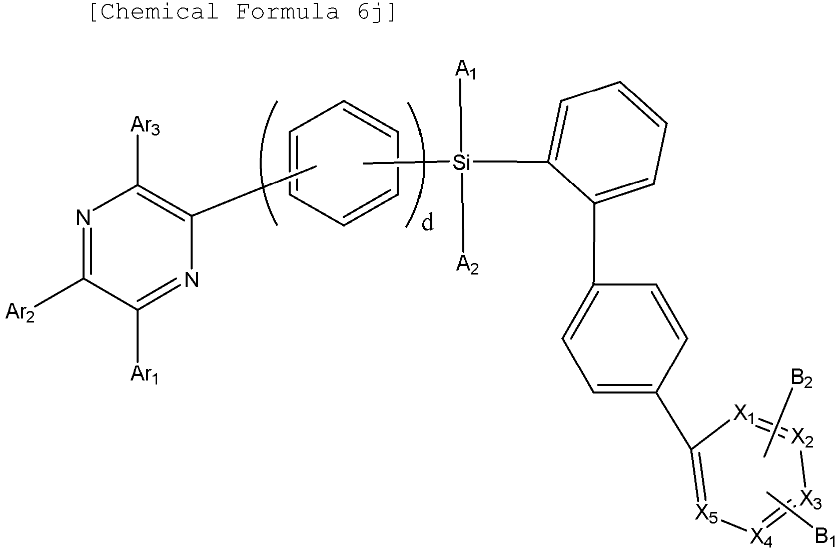 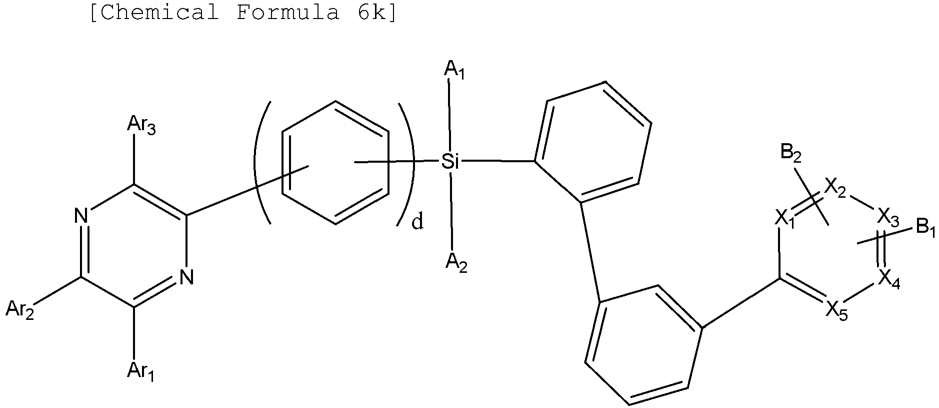 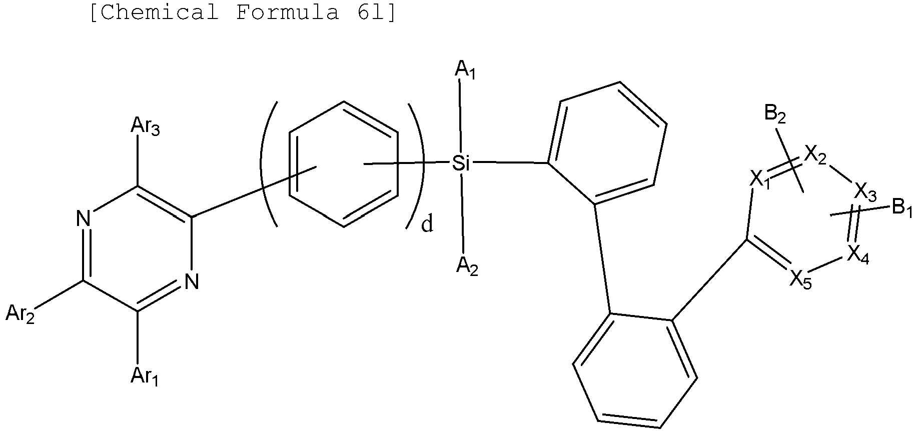 wherein the formulas,
Ar₁ to Ar₃, A₁ to A₂, B₁ to B₂, R₁, and d are each as defined in Chemical Formula 1.

In another embodiment of the present invention, the compound represented by Chemical Formula 1 may be further embodied as any one of the following Chemical Formulas 7 to 9 depending on the bonding position of the linker (e.g., L₁) connected to the pyrazine (e.g., the ring containing Ar₁ to Ar₃). However, it is not limited thereto. 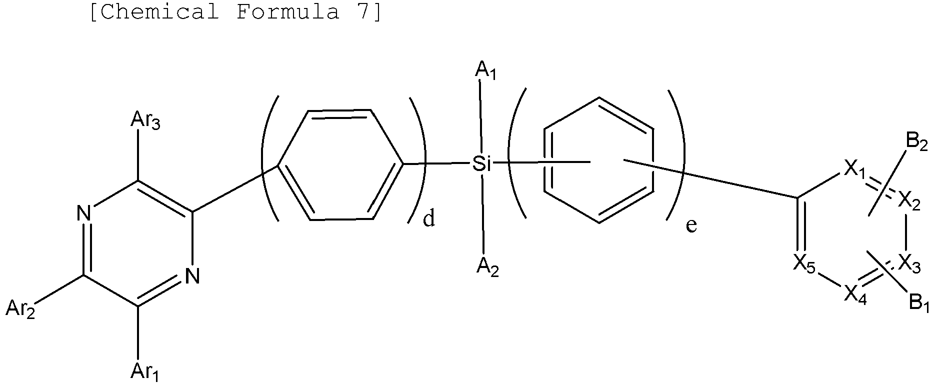 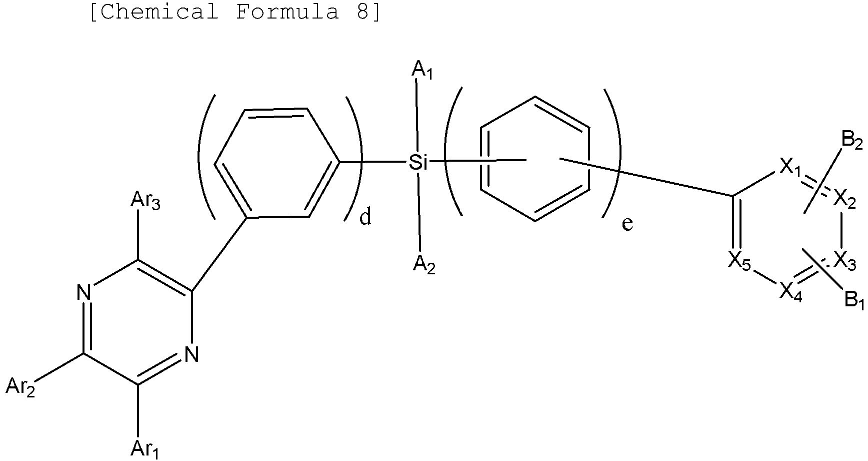 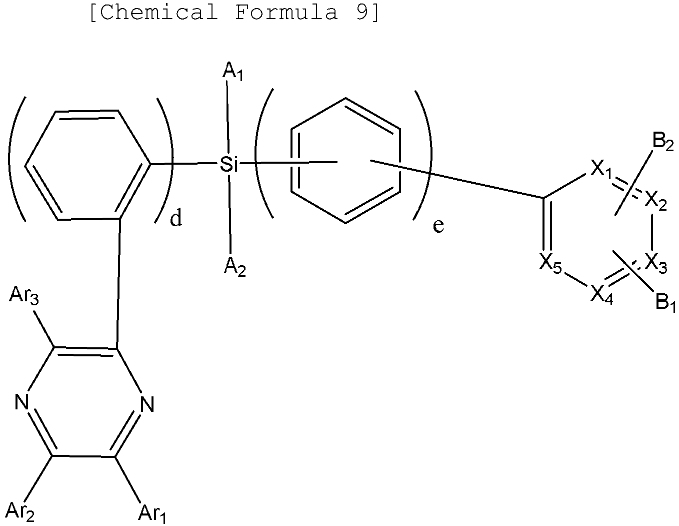 wherein the formulas,
X₁ to X₅, Ar₁ to Ar₃, A₁ to A₂, B₁ to B₂, d and e are each as defined in Chemical Formula 1.

In another embodiment of the present invention, the compound represented by Chemical Formula 1 may be further embodied as any one of the following Chemical Formulas 10a to 101 depending on the number of linkers (e.g., d = 1-2) positioned between the pyrazine group and the silane group the bonding position thereof. However, it is not limited thereto. 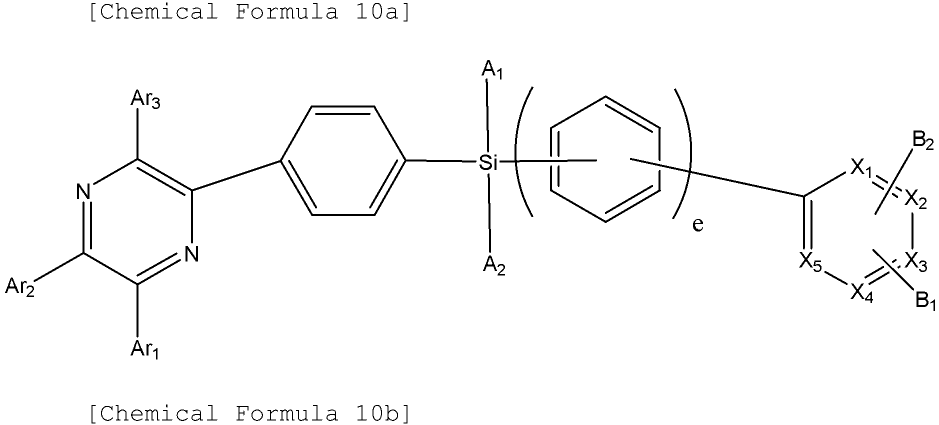 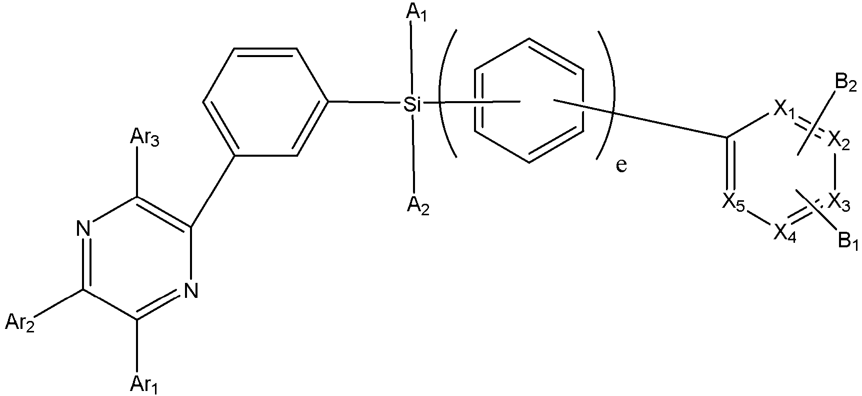 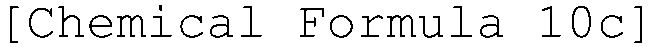 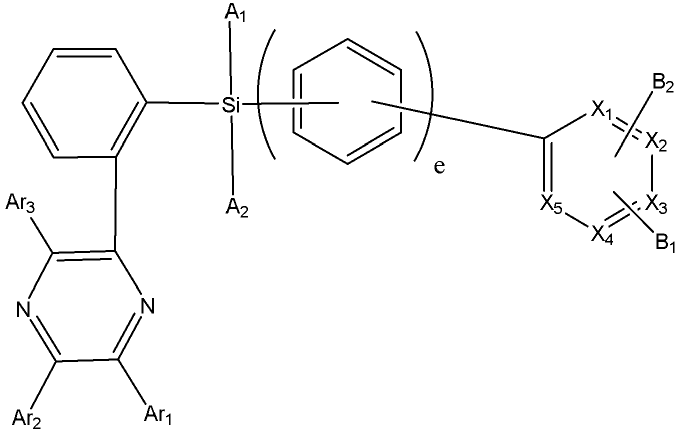 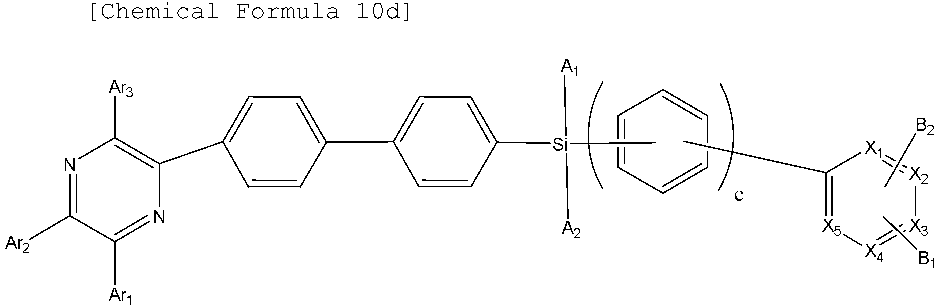 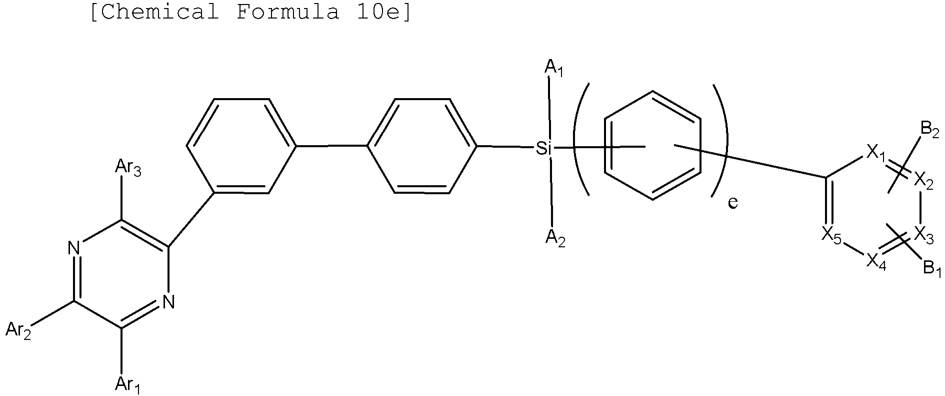 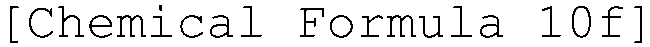 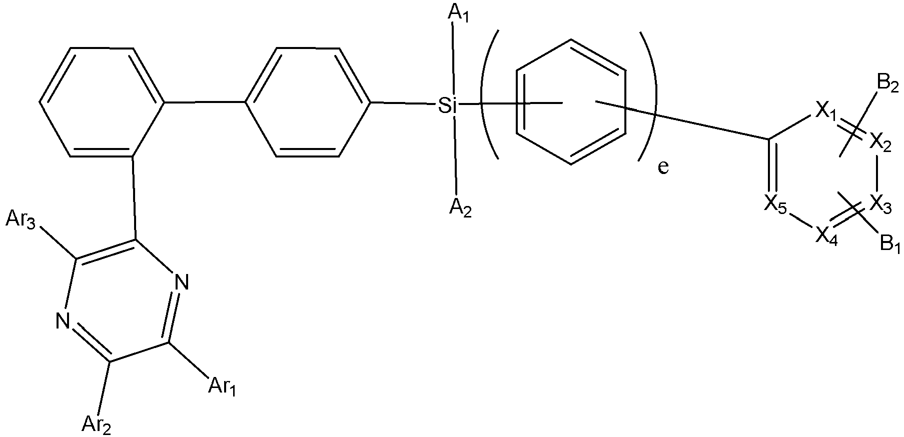 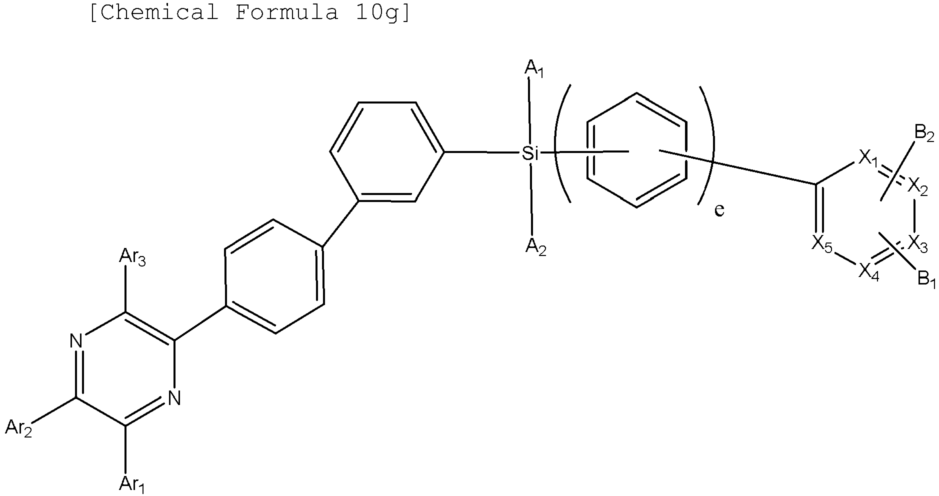 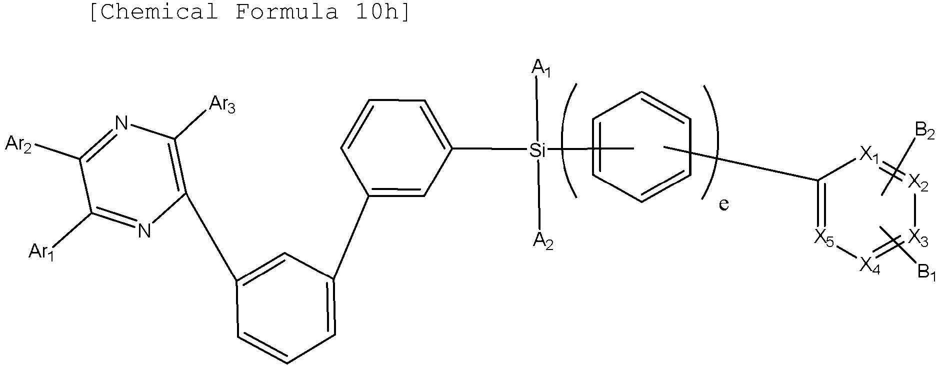 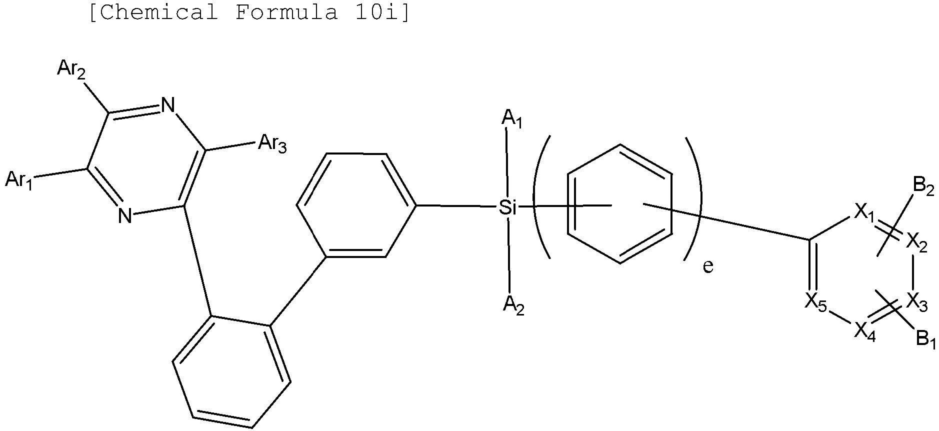 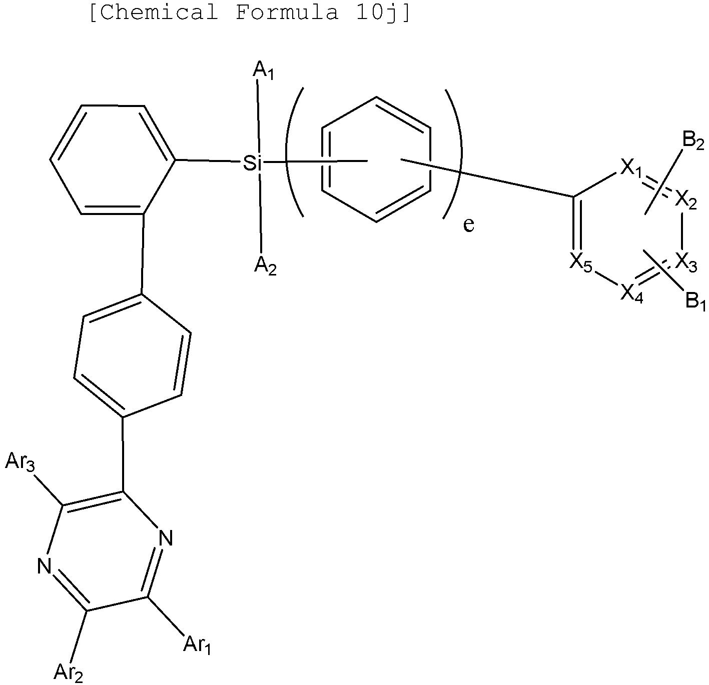 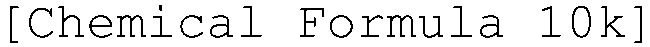 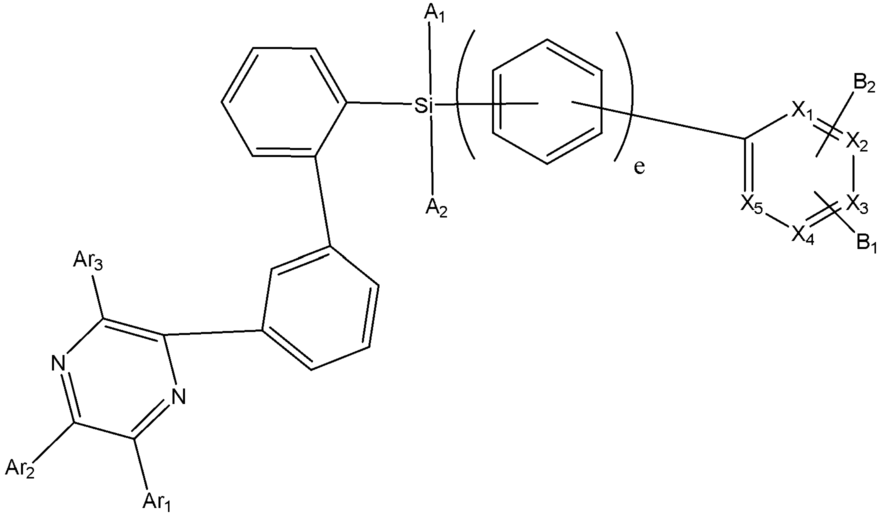 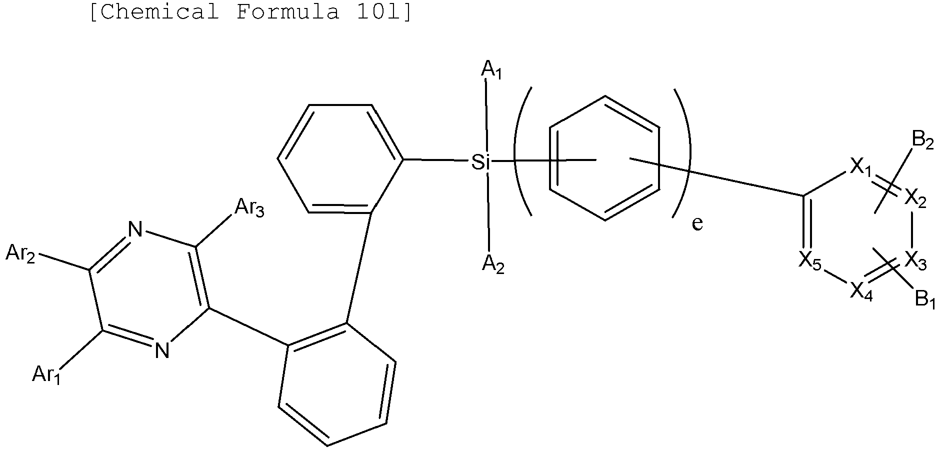 wherein the formulas,
X₁ to X₅, Ar₁ to Ar₃, A₁ to A₂, B₁ to B₂ and e are each as defined in Chemical Formula 1.

In another embodiment of the present invention, the compound represented by Chemical Formula 1 may be further embodied as any one of the following Chemical Formulas 11 to 14, depending on the types of the linkers (e.g., L₁ to L₂) and the nitrogen-containing heterocycle (e.g., the ring containing X₁ to X₅). However, it is not limited thereto. 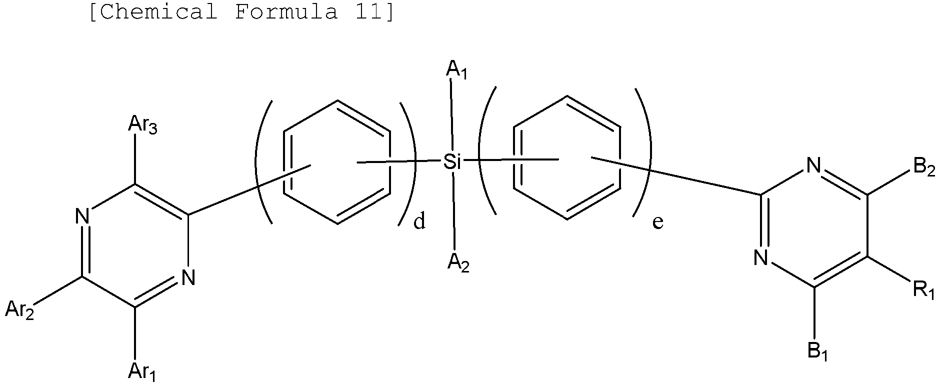 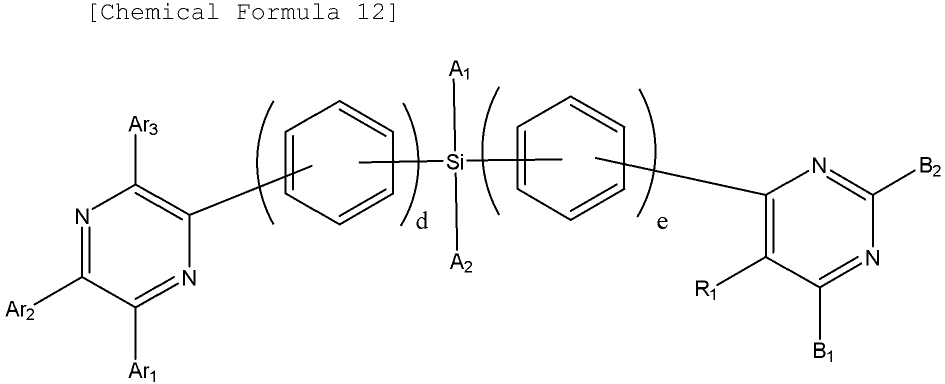 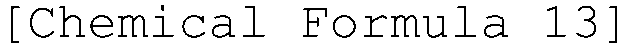 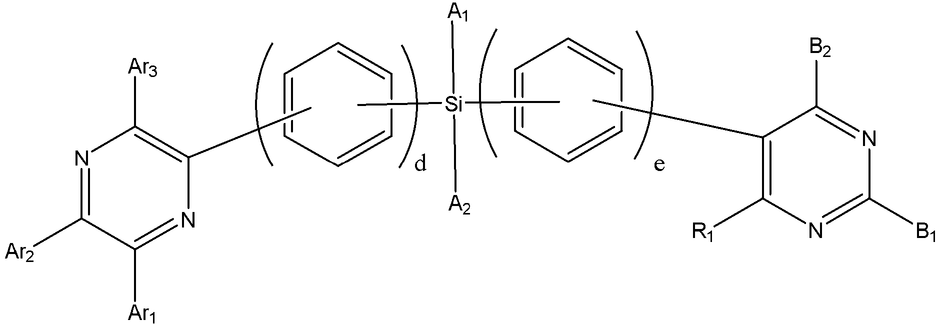 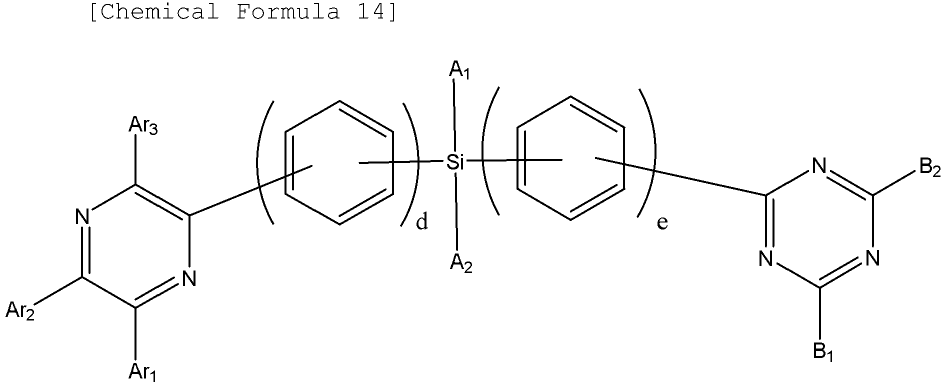 wherein the formulas,
Ar₁ to Ar₃, A₁ to A₂, B₁ to B₂, d and e are each as defined in Chemical Formula 1.

In another embodiment of the present invention, the compound represented by Chemical Formula 1 may be further embodied as any one of the following Chemical Formulas 15 to 18, depending on the types of the substituents Ar₁ to Ar₃ introduced into the pyrazine group. However, it is not limited thereto. 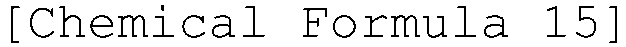 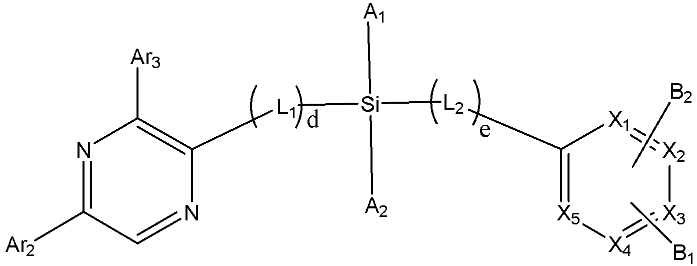 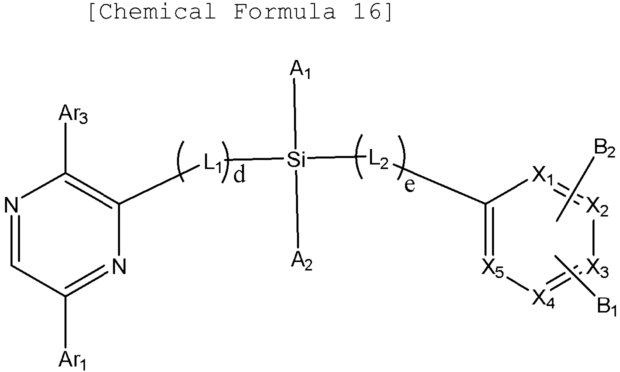 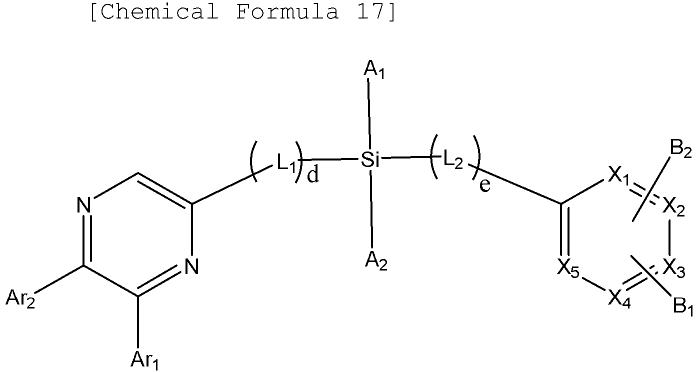 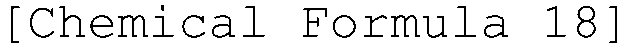 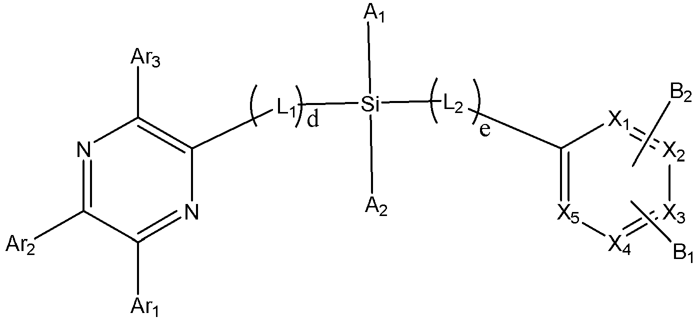 wherein the formulas,
X₁ to X₅, Ar₁ to Ar₃, A₁ to A₂, B₁ to B₂, L₁ to L₂, d and e are each as defined in Chemical Formula 1, provided that cases Ar₁ to Ar₃ are hydrogen are excluded.

The aforementioned compounds represented by Chemical Formulas 15 to 18 may be more specifically represented by any one of the following Chemical Formulas 15a to 18a, depending on the types of the linkers (e.g., L₁ to L₂). However, the present invention is not limited thereto. 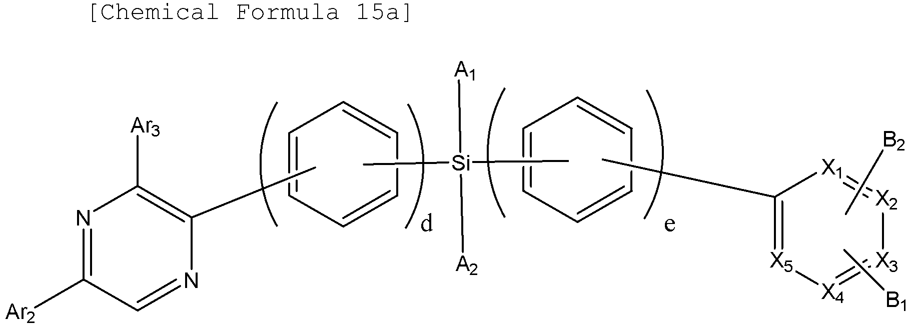 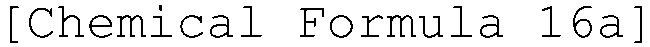 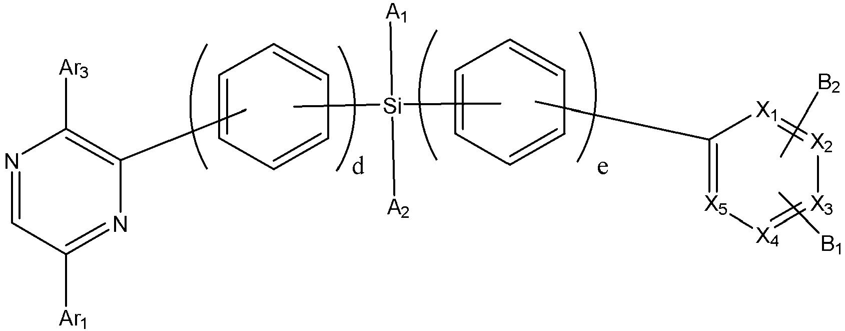 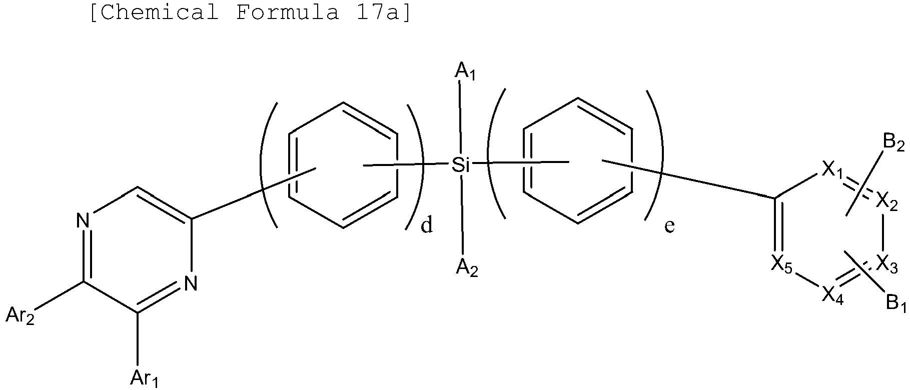 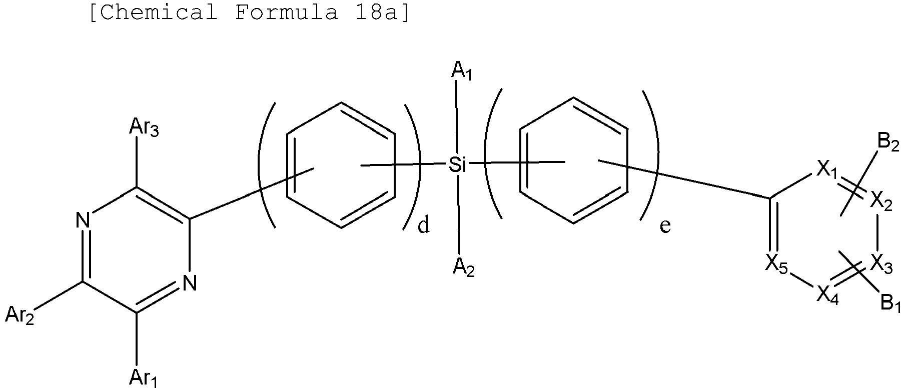 wherein the formulas,
X₁ to X₅, Ar₁ to Ar₃, A₁ to A₂, B₁ to B₂, d and e are each as defined in Chemical Formula 1, provided that cases Ar₁ to Ar₃ are hydrogen are excluded.

The compound represented by Chemical Formula 1 of the present invention described above may be further embodied as compounds represented by the following compounds represented by, for example, 1 to 128. However, the compound represented by Chemical Formula 1 of the present invention is not limited to those exemplified below.

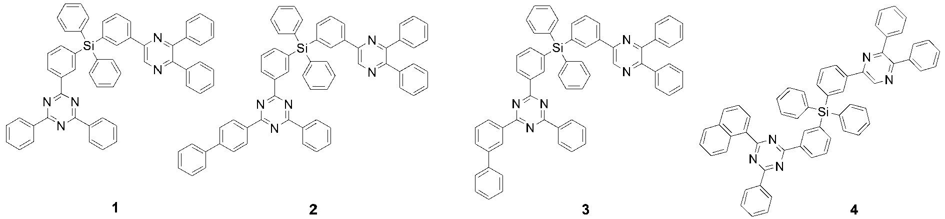

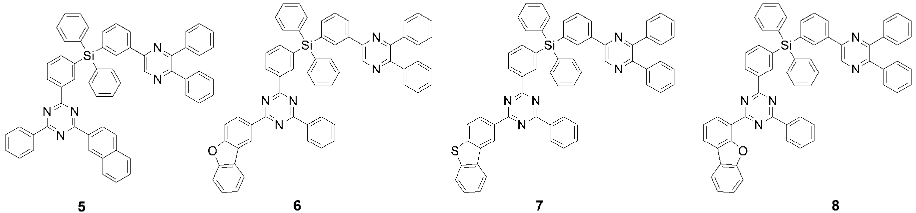

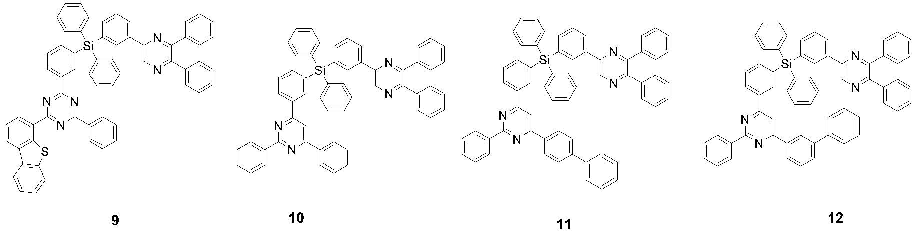

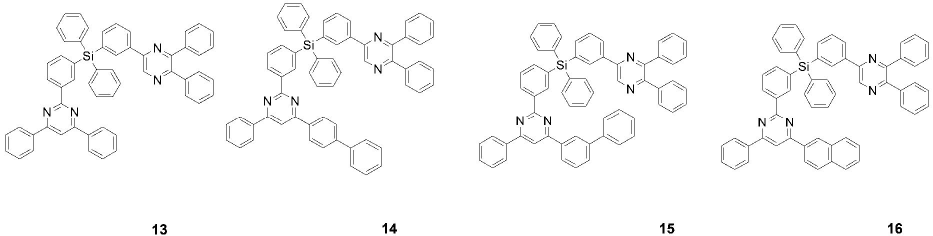

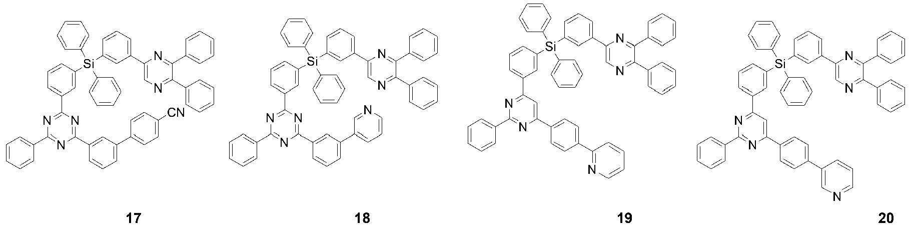

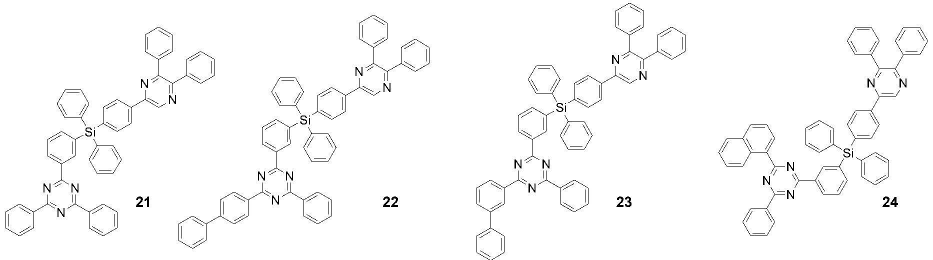

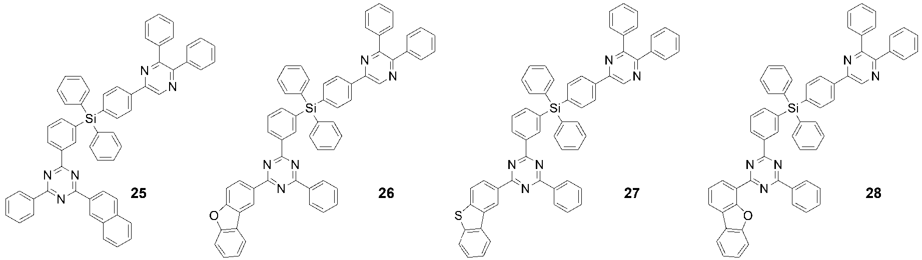

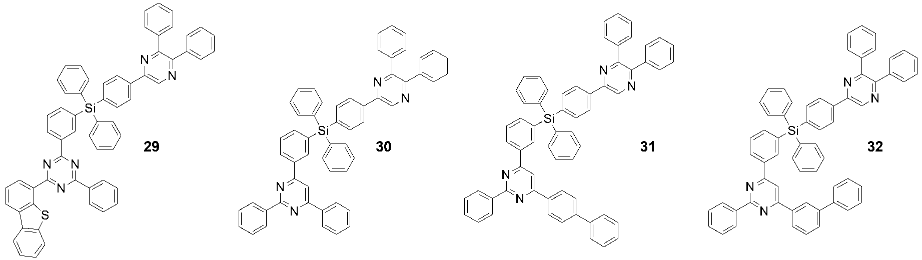

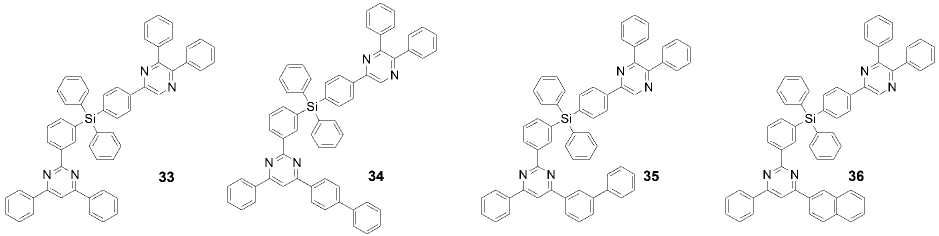

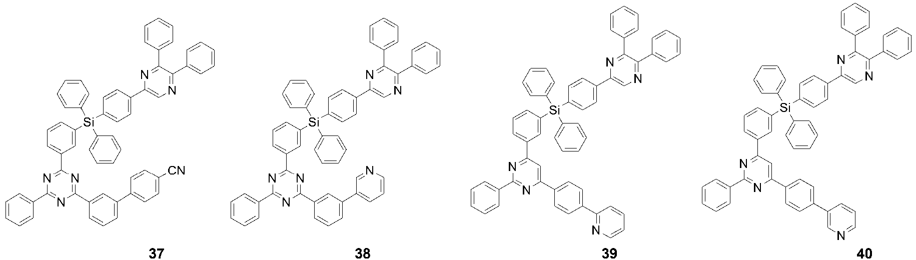

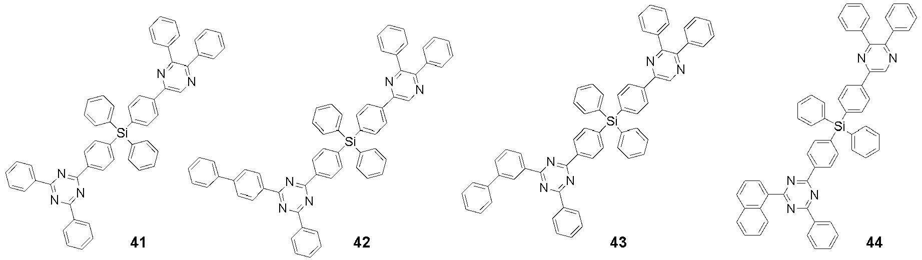

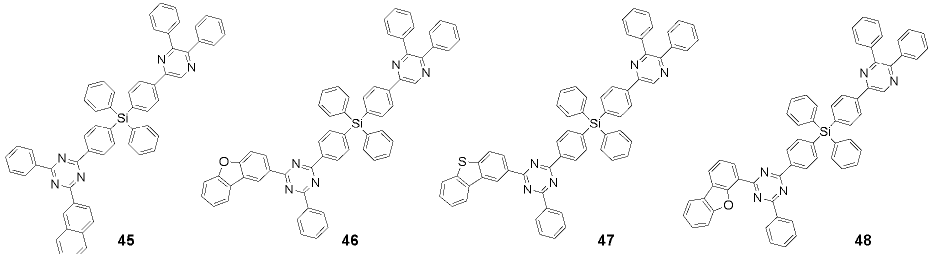

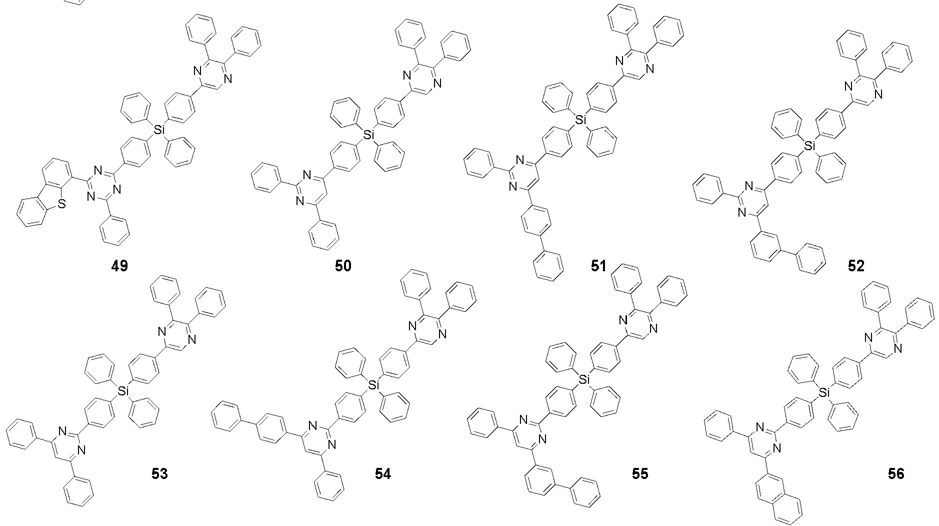

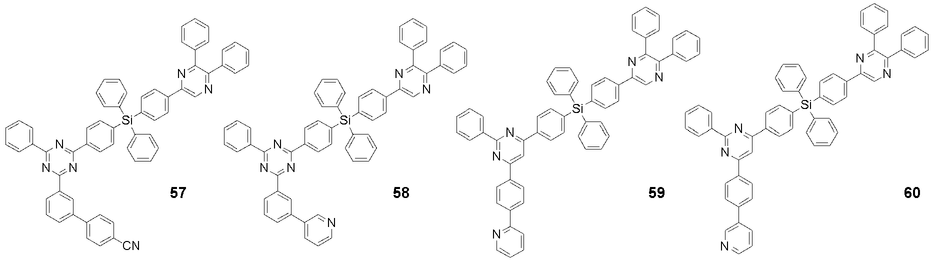

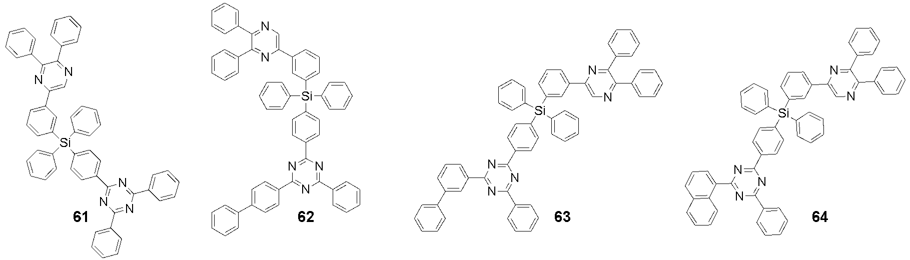

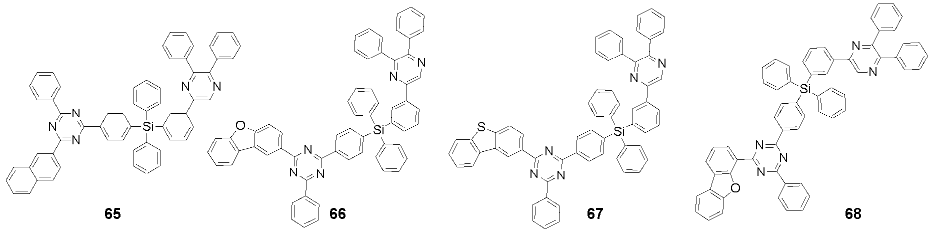

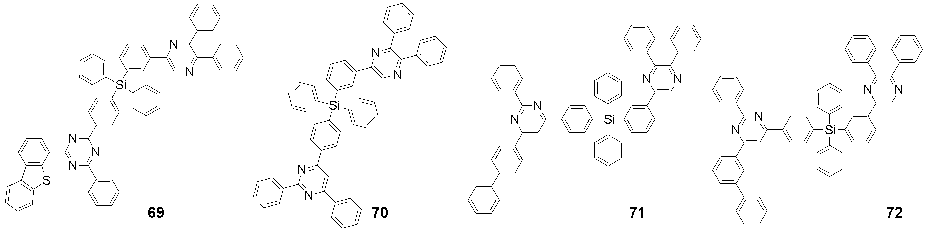

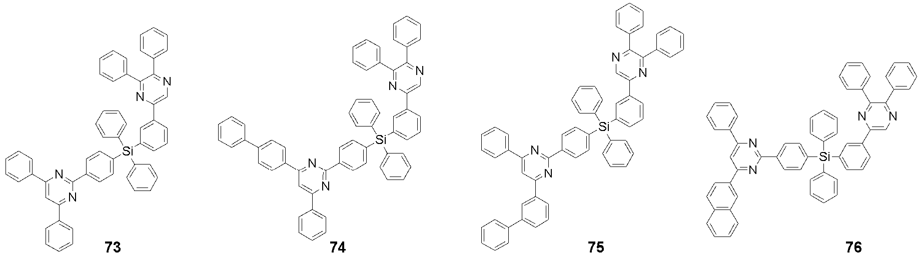

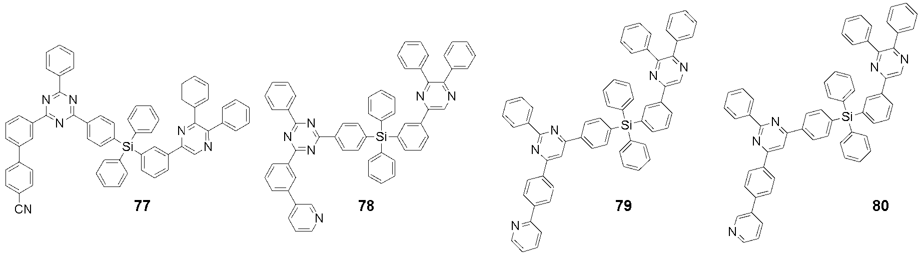

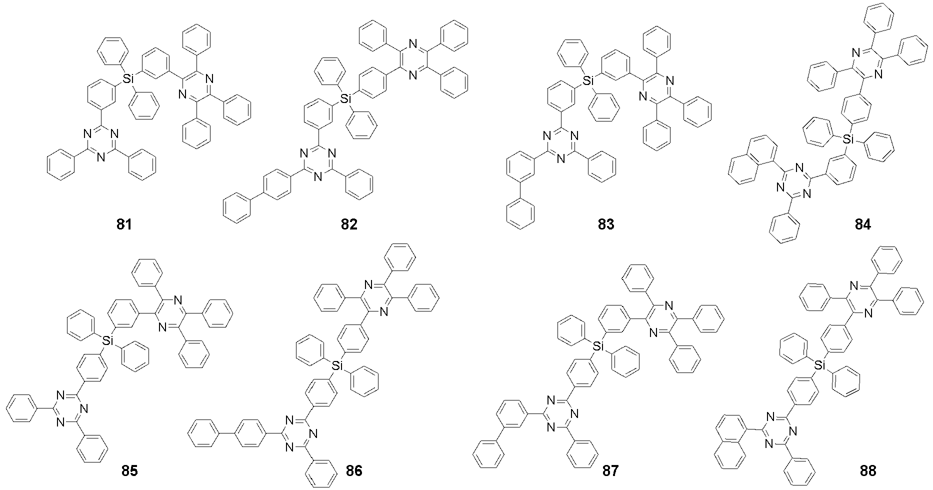

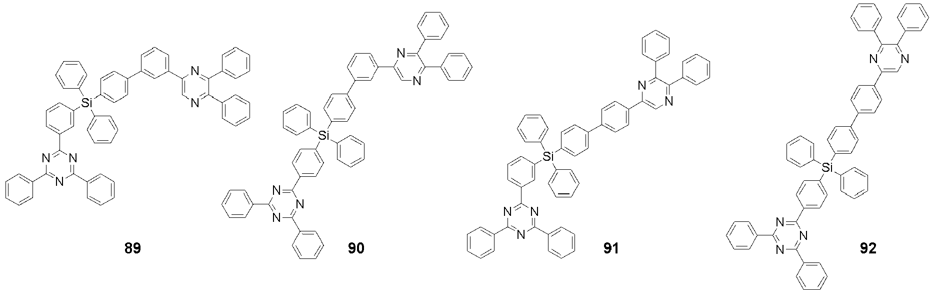

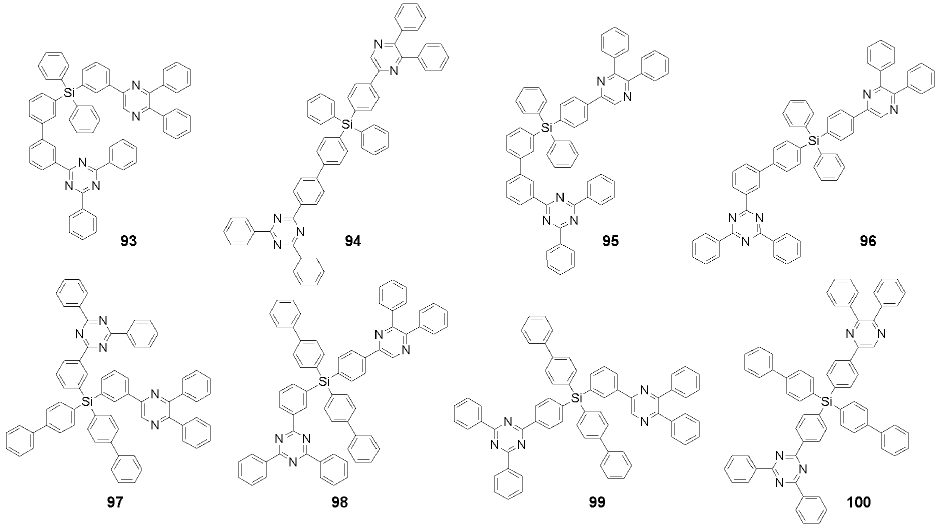

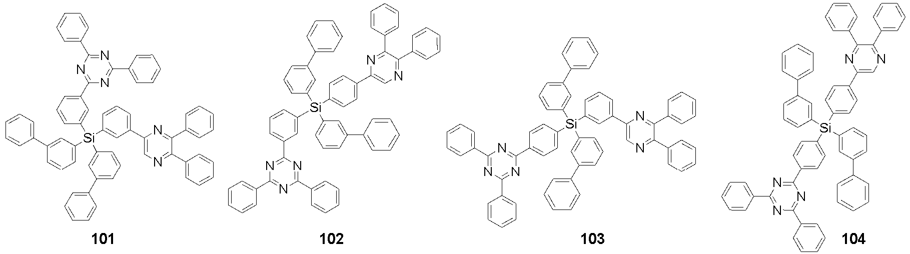

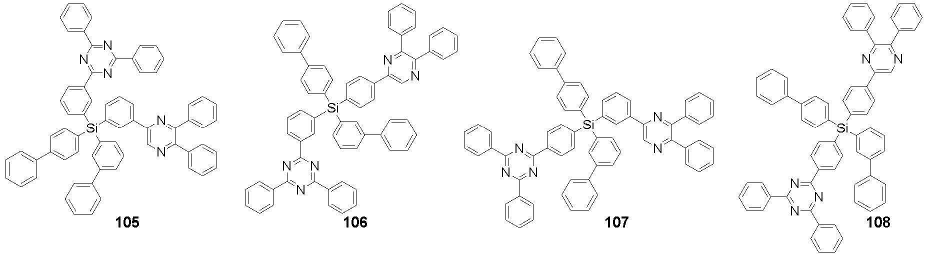

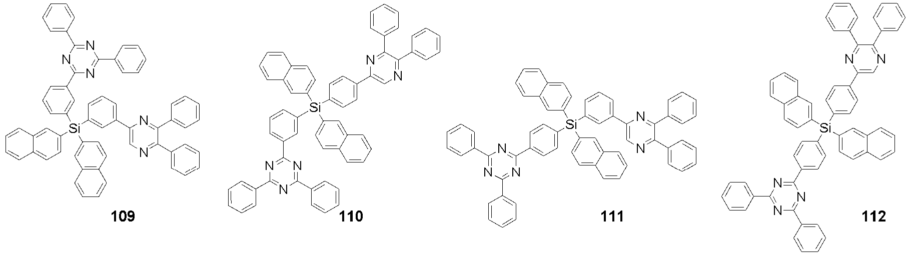

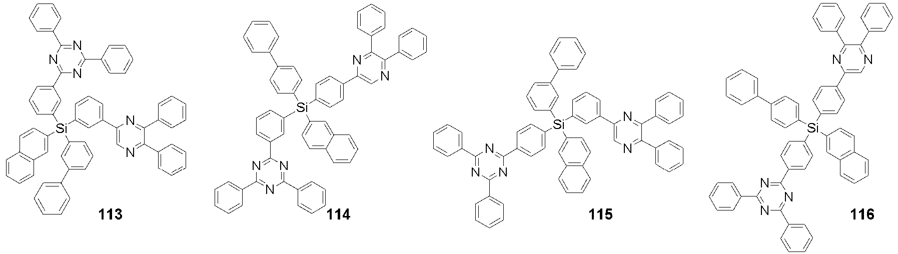

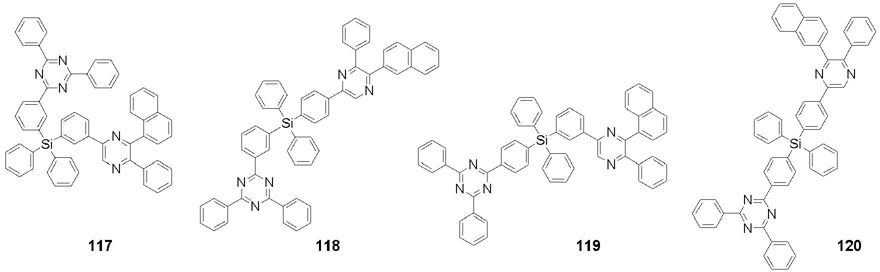

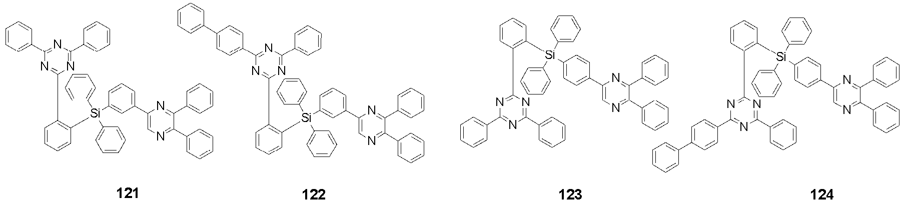

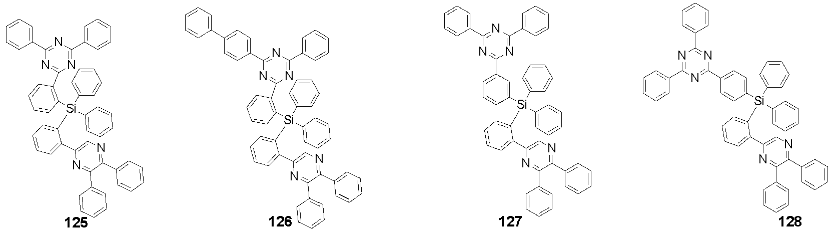

As used herein, "the number of nuclear atoms" means the number of ring atoms constituting a ring structure, and the nuclear atoms may mean carbon or a heteroatom selected from the group consisting of N, O, S and Se. For example, the number of nuclear atoms of pyridine means 6 including 5 C and 1 N constituting a pyridine ring.

As used herein, "alkyl" refers to a monovalent substituent derived from a linear or branched chain saturated hydrocarbon having 1 to 40 carbon atoms. Examples of such alkyl may include, but not limited to, methyl, ethyl, propyl, isobutyl, sec-butyl, pentyl, iso-amyl, hexyl or the like.

As used herein, "alkenyl" refers to a monovalent substituent derived from a C₂ to C₄₀ linear or branched chain unsaturated hydrocarbon, having at least one carbon-carbon double bond. Examples of such alkenyl may include, but not limited to, vinyl, allyl, isopropenyl, 2-butenyl or the like.

As used herein, "alkynyl" refers to a monovalent substituent derived from a C₂ to C₄₀ linear or branched chain unsaturated hydrocarbon, having at least one carbon-carbon triple bond. Examples of such alkynyl may include, but not limited to, ethynyl, 2-propynyl or the like.

As used herein, "aryl" refers to a monovalent substituent derived from a C₆ to C₄₀ aromatic hydrocarbon having a structure with a single ring or two or more rings combined with each other. In addition, a form in which two or more rings are pendant (e.g., simply attached) to or fused with each other may also be included. Examples of such aryl may include, but not limited to, phenyl, naphthyl, phenanthryl, anthryl or the like.

As used herein, "heteroaryl" refers to a monovalent substituent derived from a monoheterocyclic or polyheterocyclic aromatic hydrocarbon having 5 to 40 nuclear atoms. In such an embodiment, one or more carbons in the ring, preferably one to three carbons, are substituted with a heteroatom such as N, O, S or Se. In addition, a form in which two or more rings are pendant to or fused with each other may be included and a form fused with an aryl group may be included. Examples of such heteroaryl may include, but not limited to, a 6-membered monocyclic ring such as pyridyl, pyrazinyl, pyrimidinyl, pyridazinyl and triazinyl; a polycyclic ring such as phenoxathienyl, indolizinyl, indolyl, purinyl, quinolyl, benzothiazole, and carbazolyl; 2-furanyl; N-imidazolyl; 2-isoxazolyl; 2-pyridinyl; 2-pyrimidinyl or the like.

As used herein, "aryloxy" is a monovalent substituent represented by RO-, where R refers to a C₅ to C₄₀ aryl. Examples of such aryloxy may include, but not limited to, phenyloxy, naphthyloxy, diphenyloxy or the like.

As used herein, "alkyloxy" refers to a monovalent substituent represented by R'O-, where R' refers to a C₁ to C₄₀ alkyl. Such alkyloxy may include a linear, branched or cyclic structure. Examples of such alkyloxy may include, but not limited to, methoxy, ethoxy, n-propoxy, 1-propoxy, t-butoxy, n-butoxy, pentoxy or the like.

As used herein, "arylamine" refers to amine substituted with a C₆ to C₄₀ aryl.

As used herein, "cycloalkyl" refers to a monovalent substituent derived from a C₃ to C₄₀ monocyclic or polycyclic non-aromatic hydrocarbon. Examples of such cycloalkyl may include, but not limited to, cyclopropyl, cyclopentyl, cyclohexyl, norbornyl, adamantine or the like.

As used herein, "heterocycloalkyl" refers to a monovalent substituent derived from a non-aromatic hydrocarbon having 3 to 40 nuclear atoms, where one or more carbons in the ring, preferably one to three carbons, are substituted with a heteroatom such as N, O, S or Se. Examples of such heterocycloalkyl may include, but not limited to, morpholine, piperazine or the like.

As used herein, "alkylsilyl" refers to silyl substituted with a C₁ to C₄₀ alkyl, and "arylsilyl" refers to silyl substituted with a C₃ to C₄₀ aryl.

As used herein, the term "fused ring (e.g., condensed ring)" refers to a condensed aliphatic ring, a condensed aromatic ring, a condensed heteroaliphatic ring, a condensed heteroaromatic ring, or a combination thereof.

### <Electron transport layer material>

The present invention provides an electron transport layer including the compound represented by Chemical Formula 1.

The electron transport layer (ETL) serves to move electrons injected from a cathode to an adjacent layer, specifically a light emitting layer.

The compound represented by Chemical Formula 1 may be used alone as an electron transport layer (ETL) material, or may be used in combination with an electron transport layer material known in the art. It may preferably be used alone.

The electron transport layer material that may be used in combination with the compound of Chemical Formula 1 may include an electron transport material commonly known in the art. Non-limiting examples of applicable electron transport materials may include oxazole-based compounds, isoxazole-based compounds, triazole-based compounds, isothiazole-based compounds, oxadiazole-based compounds, thiadiazole-based compounds, perylene-based compounds, aluminum complexes (e.g., tris(8-quinolinolato)-aluminium (Alq₃), BAlq, SAlq, Almq₃, gallium complexes (e.g., Gaq'2OPiv, Gaq'2OAc, 2(Gaq'2)), etc. These may be used alone or two or more types thereof may be used in combination.

In the present invention, when the compound of Chemical Formula 1 and the electron transport layer material are used in combination, a mixing ratio thereof is not particularly limited, and may be appropriately adjusted within a range known in the art.

### <Auxiliary electron transport layer material>

In addition, the present invention provides an auxiliary electron transport layer including the compound represented by Chemical Formula 1.

The auxiliary electron transport layer is disposed between the light emitting layer and the electron transport layer and serves to substantially prevent diffusion of excitons or holes generated in the light emitting layer into the electron transport layer.

The compound represented by Chemical Formula 1 may be used alone as an auxiliary electron transport layer material, or may be combined with an electron transport layer material known in the art. It may preferably be used alone.

The auxiliary electron transport layer material that may be used in combination with the compound of Chemical Formula 1 includes an electron transport material commonly known in the art. For example, the auxiliary electron transport layer may include an oxadiazole derivative, a triazole derivative, a phenanthroline derivative (e.g., BCP), a heterocyclic derivative containing nitrogen, and the like.

In the present invention, when the compound of Chemical Formula 1 and the auxiliary electron transport layer material are used in combination, a mixing ratio thereof is not particularly limited, and may be appropriately adjusted within a range known in the art.

### <Organic electroluminescent device>

Another aspect of the present invention is directed to an organic electroluminescent device ("organic EL device" or "organic EL element") including the compound represented by Chemical Formula 1.

More specifically, the organic EL device according to the present invention includes an anode (e.g., a positive electrode), a cathode (e.g., a negative electrode), and one or more organic layers disposed between the anode and the cathode, and at least one of the one or more organic layers includes the compound represented by Chemical Formula 1. In such an embodiment, the compound may be used alone or in combination of two or more kinds thereof.

The one or more organic layers may be any one or more of a hole injection layer, a hole transport layer, a light emitting layer, a light emitting auxiliary layer, a lifespan improvement layer, an electron transport layer, an auxiliary electron transport layer and an electron injection layer, and at least one of the organic layers may include the compound represented by Chemical Formula 1. Specifically, the organic layer including the compound represented by Chemical Formula 1 may preferably be a light emitting layer, a light emitting auxiliary layer, an electron transport layer, an electron transport auxiliary layer and/or a lifespan improvement layer, and more specifically, it may be preferable to be an electron transport layer, an electron transport auxiliary layer or a light emitting auxiliary layer.

The light emitting layer of the organic EL device of the present invention includes a host material and a dopant material, and may include the compound of Chemical Formula 1 as a host material. In addition, the light emitting layer of the present invention may include, as a host, other compounds known in the art rather than or in addition to the compound of Chemical Formula 1.

When the compound represented by Chemical Formula 1 is included as a material for the light emitting layer of the organic EL device, preferably as a blue, green, or red phosphorescent host material, since a bonding force between holes and electrons in the light emitting layer is increased, the efficiency (luminescence efficiency and power efficiency), lifespan, luminance, driving voltage, and the like of the organic EL device may be improved. Specifically, the compound represented by Chemical Formula 1 may be preferably included in an organic EL device as a green and/or red phosphorescent host, a fluorescent host, or a dopant material. In particular, the compound represented by Chemical Formula 1 of the present invention may preferably be a green phosphorescent exciplex N-type host material for a high-efficiency light emitting layer.

A structure of the organic EL device of the present invention is not particularly limited, and may be, for example, a structure in which a substrate, an anode, a hole injection layer, a hole transport layer, a light emitting auxiliary layer, a light emitting layer, an electron transport layer, and a cathode are sequentially stacked. In such a case, at least one of the hole injection layer, the hole transport layer, the light emitting auxiliary layer, the light emitting layer, the electron transport layer and the electron injection layer may include the compound represented by Chemical Formula 1, and preferably, the light emitting layer, more preferably a phosphorescent host, may include the compound represented by Chemical Formula 1. Meanwhile, an electron injection layer may be additionally stacked on the electron transport layer.

The organic EL device of the present invention may have a structure in which an insulating layer or an adhesive layer is inserted at an interface between the electrode and the organic layer.

The organic EL device of the present invention may be prepared using materials and methods known in the art to form organic layers and electrodes, except that one or more layers of the aforementioned organic layers include the compound represented by Chemical Formula 1.

The organic layer may be formed by a vacuum deposition method or a solution coating method. Examples of the solution coating method may include, but not limited to, spin coating, dip coating, doctor blading, inkjet printing, thermal transfer or the like.

The substrate used in preparation of the organic EL device of the present invention is not particularly limited, and non-limiting examples thereof may include silicon wafers, quartz, glass plates, metal plates, plastic films, sheets or the like.

In addition, an anode material may use any anode material known in the art without limitation. Examples of the anode material may include, but not limited to, a metal such as vanadium, chromium, copper, zinc, and gold or an alloy thereof; metal oxides such as zinc oxide, indium oxide, indium tin oxide (ITO), or indium zinc oxide (IZO); combination of oxide with metal such as ZnO:Al or SnO₂:Sb; conductive polymers such as polythiophene, poly(3-methylthiophene), poly [3,4-(ethylene-1,2-dioxy) thiophene] (PEDT), polypyrrole or polyaniline; carbon black or the like.

In addition, a cathode material may use any cathode material known in the art without limitation. Examples of the cathode material may include, but not limited to, a metal such as magnesium, calcium, sodium, potassium, titanium, indium, yttrium, lithium, gadolinium, aluminum, silver, tin, or lead or an alloy thereof; a multi-layered material such as LiF/Al or LiO₂/Al or the like.

In addition, materials for the hole injection layer, the hole transport layer, the electron injection layer, and the electron transport layer are not particularly limited, and conventional materials known in the art may be used without limitation.

Hereinafter, the present invention will be described in detail through examples. However, the following examples are only to illustrate the present invention, and the present invention is not limited by the following examples.

### <Synthesis Example 1 to 11>

### [Synthesis Example 1] Synthesis of Compound 1

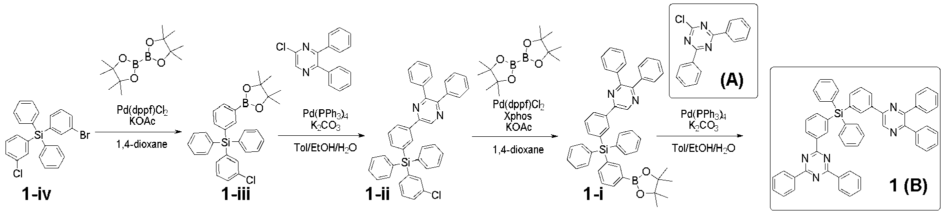

### [Synthesis Example 1-1] Synthesis of Compound 1-iii

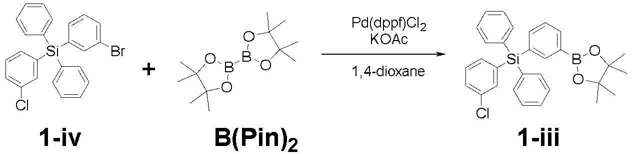

(3-bromophenyl) (3-chlorophenyl)diphenylsilane 50g, (111.1mmol, 1eq), 4,4,4',4',5,5,5',5'-octamethyl-2,2'-bi(1,3,2-dioxaborolane) 33.9g (133.4mmol, 1.2eq), PdCl2(dppf) 3.3g (4.4mmol, 0.04eq), and KOAc 21.9g (222.3mmol, 2eq) were added to 750 ml of 1,4-dioxane, and the mixture was stirred under reflux for 4 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 1-iii, (3-chlorophenyl)diphenyl(3-(4,4,5,5-tetramethyl-1,3,2-dioxaborolan-2-yl)phenyl)silane(45.3g, yield 82%).
Mass : [(M+H)⁺] : 496.91
NMR(¹H) : σ= 7.85(1H, d), 7.61(1H, s), 7.55(1H, s), 7.50-7.32(15H, m), 1,20(12H, s)

### [Synthesis Example 1-2] Synthesis of Compound 1-ii

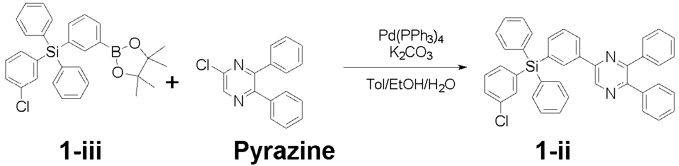

(3-chlorophenyl)diphenyl(3-(4,4,5,5-tetramethyl-1,3,2-dioxaborolan-2-yl)phenyl)silane 45.3g, (91.1mmol, 1eq) 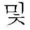 5-chloro-2,3-diphenylpyrazine 26.7g (100.3mmol, 1.1eq), Pd(PPh3)4 3.2g (2.7mmol, 0.03eq), and K₂CO₃ 25.2g (182.3, 2eq) were added to 650 ml of Toluene, 180 ml of EtOH, and 180 ml of H₂O, and the mixture was stirred under reflux for 8 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography. After concentration, the resulting product was stirred in a small amount of EA and hexane, and the precipitated solid was filtered to obtain Compound 1-ii, 5-(3-((3-chlorophenyl)diphenylsilyl)phenyl)-2,3-diphenylpyrazine (38.4g, yield 70%).
Mass : [(M+H)⁺] : 602.11
NMR (¹H) : σ= 8.79(1H, s), 8.50(1H, d), 8.44(1H, s), 8.03(2H, d), 7.68-7.59(5H, m), 7.46-7.32(19H, m)

### [Synthesis Example 1-3] Synthesis of Compound 1-i

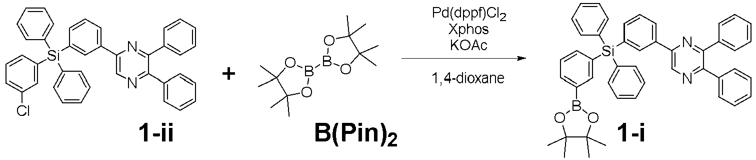

5-(3-((3-chlorophenyl)diphenylsilyl)phenyl)-2,3-diphenylpyrazine 38.4g, (63.8mmol, 1eq), 4,4,4',4',5,5,5',5'-octamethyl-2,2'-bi(1,3,2-dioxaborolane) 19.4g (76.6mmmol, 1.2eq), PdCl2(dppf) 2.3g (3.2mmol, 0.04eq), Xphos 6.1g (12.8mmol, 0.2eq), and KOAc 15.1g (153.1mmol, 2eq) were added to 570 ml of 1,4-dioxane 570ml, and the mixture was stirred under reflux for 6 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 1-i, 5-(3-(diphenyl(3-(4,4,5,5-tetramethyl-1,3,2-dioxaborolan-2-yl)phenyl)silyl)phenyl)-2,3-diphenylpyrazine (34.0g, yield 77%).
Mass : [(M+H)⁺] : 692.74
NMR(¹H) : σ= 8.79(1H, s), 8.50(1H, d), 8.46(1H, s), 8.03(2H, d), 7.85(1H, d), 7.68-7.59(5H, m), 7.46-7.32(18H, m), 1.20(12H, s)

### [Synthesis Example 1-4] Synthesis of Compound 1

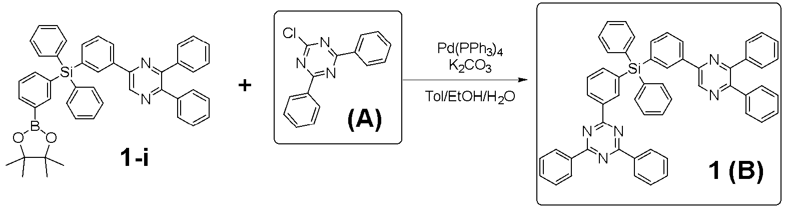

5-(3-(diphenyl(3-(4,4,5,5-tetramethyl-1,3,2-dioxaborolan-2-yl)phenyl)silyl)phenyl)-2,3-diphenylpyrazine 34.0g, (49.1mmol, 1eq), 2-chloro-4,6-diphenyl-1,3,5-triazine (e.g., intermediate A) 14.5g (54mmol, 1.1eq), Pd(PPh3)4 1.7g (1.5mmol, 0.03eq), and K₂CO₃ 13.6g (98.3mmol, 2eq) were added to 500 ml of Toluene, 150 ml of EtOH, and 150 ml of H₂O, and the mixture was stirred under reflux for 8 hours. After the completion of the reaction, the mixture was quenched with a sufficient amount of water. The precipitated solid was filtered and washed with a sufficient amount of water and MeOH. Then, the solid was adsorbed onto silica gel, and purified by column chromatography. After concentration, the resulting product was stirred in a small amount of EA and hexane, and the filtered solid was collected to obtain Compound 1 (Target compound B), (33.3g, yield 85%) as a white solid.
Mass : [(M+H)⁺] : 798.04

### [Synthesis Examples 2 to 11]

Target compounds B of Synthesis Examples 2 to 11 were synthesized in the same manner as the method for preparing Compound 1 in Synthesis Example 1, except that Intermediate A was changed as shown in Table 1 below.

**[Table 1]**

| Synthesis Example | Compound | Intermediate A | Target compound B | Yield (1-i to B) | Mass [(M+H)⁺ ] |
|---|---|---|---|---|---|
| 2 | Comp. 2 | 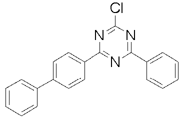 | 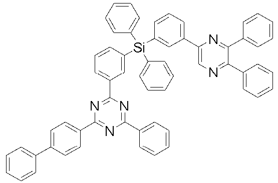 | 84% | 874.14 |
| 3 | Comp. 3 | 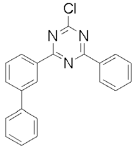 | 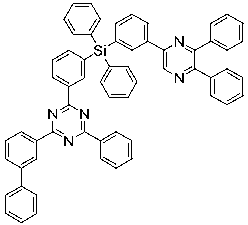 | 85% | 874.14 |
| 4 | Comp. 5 | 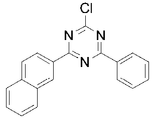 | 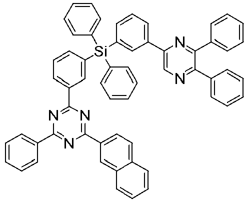 | 83% | 848.10 |
| 5 | Comp. 8 | 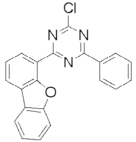 | 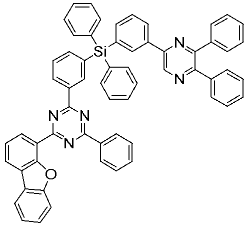 | 84% | 888.12 |
| 6 | Comp. 9 | 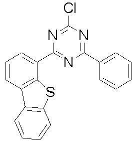 | 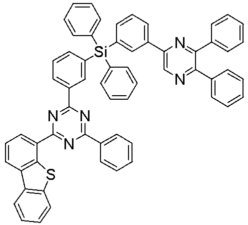 | 80% | 904.18 |
| 7 | Comp. 11 | 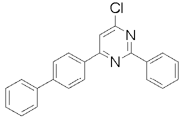 | 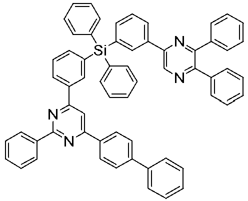 | 83% | 873.15 |
| 8 | Comp. 12 | 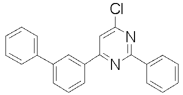 | 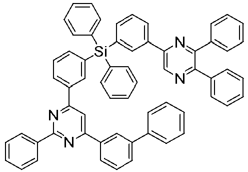 | 82% | 873.15 |
| 9 | Comp. 14 | 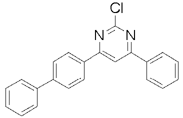 | 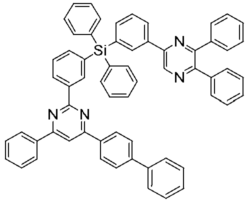 | 85% | 873.15 |
| 10 | Comp. 17 | 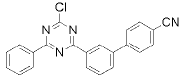 | 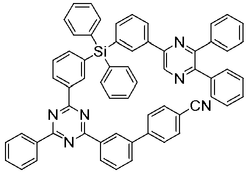 | 77% | 899.15 |
| 11 | Comp. 19 | 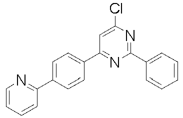 | 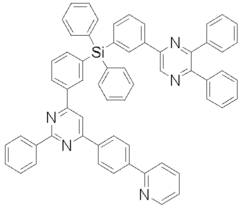 | 76% | 874.14 |

### <Synthesis Examples 12 to 17>

### [Synthesis Example 12] Synthesis of Compound 21

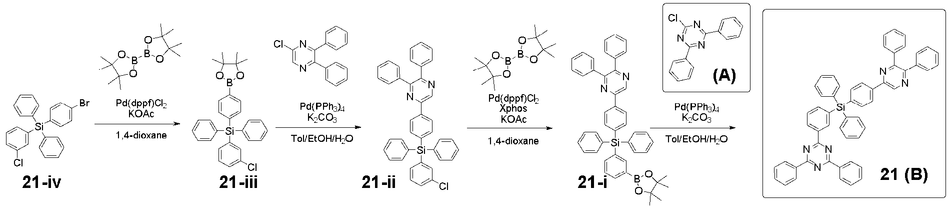

### [Synthesis Example 12-1] Synthesis of Compound 21-iii

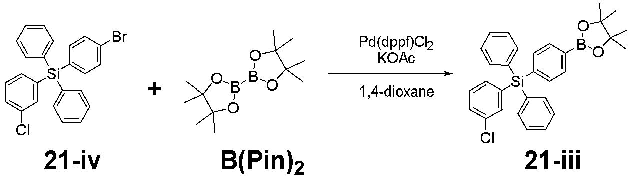

(4-bromophenyl) (3-chlorophenyl)diphenylsilane 50g, (111.1mmol, 1eq), 4,4,4',4',5,5,5',5'-octamethyl-2,2'-bi(1,3,2-dioxaborolane) 33.9g (133.4mmol, 1.2eq), PdCl2(dppf) 3.3g (4.4mmol, 0.04eq), and KOAc 21.9g (222.3mmol, 2eq) were added to 750 ml of 1,4-dioxane 750ml, and the mixture was stirred under reflux for 4 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 21-iii, ((3-chlorophenyl)diphenyl(4-(4,4,5,5-tetramethyl-1,3,2-dioxaborolan-2-yl)phenyl)silane (44.2g, yield 80%).
Mass : [(M+H)⁺] : 496.91
NMR(¹H) : σ= 7.85 (2H, d), 7.55(1H, s), 7.46-7.32(15H, m), 1,20(12H, s)

### [Synthesis Example 12-2] Synthesis of Compound 21-ii

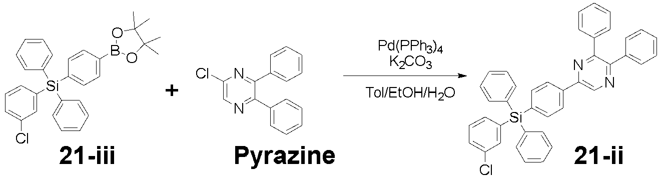

(3-chlorophenyl)diphenyl(4-(4,4,5,5-tetramethyl-1,3,2-dioxaborolan-2-yl)phenyl)silane 44.2g, (88.9mmol, 1eq), 5-chloro-2,3-diphenylpyrazine 26.1g (97.8mmol, 1.1eq), Pd(PPh3)4 3.1g (2.7mmol, 0.03eq), and K₂CO₃ 24.6g (177.8, 2eq) were added to 650 ml of Toluene, 180 ml of EtOH, and 180 ml of H₂O, and the mixture was stirred under reflux for 8 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography. After concentration, the resulting product was stirred in a small amount of EA and hexane, and the precipitated solid was filtered to obtain Compound 21-ii, 5-(4-((3-chlorophenyl)diphenylsilyl)phenyl)-2,3-diphenylpyrazine (37.4g, yield 70%).
Mass : [(M+H)⁺] : 602.11
NMR(¹H) : σ= 8.79(1H, s), 8.50(1H, d), 8.44(1H, s), 8.03(2H, d), 7.68-7.59(5H, m), 7.46-7.32(19H, m)

### [Synthesis Example 12-3] Synthesis of Compound 21-i

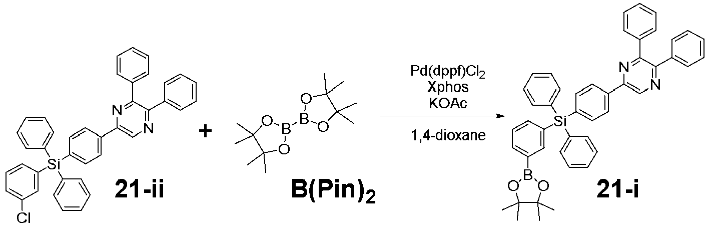

5-(4-((3-chlorophenyl)diphenylsilyl)phenyl)-2,3-diphenylpyrazine 37.4g, (62.2mmol, 1eq), 4,4,4',4',5,5,5',5'-octamethyl-2,2'-bi(1,3,2-dioxaborolane) 19.0g (74.7mmmol, 1.2eq), PdCl2(dppf) 2.3g (3.1mmol, 0.04eq), Xphos 5.9g (12.4mmol, 0.2eq), and KOAc 14.7g (149.4mmol, 2eq) were added to 560 ml of 1,4-dioxane, and the mixture was stirred under reflux for 6 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 21-i, 5-(4-(diphenyl(3-(4,4,5,5-tetramethyl-1,3,2-dioxaborolan-2-yl)phenyl)silyl)phenyl)-2,3-diphenylpyrazine (34.1g, yield 79%).
Mass : [(M+H)⁺] : 692.74
NMR(¹H) : σ= 8.79(1H, s), 8.43(2H, d), 8.03(2H, d), 7.85(1H, d), 7.69(2H, d), 7.61-7.59(3H, m), 7.45-7.32(18H, m), 1.20(12H, s)

### [Synthesis Example 12-4] Synthesis of Compound 21

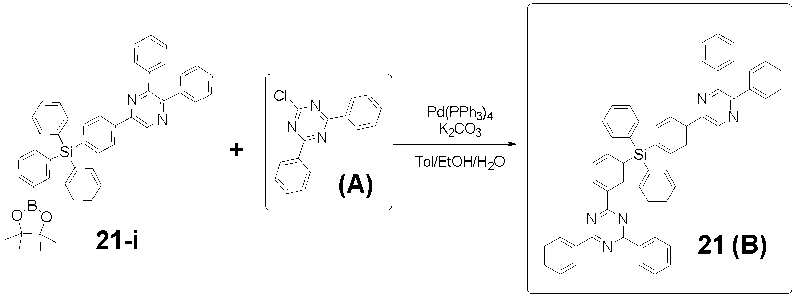

5-(4-(diphenyl(3-(4,4,5,5-tetramethyl-1,3,2-dioxaborolan-2-yl)phenyl)silyl)phenyl)-2,3-diphenylpyrazine 34.1g, (49.2mmol, 1eq) 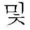 2-chloro-4,6-diphenyl-1,3,5-triazine(e.g., Intermediate A) 14.5g (54.1mmol, 1.1eq), Pd(PPh3)4 1.7g (1.5mmol, 0.03eq), and K₂CO₃ 13.6g (98.3mmol, 2eq) were added to 500 ml of Toluene, 140 ml of EtOH, and 140 ml of H₂O, and the mixture was stirred under reflux for 8 hours. After the completion of the reaction, the mixture was quenched with a sufficient amount of water. The precipitated solid was filtered and washed with a sufficient amount of water and MeOH. Then, the solid was adsorbed onto silica gel, and purified by column chromatography. After concentration, the resulting product was stirred in a small amount of EA and hexane, and the filtered solid was collected to obtain Compound 21 (Target compound B), (33.0g, yield 84%) as a white solid.
Mass : [(M+H)⁺] : 798.04

### [Synthesis Examples 13 to 17]

Target compounds B of Synthesis Examples 13 to 17 were synthesized in the same manner as the method for preparing Compound 21 in Synthesis Example 12, except that Intermediate A was changed as shown in Table 2 below.

**[Table 2]**

| Synthesis Example | Compound | Intermediate A | Target compound B | Yield (1-i to B) | Mass [(M+H)⁺ ] |
|---|---|---|---|---|---|
| 13 | Comp. 22 | 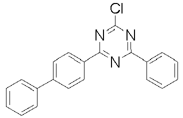 | 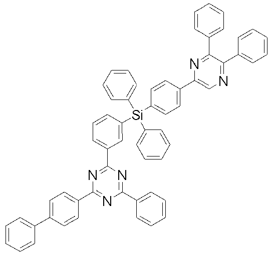 | 85% | 874.14 |
| 14 | Comp. 25 | 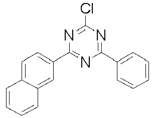 | 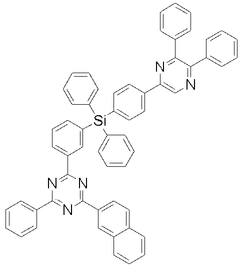 | 83% | 848.10 |
| 15 | Comp. 28 | 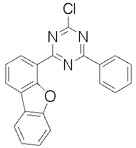 | 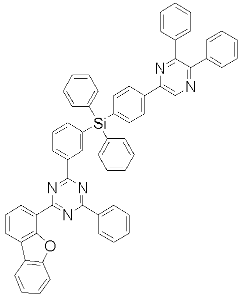 | 84% | 888.12 |
| 16 | Comp. 31 | 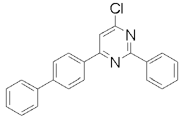 | 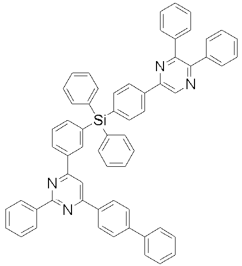 | 80% | 873.15 |
| 17 | Comp. 40 | 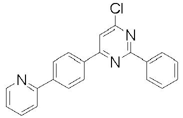 | 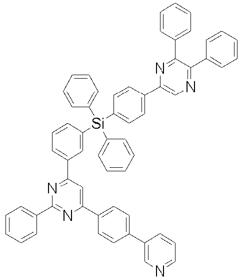 | 83% | 874.14 |

### <Synthesis Examples 18 to 22>

### [Synthesis Example 18] Synthesis of Compound 41

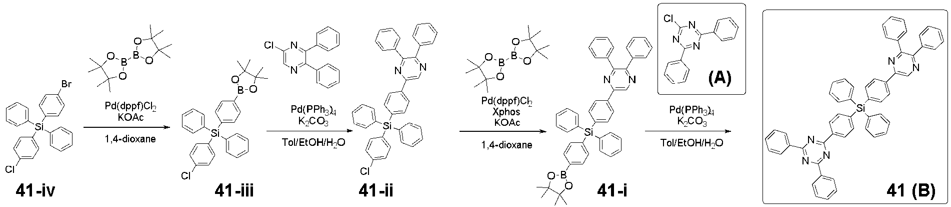

### [Synthesis Example 18-1] Synthesis of Compound 41-iii

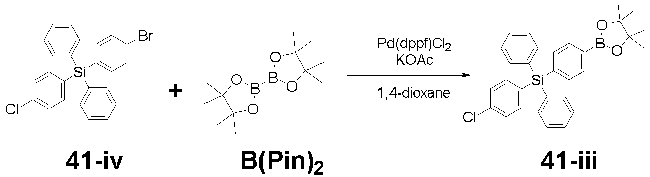

(4-bromophenyl) (4-chlorophenyl)diphenylsilane 50g, (111.1mmol, 1eq), 4,4,4',4',5,5,5',5'-octamethyl-2,2'-bi(1,3,2-dioxaborolane) 33.9g (133.4mmol, 1.2eq), PdCl2(dppf) 3.3g (4.4mmol, 0.04eq), KOAc 21.9g (222.3mmol, 2eq) were added to 750 ml of 1,4-dioxane, and the mixture was stirred under reflux for 4 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 41-iii, (4-chlorophenyl)diphenyl(4-(4,4,5,5-tetramethyl-1,3,2-dioxaborolan-2-yl)phenyl)silane (44.7g, yield 81%).
Mass : [(M+H)⁺] : 496.91
NMR(¹H) : σ= 7.85(2H, d), 7.52-7.38(16H, m), 1,20(12H, s)

### [Synthesis Example 18-2] Synthesis of Compound 41-ii

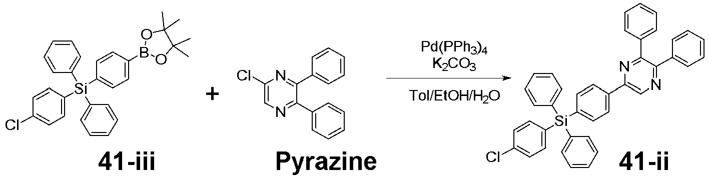

(4-chlorophenyl)diphenyl(4-(4,4,5,5-tetramethyl-1,3,2-dioxaborolan-2-yl)phenyl)silane 44.7g, (90.0mol, 1eq), 5-chloro-2,3-diphenylpyrazine 26.4g (99.0mmol, 1.1eq), Pd(PPh3)4 3.1g (2.7mmol, 0.03eq), and K₂CO₃ 24. 6g (180.1ml, 2eq) were added to 650 ml of Toluene, 180 ml of EtOH, and 180 ml of H₂O, and the mixture was stirred under reflux for 8 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography. After concentration, the resulting product was stirred in a small amount of EA and hexane, and the precipitated solid was filtered to obtain Compound 41-ii, 5-(4-((4-chlorophenyl)diphenylsilyl)phenyl)-2,3-diphenylpyrazine (41.1g, yield 76%).
Mass : [(M+H)⁺] : 602.11
NMR(¹H) : σ= 8.79(1H, s), 8.43(2H, d), 8.03(2H, d), 7.69(2H, d), 7.59-7.32(22H, m)

### [Synthesis Example 18-3] Synthesis of Compound 41-i

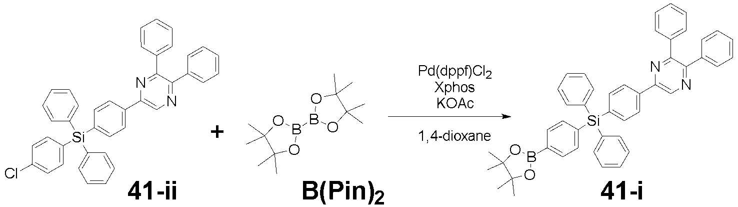

5-(4-((4-chlorophenyl)diphenylsilyl)phenyl)-2,3-diphenylpyrazine 41.1g, (68.4mmol, 1eq), 4,4,4',4',5,5,5',5'-octamethyl-2,2'-bi(1,3,2-dioxaborolane) 20.9g (82.1mmmol, 1.2eq), PdCl2(dppf) 2.5g (3.4mmol, 0.04eq), Xphos 6.5g (13.7mmol, 0.2eq), and KOAc 16.2g (164.2mmol, 2eq) were added to 620 ml of 1,4-dioxane, and the mixture was stirred under reflux for 6 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 41-i, 5-(4-(diphenyl(4-(4,4,5,5-tetramethyl-1,3,2-dioxaborolan-2-yl)phenyl)silyl)phenyl)-2,3-diphenylpyrazine (38.9g, yield 82%).
Mass : [(M+H)⁺] : 692.74
NMR(¹H) : σ= 8.79(1H, s), 8.43(2H, d), 8.03(2H, d), 7.85(1H, d), 7.69(2H, d), 7.61-7.59(3H, m), 7.45-7.32(18H, m), 1.20(12H, s)

### [Synthesis Example 18-4] Synthesis of Compound 41

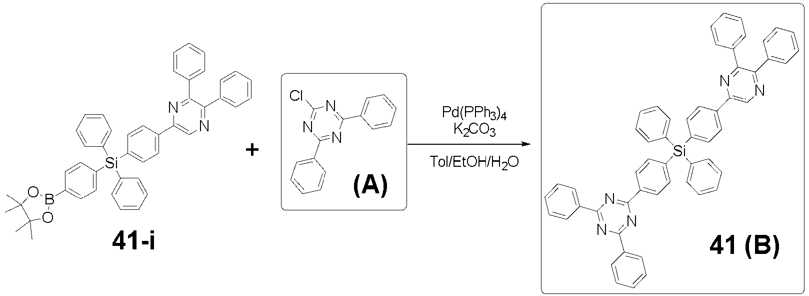

5-(4-(diphenyl(4-(4,4,5,5-tetramethyl-1,3,2-dioxaborolan-2-yl)phenyl)silyl)phenyl)-2,3-diphenylpyrazine 38.9g, (56.1mmol, 1eq), 2-chloro-4,6-diphenyl-1,3,5-triazine (e.g., Intermediate A) 16.5g (61.7mmol, 1.1eq), Pd(PPh3)4 1.9g (1.7mmol, 0.03eq), and K₂CO₃ 15.5g (112.2mmol, 2eq) were added to 600 ml of Toluene, 150 ml of EtOH, and 150 ml of H₂O, and the mixture was stirred under reflux for 8 hours. After the completion of the reaction, the mixture was quenched with a sufficient amount of water. The precipitated solid was filtered and washed with a sufficient amount of water and MeOH. Then, the solid was adsorbed onto silica gel, and purified by column chromatography. After concentration, the resulting product was stirred in a small amount of EA and hexane, and the filtered solid was collected to obtain Compound 41(Target compound B), (37.2g, yield 83%) as a white solid.
Mass : [(M+H)⁺] : 874.14

### [Synthesis Examples 19 to 22]

Target compounds B of Synthesis Examples 19 to 22 were synthesized in the same manner as the method for preparing Compound 41 in Synthesis Example 18, except that Intermediate A was changed as shown in Table 3 below.

**[Table 3]**

| Synthesis Example | Compound | Intermediate A | Target compound B | Yield (1-i to B) | Mass [(M+H)⁺ ] |
|---|---|---|---|---|---|
| 19 | Comp. 45 | 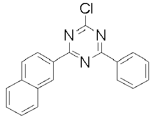 | 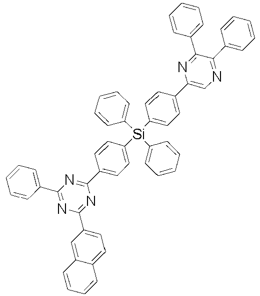 | 79% | 848.10 |
| 20 | Comp. 48 | 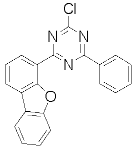 | 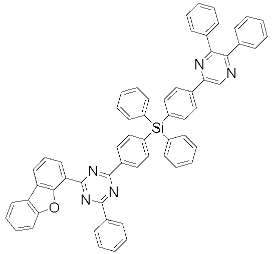 | 83% | 888.12 |
| 21 | Comp. 49 | 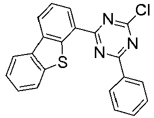 | 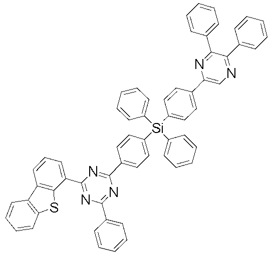 | 83% | 904.18 |
| 22 | Comp. 51 | 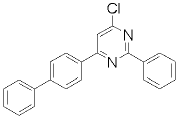 | 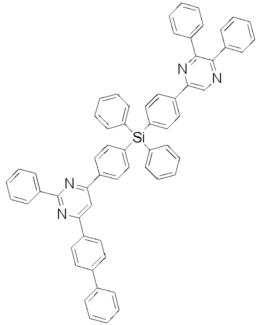 | 81% | 873.15 |

### <Synthesis Examples 23 to 28>

### [Synthesis Example 23] Synthesis of Compound 61

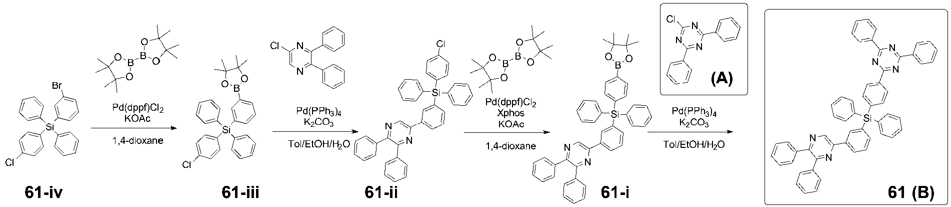

### [Synthesis Example 23-1] Synthesis of Compound 61-iii

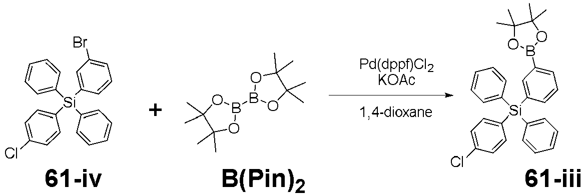

(3-bromophenyl)(4-chlorophenyl)diphenylsilane 50g, (111.1mmol, 1eq), 4,4,4',4',5,5,5',5'-octamethyl-2,2'-bi(1,3,2-dioxaborolane) 33.9g (133.4mmol, 1.2eq), PdCl2(dppf) 3.3g (4.4mmol, 0.04eq), and KOAc 21.9g (222.3mmol, 2eq) were added to 750 ml of 1,4-dioxane 750ml, and the mixture was stirred under reflux for 4 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 61-iii, (4-chlorophenyl)diphenyl(3-(4,4,5,5-tetramethyl-1,3,2-dioxaborolan-2-yl)phenyl)silane (45.3g, yield 82%).
Mass : [(M+H)⁺] : 496.91
NMR (¹H) : σ= 7.85(1H, d), 7.61(1H, s), 7.52-7.32(16H, m), 1,20(12H, s)

### [Synthesis Example 23-2] Synthesis of Compound 61-ii

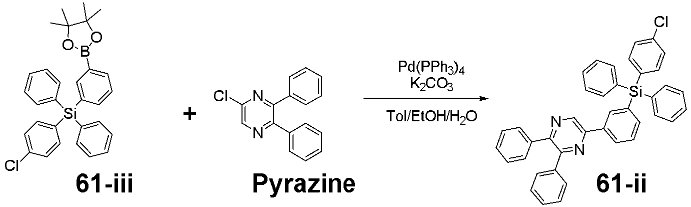

(4-chlorophenyl)diphenyl(3-(4,4,5,5-tetramethyl-1,3,2-dioxaborolan-2-yl)phenyl)silane 45.3g, (91.1mmol, 1eq), 5-chloro-2,3-diphenylpyrazine 26.7g (100.3mmol, 1.1eq), Pd(PPh3)4 3.2g (2.7mmol, 0.03eq), and K₂CO₃ 25.2g (182.3mmol, 2eq) were added to 650 ml of Toluene, 180 ml of EtOH, and 180 ml of H₂O, and the mixture was stirred under reflux for 8 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography. After concentration, the resulting product was stirred in a small amount of EA and hexane, and the precipitated solid was filtered to obtain Compound 61-ii, 5-(3-((4-chlorophenyl)diphenylsilyl)phenyl)-2,3-diphenylpyrazine (43.8g, yield 80%).
Mass : [(M+H)⁺] : 602.11
NMR(¹H) : σ= 8.79(1H, s), 8.50(1H, d), 8.46(1H, s), 8.03(2H, d), 7.68-7.32(24H, m)

### [Synthesis Example 23-3] Synthesis of Compound 61-i

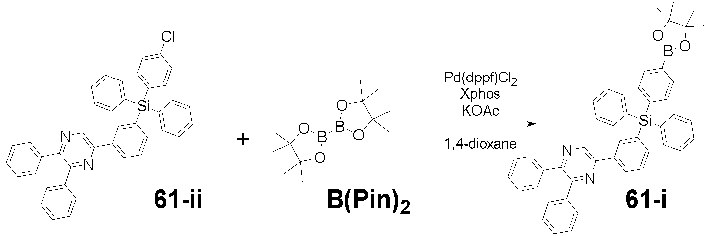

5-(3-((4-chlorophenyl)diphenylsilyl)phenyl)-2,3-diphenylpyrazine 43.8g, (72.9mmol, 1eq), 4,4,4',4',5,5,5',5'-octamethyl-2,2'-bi(1,3,2-dioxaborolane) 22.2g (87.5mmmol, 1.2eq), PdCl2(dppf) 2.7g (3.6mmol, 0.04eq), Xphos 7.0g (14.6mmol, 0.2eq), and KOAc 17.2g (175.0mmol, 2eq) were added to 640 ml of 1,4-dioxane 640ml, and the mixture was stirred under reflux for 6 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 61-i, 5-(3-(diphenyl(4-(4,4,5,5-tetramethyl-1,3,2-dioxaborolan-2-yl)phenyl)silyl)phenyl)-2,3-diphenylpyrazine (38.4g, yield 76%).
Mass : [(M+H)⁺] : 692.74
NMR(¹H) : σ= = 8.79(1H, s), 8.50(1H, d), 8.46(1H, s), 8.03(2H, d), 7.85(2H, d), 7.68(2H, d), 7.59(2H, d), 7.46-7.32(18H, m), 1.20(12H, s)

### [Synthesis Example 23-4] Synthesis of Compound 61

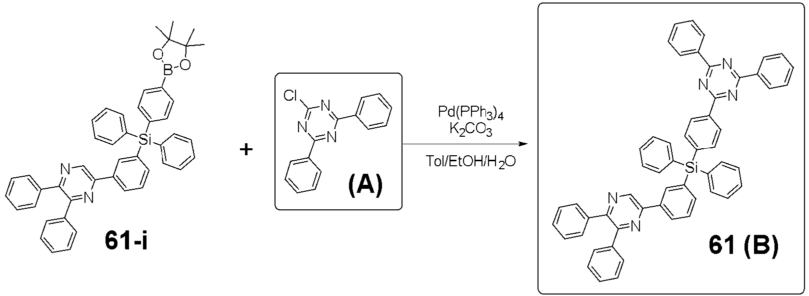

5-(3-(diphenyl(4-(4,4,5,5-tetramethyl-1,3,2-dioxaborolan-2-yl)phenyl)silyl)phenyl)-2,3-diphenylpyrazine 38.4g, (55.4mmol, 1eq), 2-chloro-4,6-diphenyl-1,3,5-triazine (e.g., Intermediate A) 16.3g (61.0mmol, 1.1eq), Pd(PPh3)4 1.9g (1.7mmol, 0.03eq), and K₂CO₃ 15.3g (110.8mmol, 2eq) were added to 550 ml of Toluene, 150 ml of EtOH, and 150 ml of H₂O, and the mixture was stirred under reflux for 8 hours. After the completion of the reaction, the mixture was quenched with a sufficient amount of water. The precipitated solid was filtered and washed with a sufficient amount of water and MeOH. Then, the solid was adsorbed onto silica gel, and purified by column chromatography. After concentration, the resulting product was stirred in a small amount of EA and hexane, and the filtered solid was collected to obtain Compound 61 (Target compound B), (36.3g, yield 82%) as a white solid.
Mass : [(M+H)⁺] : 798.04

### [Synthesis Examples 24 to 28]

Target compounds B of Synthesis Examples 24 to 28 were synthesized in the same manner as the method for preparing Compound 61 in Synthesis Example 23, except that Intermediate A was changed as shown in Table 4 below.

**[Table 4]**

| Synt hesi s Exam ple | Compound | Intermediate A | Target compound B | Yield (1-i to B) | Mass [(M+H)⁺ ] |
|---|---|---|---|---|---|
| 24 | Comp. 63 | 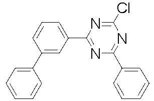 | 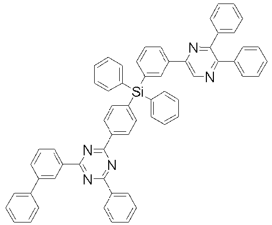 | 85% | 874.14 |
| 25 | Comp. 65 | 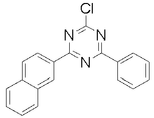 | 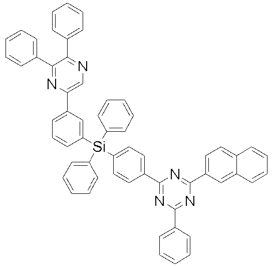 | 83% | 848.10 |
| 26 | Comp. 66 | 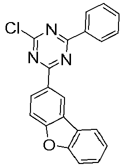 | 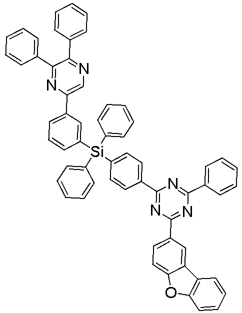 | 84% | 888.12 |
| 27 | Comp. 71 | 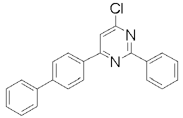 | 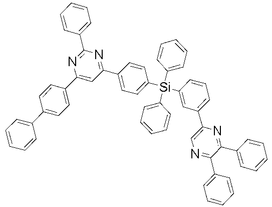 | 80% | 873.15 |
| 28 | Comp. 77 | 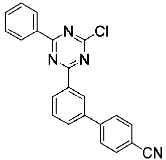 | 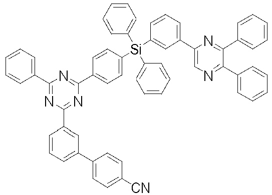 | 83% | 899.15 |

### [Synthesis Example 29] Synthesis of Compound 81

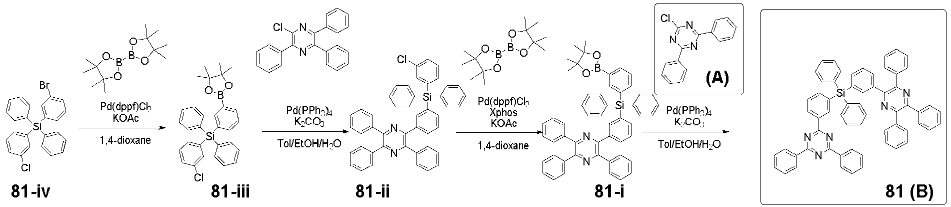

### [Synthesis Example 29-1] Synthesis of Compound 81-iii

((3-bromophenyl)(3-chlorophenyl)diphenylsilane 50g, (111.1mmol, 1eq), 4,4,4',4',5,5,5',5'-octamethyl-2,2'-bi(1,3,2-dioxaborolane) 33.9g (133.4mmol, 1.2eq), PdCl2(dppf) 3.3g (4.4mmol, 0.04eq), and KOAc 21.9g (222.3mmol, 2eq) were added to 750 ml of 1,4-dioxane, and the mixture was stirred under reflux for 4 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 81-iii, (3-chlorophenyl)diphenyl(3-(4,4,5,5-tetramethyl-1,3,2-dioxaborolan-2-yl)phenyl)silane(45.3g, yield 82%).
Mass : [(M+H)⁺] : 496.91
NMR(¹H) : σ= 7.85(1H, d), 7.61(1H, s), 7.55(1H, s), 7.50-7.32(15H, m), 1,20(12H, s)

### [Synthesis Example 29-2] Synthesis of Compound 81-ii

(3-chlorophenyl)diphenyl(3-(4,4,5,5-tetramethyl-1,3,2-dioxaborolan-2-yl)phenyl)silane 45.3g, (91.1mmol, 1eq), 2-chloro-3,5,6-triphenylpyrazine 34.4g (100.3mmol, 1.1eq), Pd(PPh3)4 3.2g (2.7mmol, 0.03eq), and K₂CO₃ 25.2g (182.3mmol, 2eq) were added to 650 ml of Toluene, 180 ml of EtOH, and 180 ml of H₂O, and the mixture was stirred under reflux for 9 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography. After concentration, the resulting product was stirred in a small amount of EA and hexane, and the precipitated solid was filtered to obtain Compound 81-ii, 2-(3-((3-chlorophenyl)diphenylsilyl)phenyl)-3,5,6-triphenylpyrazine (46.3g, yield 75%).
Mass : [(M+H)⁺] : 677.32
NMR(¹H) : σ= 8.50(1H, d), 8.44(1H, d), 8.03(6H, s), 7.66-7.59(6H, m), 7.46-7.32(19H, m)

### [Synthesis Example 29-3] Synthesis of Compound 81-i

2-(3-((3-chlorophenyl)diphenylsilyl)phenyl)-3,5,6-triphenylpyrazine 46.3g, (68.4mmol, 1eq), 4,4,4',4',5,5,5',5'-octamethyl-2,2'-bi(1,3,2-dioxaborolane) 20.8g (82.0mmmol, 1.2eq), PdCl2(dppf) 2.5g (3.4mmol, 0.04eq), Xphos 6.5g (13.7mmol, 0.2eq), and KOAc 16.1g (164.1mmol, 2eq) were added to 700 ml of 1,4-dioxane , and the mixture was stirred under reflux for 8 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 81-i, 2-(3-(diphenyl(3-(4,4,5,5-tetramethyl-1,3,2-dioxaborolan-2-yl)phenyl)silyl)phenyl)-3,5,6-triphenylpyrazine (40.5g, yield 77%).
Mass : [(M+H)⁺] : 768.84
NMR(¹H) : σ= = 88.50(1H, d), 8.44 (1H, s), 8.03(6H, m), 7.85(1H, d), 7.66-7.59(6H, m), 7.45-7.32(18H, m), 1.20(12H, s)

### [Synthesis Example 29-4] Synthesis of Compound 81

2-(3-(diphenyl(3-(4,4,5,5-tetramethyl-1,3,2-dioxaborolan-2-yl)phenyl)silyl)phenyl)-3,5,6-triphenylpyrazine 40.5g, (52.6mmol, 1eq), 2-chloro-4,6-diphenyl-1,3,5-triazine (Intermediate A) 15.5g (57.9mmol, 1.1eq), Pd(PPh3)4 1.8g (1.6mmol, 0.03eq), and K₂CO₃ 14.5g (105.3mmol, 2eq) were added to 600 ml of Toluene, 180 ml of EtOH, and 180 ml of H₂O, and the mixture was stirred under reflux for 6 hours. After the completion of the reaction, the mixture was quenched with a sufficient amount of water. The precipitated solid was filtered and washed with a sufficient amount of water and MeOH. Then, the solid was adsorbed onto silica gel, and purified by column chromatography. After concentration, the resulting product was stirred in a small amount of EA and hexane, and the filtered solid was collected to obtain Compound 81 (Target compound B), (36.8g, yield 80%) as a white solid.
Mass : [(M+H)⁺] : 874.14

### [Synthesis Example 30] Synthesis of Compound 82

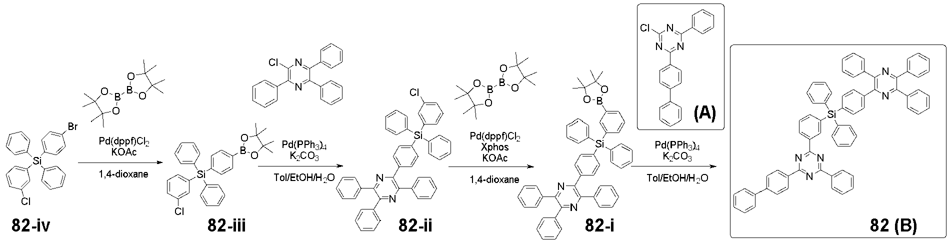

### [Synthesis Example 30-1] Synthesis of Compound 82-iii

(4-bromophenyl)(3-chlorophenyl)diphenylsilane 50g, (111.1mmol, 1eq), 4,4,4',4',5,5,5',5'-octamethyl-2,2'-bi(1,3,2-dioxaborolane) 33.9g (133.4mmol, 1.2eq), PdCl2(dppf) 3.3g (4.4mmol, 0.04eq), and KOAc 21.9g (222.3mmol, 2eq) were added to 750 ml of 1,4-dioxane, and the mixture was stirred under reflux for 4 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 82-iii, (3-chlorophenyl)diphenyl(4-(4,4,5,5-tetramethyl-1,3,2-dioxaborolan-2-yl)phenyl)silane (44.2g, yield 80%).
Mass : [(M+H)⁺] : 496.91
NMR(¹H) : σ= 7.85(2H, d), 7.55(1H, s), 7.46-7.32(15H, m), 1,20(12H, s)

### [Synthesis Example 30-2] Synthesis of Compound 82-ii

(3-chlorophenyl)diphenyl(4-(4,4,5,5-tetramethyl-1,3,2-dioxaborolan-2-yl)phenyl)silane 44.2g, (88.9mmol, 1eq), 2-chloro-3,5,6-triphenylpyrazine 33.5g (97.8mmol, 1.1eq), Pd(PPh3)4 3.1g (2.7mmol, 0.03eq), and K₂CO₃ 24.6g (177.8mmol, 2eq) were added to 650 ml of Toluene, 180 ml of EtOH, and 180 ml of H₂O, and the mixture was stirred under reflux for 9 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography. After concentration, the resulting product was stirred in a small amount of EA and hexane, and the precipitated solid was filtered to obtain Compound 82-ii, 2-(4-((3-chlorophenyl)diphenylsilyl)phenyl)-3,5,6-triphenylpyrazine (47.6g, yield 75%).
Mass : [(M+H)⁺] : 677.32
NMR (¹H) : σ= 8.43(2H, d), 8.03(6H, d), 7.69(2H, d), 7.59-7.55(4H, m), 7.46-7.32(19H ,m)

### [Synthesis Example 30-3] Synthesis of Compound 81-i

2-(4-((3-chlorophenyl)diphenylsilyl)phenyl)-3,5,6-triphenylpyrazine 47.6g, (70.2mmol, 1eq), 4,4,4',4',5,5,5',5'-octamethyl-2,2'-bi(1,3,2-dioxaborolane) 21.4g (84.3mmmol, 1.2eq), PdCl2(dppf) 2.6g (3.5mmol, 0.04eq), Xphos 6.7g (14.0mmol, 0.2eq), and KOAc 16.6g (168.6mmol, 2eq) were added to 700 ml of 1,4-dioxane, and the mixture was stirred under reflux for 8 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 82-i, 2-(4-(diphenyl(3-(4,4,5,5-tetramethyl-1,3,2-dioxaborolan-2-yl)phenyl)silyl)phenyl)-3,5,6-triphenylpyrazine (41.6g, yield 77%).
Mass : [(M+H)⁺] : 768.84
NMR(¹H) : σ= = 8.43(2H, d), 8.03(6H ,d), 7.85(1H, d), 7.69(2H, d), 7.61-7.59(4H, m), 7.46-7.32(18H, m), 1.20(12H, s)

### [Synthesis Example 30-4] Synthesis of Compound 82

2-(4-(diphenyl(3-(4,4,5,5-tetramethyl-1,3,2-dioxaborolan-2-yl)phenyl)silyl)phenyl)-3,5,6-triphenylpyrazine 41.6g, (54.1mmol, 1eq), 2-([1,1'-biphenyl]-4-yl)-4-(3-chlorophenyl)-6-phenyl-1,3,5-triazine (e.g., Intermediate A) 25.0g (59.5mmol, 1.1eq), Pd(PPh3)4 1.9g (1.6mmol, 0.03eq), and K₂CO₃ 15.0g (108.2mmol, 2eq) were added to 600 ml of Toluene, 180 ml of EtOH, and 180 ml of H₂O, and the mixture was stirred under reflux for 6 hours. After the completion of the reaction, the mixture was quenched with a sufficient amount of water. The precipitated solid was filtered and washed with a sufficient amount of water and MeOH. Then, the solid was adsorbed onto silica gel, and purified by column chromatography. After concentration, the resulting product was stirred in a small amount of EA and hexane, and the filtered solid was collected to obtain Compound 81 (Target compound B), (42.1g, yield 82%) as a white solid.
Mass : [(M+H)⁺] : 950.23

### [Synthesis Example 31] Synthesis of Compound 85

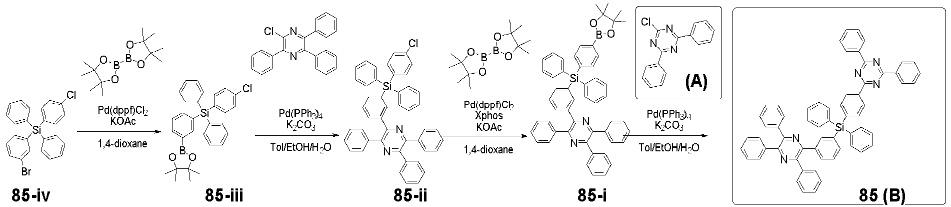

### [Synthesis Example 31-1] Synthesis of Compound 85-iii

(4-bromophenyl) (4-chlorophenyl)diphenylsilane 50g, (111.1mmol, 1eq), 4,4,4',4',5,5,5',5'-octamethyl-2,2'-bi(1,3,2-dioxaborolane) 33.9g (133.4mmol, 1.2eq), PdCl2(dppf) 3.3g (4.4mmol, 0.04eq), and KOAc 21.9g (222.3mmol, 2eq) were added to 750 ml of 1,4-dioxane, and the mixture was stirred under reflux for 4 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 85-iii, (4-chlorophenyl)diphenyl(4-(4,4,5,5-tetramethyl-1,3,2-dioxaborolan-2-yl)phenyl)silane (44.7g, yield 81%).
Mass : [(M+H)⁺] : 496.91
NMR(¹H) : σ= 7.85(2H, d), 7.52-7.38(16H, m), 1,20(12H, s)

### [Synthesis Example 31-2] Synthesis of Compound 85-ii

(4-chlorophenyl)diphenyl(4-(4,4,5,5-tetramethyl-1,3,2-dioxaborolan-2-yl)phenyl)silane 44.7g, (90.0mol, 1eq), 2-chloro-3,5,6-triphenylpyrazine 34.0g (99.0mmol, 1.1eq), Pd(PPh3)4 3.1g (2.7mmol, 0.03eq), and K₂CO₃ 24.6g (180.1ml, 2eq) were added to 650 ml of Toluene, 180 ml of EtOH, and 180 ml of H₂O, and the mixture was stirred under reflux for 8 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography. After concentration, the resulting product was stirred in a small amount of EA and hexane, and the precipitated solid was filtered to obtain Compound 85-ii, 2-(3-((4-chlorophenyl)diphenylsilyl)phenyl)-3,5,6-triphenylpyrazine (45.7g, yield 75%).
Mass : [(M+H)⁺] : 602.11
NMR(¹H) : σ= 8.50(1H, d), 8.44(1H, s), 8.03(6H, d), 7.66-7.32(25H, m)

### [Synthesis Example 31-3] Synthesis of Compound 85-i

2-(3-((4-chlorophenyl)diphenylsilyl)phenyl)-3,5,6-triphenylpyrazine 45.7g, (67.5mmol, 1eq), 4,4,4',4',5,5,5',5'-octamethyl-2,2'-bi(1,3,2-dioxaborolane) 20.6g (81.0mmmol, 1.2eq), PdCl2(dppf) 2.5g (3.4mmol, 0.04eq), Xphos 6.4g (13.5mmol, 0.2eq), and KOAc 15.9g (162.1mmol, 2eq) were added to 620 ml of 1,4-dioxane, and the mixture was stirred under reflux for 6 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 85-i, 2-(3-(diphenyl(4-(4,4,5,5-tetramethyl-1,3,2-dioxaborolan-2-yl)phenyl)silyl)phenyl)-3,5,6-triphenylpyrazine (40.0g, yield 77%).
Mass : [(M+H)⁺] : 692.74
NMR(¹H) : σ=8.50(1H, d), 8.44(1H, s), 8.03(6H, d), 7.85(2H, d), 7.68-7.59(5H, m), 7.46-7.32(18H, m), 1.20(12H, s)

### [Synthesis Example 31-4] Synthesis of Compound 85

2-(3-(diphenyl(4-(4,4,5,5-tetramethyl-1,3,2-dioxaborolan-2-yl)phenyl)silyl)phenyl)-3,5,6-triphenylpyrazine 40.0g, (52.0mmol, 1eq), 2-chloro-4,6-diphenyl-1,3,5-triazine (e.g., Intermediate A) 15.3g (57.2mmol, 1.1eq), Pd(PPh3)4 1.8g (1.6mmol, 0.03eq), and K₂CO₃ 14.4g (104.0mmol, 2eq) were added to 600 ml of Toluene, 150 ml of EtOH, and 150 ml of H₂O, and the mixture was stirred under reflux for 8 hours. After the completion of the reaction, the mixture was quenched with a sufficient amount of water. The precipitated solid was filtered and washed with a sufficient amount of water and MeOH. Then, the solid was adsorbed onto silica gel, and purified by column chromatography. After concentration, the resulting product was stirred in a small amount of EA and hexane, and the filtered solid was collected to obtain Compound 85 (Target compound B), (37.3g, yield 82%) as a white solid.
Mass : [(M+H)⁺] : 874.14

### [Synthesis Example 32] Synthesis of Compound 89

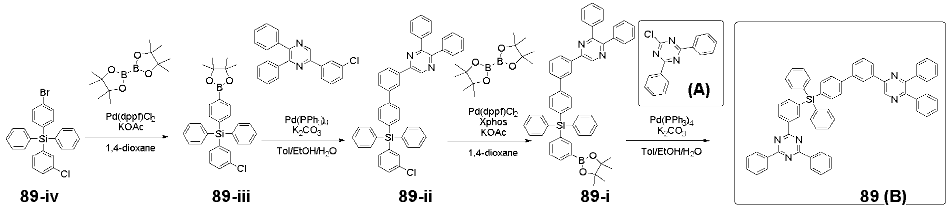

### [Synthesis Example 32-1] Synthesis of Compound 89-iii

(4-bromophenyl) (3-chlorophenyl)diphenylsilane 50g, (111.1mmol, 1eq), 4,4,4',4',5,5,5',5'-octamethyl-2,2'-bi(1,3,2-dioxaborolane) 33.9g (133.4mmol, 1.2eq), PdCl2(dppf) 3.3g (4.4mmol, 0.04eq), and KOAc 21.9g (222.3mmol, 2eq) were added to 750 ml of 1,4-dioxane, and the mixture was stirred under reflux for 4 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 89-iii, (3-chlorophenyl)diphenyl(4-(4,4,5,5-tetramethyl-1,3,2-dioxaborolan-2-yl)phenyl)silane (44.2g, yield 80%).
Mass : [(M+H)⁺] : 496.91
NMR(¹H) : σ= 7.85(2H, d), 7.55(1H, s), 7.46-7.32(15H, m), 1,20(12H, s)

### [Synthesis Example 32-2] Synthesis of Compound 89-ii

(3-chlorophenyl)diphenyl(4-(4,4,5,5-tetramethyl-1,3,2-dioxaborolan-2-yl)phenyl)silane 44.2g, (88.9mmol, 1eq), 5-(3-chlorophenyl)-2,3-diphenylpyrazine 33.5g (97.8mmol, 1.1eq), Pd(PPh3)4 3.1g (2.7mmol, 0.03eq), and K₂CO₃ 24.6g (177.8mmol, 2eq) were added to 650 ml of Toluene, 180 ml of EtOH, and 180 ml of H₂O, and the mixture was stirred under reflux for 6 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography. After concentration, the resulting product was stirred in a small amount of EA and hexane, and the precipitated solid was filtered to obtain Compound 89-ii, 5-(4'-((3-chlorophenyl)diphenylsilyl)-[1,1'-biphenyl]-3-yl)-2,3-diphenylpyrazine (46.4g, yield 77%).
Mass : [(M+H)⁺] : 677.32
NMR (¹H) : σ= 8.79(1H, s), 8.50(2H, d), 8.03(2H, d), 7.87 (2H, d), 7.77(1H, d), 7.71(1H, d), 7.65-7.55(5H, m), 7.48-7.32(19H, m)

### [Synthesis Example 32-3] Synthesis of Compound 89-i

5-(4'-((3-chlorophenyl)diphenylsilyl)-[1,1'-biphenyl]-3-yl)-2,3-diphenylpyrazine 46.4g, (68.5mmol, 1eq), 4,4,4',4',5,5,5',5'-octamethyl-2,2'-bi(1,3,2-dioxaborolane) 20.9g (82.2mmmol, 1.2eq), PdCl2(dppf) 2.5g (3.4mmol, 0.04eq), Xphos 6.5g (13.7mmol, 0.2eq), and KOAc 16.2g (164.3mmol, 2eq) were added to 700 ml of 1,4-dioxane, and the mixture was stirred under reflux for 8 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 89-i, 5-(4'-(diphenyl(3-(4,4,5,5-tetramethyl-1,3,2-dioxaborolan-2-yl)phenyl)silyl)-[1,1'-biphenyl]-3-yl)-2,3-diphenylpyrazine (39.0g, yield 74%).
Mass : [(M+H)⁺] : 768.84
NMR(¹H) : σ= = 8.79(1H, s), 8.50(2H, d), 8.03(2H, d), 7.87-7.85(3H, m), 7.77(1H, d), 7.71(1H, d), 7.65-7.55(5H, m), 7.48-7.32(18H, m), 1.20(12H, s)

### [Synthesis Example 32-4] Synthesis of Compound 89

5-(4'-(diphenyl(3-(4,4,5,5-tetramethyl-1,3,2-dioxaborolan-2-yl)phenyl)silyl)-[1,1'-biphenyl]-3-yl)-2,3-diphenylpyrazine 39.0g, (50.7mmol, 1eq), 2-chloro-4,6-diphenyl-1,3,5-triazine (e.g., Intermediate A) 14.9g (55.7mmol, 1.1eq), Pd(PPh3)4 1.8g (1.5mmol, 0.03eq), and K₂CO₃ 14.0g (101.3mmol, 2eq) were added to 550 ml of Toluene, 160 ml of EtOH, and 160 ml of H₂O, and the mixture was stirred under reflux for 6 hours. After the completion of the reaction, the mixture was quenched with a sufficient amount of water. The precipitated solid was filtered and washed with a sufficient amount of water and MeOH. Then, the solid was adsorbed onto silica gel, and purified by column chromatography. After concentration, the resulting product was stirred in a small amount of EA and hexane, and the filtered solid was collected to obtain Compound 89 (Target compound B), (36.3g, yield 82%) as a white solid.
Mass : [(M+H)⁺] : 874.14

### [Synthesis Example 33] Synthesis of Compound 90

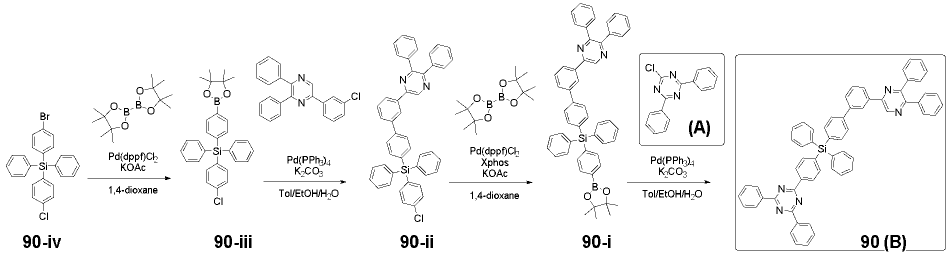

### [Synthesis Example 33-1] Synthesis of Compound 90-iii

(4-bromophenyl) (4-chlorophenyl)diphenylsilane 50g, (111.1mmol, 1eq), 4,4,4',4',5,5,5',5'-octamethyl-2,2'-bi(1,3,2-dioxaborolane) 33.9g (133.4mmol, 1.2eq), PdCl2(dppf) 3.3g (4.4mmol, 0.04eq), and KOAc 21.9g (222.3mmol, 2eq) were added to 750 ml of 1,4-dioxane, and the mixture was stirred under reflux for 4 hours.

After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 90-iii, (4-chlorophenyl)diphenyl(4-(4,4,5,5-tetramethyl-1,3,2-dioxaborolan-2-yl)phenyl)silane (44.7g, yield 81%).
Mass : [(M+H)⁺] : 496.91
NMR(¹H) : σ= 7.85(2H, d), 7.52-7.38(16H, m), 1,20(12H, s)

### [Synthesis Example 33-2] Synthesis of Compound 90-ii

(4-chlorophenyl)diphenyl(4-(4,4,5,5-tetramethyl-1,3,2-dioxaborolan-2-yl)phenyl)silane 44.7g, (90.0mol, 1eq), 5-(3-chlorophenyl)-2,3-diphenylpyrazine 34.0g (99.0mmol, 1.1eq), Pd(PPh3)4 3.1g (2.7mmol, 0.03eq), and K₂CO₃ 24.6g (180.1ml, 2eq) were added to 650 ml of Toluene, 180 ml of EtOH, and 180 ml of H₂O, and the mixture was stirred under reflux for 8 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography. After concentration, the resulting product was stirred in a small amount of EA and hexane, and the precipitated solid was filtered to obtain Compound 90-ii, 5-(4'-((4-chlorophenyl)diphenylsilyl)-[1,1'-biphenyl]-3-yl)-2,3-diphenylpyrazine (45.7g, yield 75%).
Mass : [(M+H)⁺] : 677.32
NMR(¹H) : o= 8.79(1H ,d), 8.50(2H, d), 8.03(2H, d), 7.87-7.85(4H, m), 7.77(1H, d), 7.71(1H, s), 7.65-7.32(22H, m)

### [Synthesis Example 33-3] Synthesis of Compound 90-i

5-(4'-((4-chlorophenyl)diphenylsilyl)-[1,1'-biphenyl]-3-yl)-2,3-diphenylpyrazine 45.7g, (67.5mmol, 1eq), 4,4,4',4',5,5,5',5'-octamethyl-2,2'-bi(1,3,2-dioxaborolane) 20.6g (81.0mmmol, 1.2eq), PdCl2(dppf) 2.5g (3.4mmol, 0.04eq), Xphos 6.4g (13.5mmol, 0.2eq), and KOAc 15.9g (162.1mmol, 2eq) were added to 650 ml of 1,4-dioxane, and the mixture was stirred under reflux for 6 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 90-i, 5-(4'-(diphenyl(4-(4,4,5,5-tetramethyl-1,3,2-dioxaborolan-2-yl)phenyl)silyl)-[1,1'-biphenyl]-3-yl)-2,3-diphenylpyrazine (40.0g, yield 77%).
Mass : [(M+H)⁺] : 768.84
NMR(¹H) : σ= 8.79(1H, s), 8.50(2H, d), 8.03(2H, d), 7.87-7.85(4H, m), 7.77-7.59(6H, m), 7.59-7.32(18H, m), 1.20 (12H, s)

### [Synthesis Example 33-4] Synthesis of Compound 90

5-(4'-(diphenyl(4-(4,4,5,5-tetramethyl-1,3,2-dioxaborolan-2-yl)phenyl)silyl)-[1,1'-biphenyl]-3-yl)-2,3-diphenylpyrazine 40.0g, (52.0mmol, 1eq), 2-chloro-4,6-diphenyl-1,3,5-triazine (e.g., Intermediate A) 15.3g (57.2mmol, 1.1eq), Pd(PPh3)4 1.8g (1.6mmol, 0.03eq), and K₂CO₃ 14.4g (104.0mmol, 2eq) were added to 600 ml of Toluene, 150 ml of EtOH, and 150 ml of H₂O, and the mixture was stirred under reflux for 8 hours. After the completion of the reaction, the mixture was quenched with a sufficient amount of water. The precipitated solid was filtered and washed with a sufficient amount of water and MeOH. Then, the solid was adsorbed onto silica gel, and purified by column chromatography. After concentration, the resulting product was stirred in a small amount of EA and hexane, and the filtered solid was collected to obtain Compound 90 (Target compound B), (36.4g, yield 80%) as a white solid.
Mass : [(M+H)⁺] : 874.14

### [Synthesis Example 34] Synthesis of Compound 118

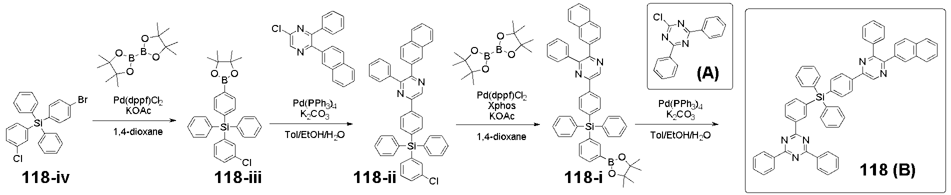

### [Synthesis Example 34-1] Synthesis of Compound 118-iii

(4-bromophenyl) (3-chlorophenyl)diphenylsilane 50g, (111.1mmol, 1eq), 4,4,4',4',5,5,5',5'-octamethyl-2,2'-bi(1,3,2-dioxaborolane) 33.9g (133.4mmol, 1.2eq), PdCl2(dppf) 3.3g (4.4mmol, 0.04eq), and KOAc 21.9g (222.3mmol, 2eq) were added to 750 ml of 1,4-dioxane, and the mixture was stirred under reflux for 4 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 118-iii, ((3-chlorophenyl)diphenyl(4-(4,4,5,5-tetramethyl-1,3,2-dioxaborolan-2-yl)phenyl)silane (44.2g, yield 80%).
Mass : [(M+H)⁺] : 496.91
NMR(¹H) : σ= 7.85(2H, d), 7.55(1H, s), 7.46-7.32(15H, m), 1,20(12H, s)

### [Synthesis Example 34-2] Synthesis of Compound 118-ii

(3-chlorophenyl)diphenyl(4-(4,4,5,5-tetramethyl-1,3,2-dioxaborolan-2-yl)phenyl)silane 44.2g, (88.9mmol, 1eq), 5-chloro-2-(naphthalen-2-yl)-3-phenylpyrazine 31.0g (97.8mmol, 1.1eq), Pd(PPh3)4 3.1g (2.7mmol, 0.03eq), and K₂CO₃ 24.6g (177.8, 2eq) were added to 650 ml of Toluene, 180 ml of EtOH, and 180 ml of H₂O, and the mixture was stirred under reflux for 8 hours.

After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography. After concentration, the resulting product was stirred in a small amount of EA and hexane, and the precipitated solid was filtered to obtain Compound 118-ii, 5-(4-((3-chlorophenyl)diphenylsilyl)phenyl)-2-(naphthalen-2-yl)-3-phenylpyrazine (38.2g, yield 66%).
Mass : [(M+H)⁺] : 651.28
NMR(¹H) : σ= 9.02(1H, d), 8.79(1H, s), 8.54(1H, d), 8.43(2H, d), 8.10-8.00(5H, m), 7.69(2H, d), 7.61-7.32(19H, m)

### [Synthesis Example 34-3] Synthesis of Compound 118-i

5-(4-((3-chlorophenyl)diphenylsilyl)phenyl)-2-(naphthalen-2-yl)-3-phenylpyrazine 38.2g, (58.7mmol, 1eq), 4,4,4',4',5,5,5',5'-octamethyl-2,2'-bi(1,3,2-dioxaborolane) 17.9g (70.4mmmol, 1.2eq), PdCl2(dppf) 2.1g (2.9mmol, 0.04eq), Xphos 5.6g (11.7mmol, 0.2eq), and KOAc 13.9g (140.8mmol, 2eq) were added to 550 ml of 1,4-dioxane, and the mixture was stirred under reflux for 8 hours. After the completion of the reaction, the mixture was quenched with a sufficient amount of water and transferred to a separatory funnel. The organic layer was separated and extracted by adding MC (methylene chloride). The extracted organic layer was concentrated, adsorbed onto silica gel, and purified by column chromatography to obtain Compound 118-i, 5-(4-(diphenyl(3-(4,4,5,5-tetramethyl-1,3,2-dioxaborolan-2-yl)phenyl)silyl)phenyl)-2-(naphthalen-2-yl)-3-phenylpyrazine (33.1g, yield 76%).
Mass : [(M+H)⁺] : 742.80
NMR(¹H) : σ= 9.02(1H, s), 8.79(1H, s), 8.54(1H, d), 8.43(2H, d), 8.10-8.00(5H, m), 7.85(1H, d), 7.69(2H, d), 7.61-7.59(4H, m), 7.46-7.32(14H, m), 1.20(12H, s)

### [Synthesis Example 34-4] Synthesis of Compound 118

5-(4-(diphenyl(3-(4,4,5,5-tetramethyl-1,3,2-dioxaborolan-2-yl)phenyl)silyl)phenyl)-2-(naphthalen-2-yl)-3-phenylpyrazine 33.1g, (44.6mmol, 1eq), 2-chloro-4,6-diphenyl-1,3,5-triazine (e.g., Intermediate A) 13.1g (49.1mmol, 1.1eq), Pd(PPh3)4 1.5g (1.3mmol, 0.03eq), and K₂CO₃ 12.3g (89.2mmol, 2eq) were added to 500 ml of Toluene, 140 ml of EtOH, and 140 ml of H₂O, and the mixture was stirred under reflux for 8 hours. After the completion of the reaction, the mixture was quenched with a sufficient amount of water. The precipitated solid was filtered and washed with a sufficient amount of water and MeOH. Then, the solid was adsorbed onto silica gel, and purified by column chromatography. After concentration, the resulting product was stirred in a small amount of EA and hexane, and the filtered solid was collected to obtain Compound 118 (Target compound B), (29.1g, yield 77%) as a white solid.
Mass : [(M+H)⁺] : 848.10

### [Reference Example]

The structures of the compounds HI, HAT-CN6, EB, BH, BD, Liq, Alq3, E-1, E-2, E-3, E-4, and E-5 used in Examples 1 to 66 and Comparative Examples 1 to 12 are as follows.

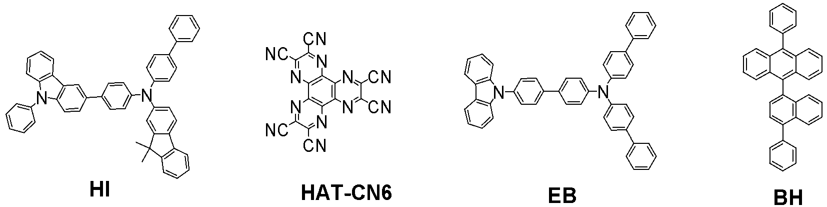

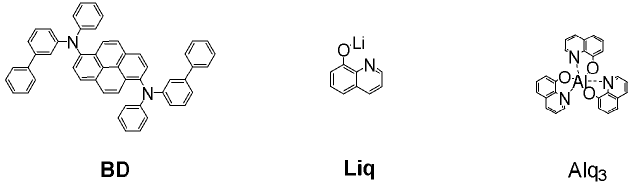

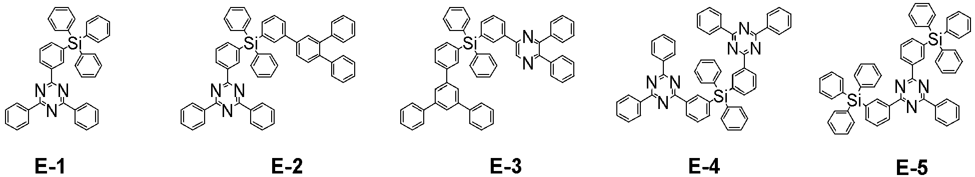

### [Examples 1 to 34] Manufacturing of Blue organic EL devices

The compounds synthesized in the above synthesis examples were subjected to high-purity sublimation purification in a conventionally known method, and then blue organic EL devices were manufactured according to the following procedure.

A glass substrate thin-film-coated with indium tin oxide (ITO) to a thickness of 1,200 Å was washed with distilled water ultrasonically. After washing with distilled water was completed, the glass substrate was ultrasonically washed with a solvent, such as isopropyl alcohol, acetone and methanol, dried, transferred to a UV OZONE cleaner (Power sonic 405, Hwasin Tech), cleaned for 5 minutes using UV, and then transferred to a vacuum evaporator.

On the ITO transparent electrode prepared as above, HI + 2% HAT-CN6 (10 nm)/HI(140 nm)/EB (5 nm)/BH + 2 % BD (20nm)/the electron transport layer material of Table 1 + Liq (1:1) (30 nm) /LiF (1 nm)/Al (100 nm) were stacked in order to manufacture an organic EL device.

### [Comparative Examples 1 to 4] Manufacturing of blue organic EL device

Blue organic EL devices of Comparative Examples 1 to 6 were manufactured in the same manner as in Example 1, except that Compounds Alq₃, E-1, E-2, ET-3, ET-4 and ET-5 were respectively used instead of Compound 1 used as the electron transport layer material in Example 1.

### [Evaluation example 1]

For each of the organic EL devices manufactured in Examples (Ex.) 1 to 34 and Comparative Examples (Comp. Ex.) 1 to 6, a driving voltage, an emission peak, and a current efficiency at a current density of 10 mA/cm² were measured, and the results are shown in Table 5 below.

**[Table 5]**

| Sample | Electron transport layer material | Driving voltage (V) | EL peak (nm) | Current efficiency (cd/A) |
|---|---|---|---|---|
| Ex. 1 | Comp. 1 | 3.4 | 454 | 8.0 |
| Ex. 2 | Comp. 2 | 3.2 | 455 | 8.1 |
| Ex. 3 | Comp. 3 | 3.3 | 455 | 8.3 |
| Ex. 4 | Comp. 5 | 3.4 | 453 | 8.2 |
| Ex. 5 | Comp. 8 | 3.3 | 454 | 8.4 |
| Ex. 6 | Comp. 9 | 3.4 | 454 | 8.5 |
| Ex. 7 | Comp. 11 | 3.2 | 453 | 8.2 |
| Ex. 8 | Comp. 12 | 3.3 | 455 | 8.3 |
| Ex. 9 | Comp. 14 | 3.3 | 454 | 8.2 |
| Ex. 10 | Comp. 17 | 3.5 | 455 | 7.9 |
| Ex. 11 | Comp. 19 | 3.4 | 454 | 8.3 |
| Ex. 12 | Comp. 21 | 3.4 | 455 | 7.9 |
| Ex. 13 | Comp. 22 | 3.3 | 456 | 8.0 |
| Ex. 14 | Comp. 25 | 3.3 | 454 | 8.1 |
| Ex. 15 | Comp. 28 | 3.3 | 453 | 8.2 |
| Ex. 16 | Comp. 31 | 3.4 | 453 | 8.1 |
| Ex. 17 | Comp. 40 | 3.4 | 454 | 8.3 |
| Ex. 18 | Comp. 41 | 3.2 | 455 | 7.8 |
| Ex. 19 | Comp. 45 | 3.2 | 454 | 7.9 |
| Ex. 20 | Comp. 48 | 3.2 | 455 | 8.1 |
| Ex. 21 | Comp. 49 | 3.3 | 456 | 8.1 |
| Ex. 22 | Comp. 51 | 3.1 | 453 | 8.3 |
| Ex. 23 | Comp. 61 | 3.4 | 453 | 8.0 |
| Ex. 24 | Comp. 63 | 3.3 | 454 | 8.3 |
| Ex. 25 | Comp. 65 | 3.4 | 454 | 8.2 |
| Ex. 26 | Comp. 66 | 3.3 | 453 | 8.2 |
| Ex. 27 | Comp. 71 | 3.3 | 456 | 8.4 |
| Ex. 28 | Comp. 77 | 3.5 | 455 | 8.4 |
| Ex. 29 | Comp. 81 | 3.5 | 453 | 8.2 |
| Ex. 30 | Comp. 82 | 3.3 | 453 | 8.4 |
| Ex. 31 | Comp. 85 | 3.4 | 455 | 8.1 |
| Ex. 32 | Comp. 89 | 3.3 | 453 | 8.3 |
| Ex. 33 | Comp. 90 | 3.2 | 454 | 8.3 |
| Ex. 34 | Comp. 118 | 3.3 | 456 | 8.2 |
| Comp. Ex. 1 | Alq₃ | 4.6 | 457 | 5.6 |
| Comp. Ex. 2 | E-1 | 4.3 | 457 | 6.6 |
| Comp. Ex. 3 | E-2 | 4.7 | 460 | 7.0 |
| Comp. Ex. 4 | E-3 | 4.5 | 459 | 6.2 |
| Comp. Ex. 5 | E-4 | 3.5 | 455 | 7.5 |
| Comp. Ex. 6 | E-5 | 4.6 | 455 | 7.7 |

As shown in Table 5, it was appreciated that the blue organic EL devices of Examples 1 to 34 using the compound according to the present invention as an electron transport layer material exhibit significantly superior performance in terms of driving voltage, emission peak and current efficiency compared to the blue organic EL device of Comparative Examples 1 to 6 using conventional Alq₃, and compounds E-1 to E-4 (which do not include the essential constitution of the present invention) as an electron transport layer material.

### [Examples 35 to 68] Manufacturing of Blue organic EL devices

The compounds synthesized in the above synthesis examples were subjected to high-purity sublimation purification in a conventionally known method, and then blue organic EL devices were manufactured by using these compounds as electron transport auxiliary layer materials according to the following procedure.

A glass substrate thin-film-coated with indium tin oxide (ITO) to a thickness of 1,200 Å was washed with distilled water ultrasonically. After washing with distilled water was completed, the glass substrate was ultrasonically washed with a solvent, such as isopropyl alcohol, acetone and methanol, dried, transferred to a UV OZONE cleaner (Power sonic 405, Hwasin Tech), cleaned for 5 minutes using UV, and then transferred to a vacuum evaporator.

On the ITO transparent electrode prepared as above, HI + 2% HAT-CN6 (10 nm)/HI(140 nm)/EB (5 nm)/BH + 2% BD (20nm)/the electron transport auxiliary layer material of Table 1 (5 nm)/ET + Liq (1:1) (30 nm)/LiF (1 nm)/Al (100 nm) were stacked in order to manufacture an organic EL device.

### [Comparative Examples 7 to 12] Manufacturing of blue organic EL device

Blue organic EL devices of Comparative Examples 7 to 12 were manufactured in the same manner as in Example 35, except that no electron transport auxiliary layer was included, or compounds E-1 to E-5 were respectively used instead of Compound 1 used as the electron transport auxiliary layer material in Example 35.

### [Evaluation example 2]

For each of the organic EL devices manufactured in Examples (Ex.) 35 to 68 and Comparative Examples (Comp. Ex.) 7 to 12, a driving voltage, an emission peak, and a current efficiency at a current density of 10 mA/cm² were measured, and the results are shown in Table 6 below.

**[Table 6]**

| Sample | Electron transport layer | Driving voltage (V) | EL peak (nm) | Current efficiency (cd/A) |
|---|---|---|---|---|
| Ex. 35 | Comp. 1 | 3.4 | 453 | 8.2 |
| Ex. 36 | Comp. 2 | 3.2 | 452 | 8.3 |
| Ex. 37 | Comp. 3 | 3.3 | 453 | 8.5 |
| Ex. 38 | Comp. 5 | 3.3 | 451 | 8.3 |
| Ex. 39 | Comp. 8 | 3.2 | 453 | 8.5 |
| Ex. 40 | Comp. 9 | 3.3 | 453 | 8.6 |
| Ex. 41 | Comp. 11 | 3.2 | 452 | 8.3 |
| Ex. 42 | Comp. 12 | 3.4 | 454 | 8.3 |
| Ex. 43 | Comp. 14 | 3.3 | 453 | 8.3 |
| Ex. 44 | Comp. 17 | 3.4 | 454 | 8.1 |
| Ex. 45 | Comp. 19 | 3.3 | 453 | 8.4 |
| Ex. 46 | Comp. 21 | 3.3 | 452 | 7.9 |
| Ex. 47 | Comp. 22 | 3.2 | 454 | 8.1 |
| Ex. 48 | Comp. 25 | 3.3 | 453 | 8.2 |
| Ex. 49 | Comp. 28 | 3.2 | 453 | 8.3 |
| Ex. 50 | Comp. 31 | 3.3 | 454 | 8.3 |
| Ex. 51 | Comp. 40 | 3.4 | 453 | 8.4 |
| Ex. 52 | Comp. 41 | 3.3 | 453 | 7.9 |
| Ex. 53 | Comp. 45 | 3.1 | 455 | 8.0 |
| Ex. 54 | Comp. 48 | 3.1 | 453 | 8.2 |
| Ex. 55 | Comp. 49 | 3.2 | 455 | 8.1 |
| Ex. 56 | Comp. 51 | 3.1 | 451 | 8.4 |
| Ex. 57 | Comp. 61 | 3.3 | 453 | 8.1 |
| Ex. 58 | Comp. 63 | 3.2 | 453 | 8.3 |
| Ex. 59 | Comp. 65 | 3.3 | 455 | 8.3 |
| Ex. 60 | Comp. 66 | 3.4 | 452 | 8.4 |
| Ex. 61 | Comp. 71 | 3.4 | 454 | 8.5 |
| Ex. 62 | Comp. 77 | 3.3 | 452 | 8.5 |
| Ex. 63 | Comp. 81 | 3.4 | 452 | 8.4 |
| Ex. 64 | Comp. 82 | 3.2 | 454 | 8.5 |
| Ex. 65 | Comp. 85 | 3.3 | 451 | 8.2 |
| Ex. 66 | Comp. 89 | 3.3 | 453 | 8.4 |
| Ex. 67 | Comp. 90 | 3.4 | 452 | 8.4 |
| Ex. 68 | Comp. 118 | 3.4 | 453 | 8.3 |
| Comp. Ex. 7 | - | 4.9 | 457 | 5.3 |
| Comp. Ex. 8 | E-1 | 4.3 | 456 | 6.7 |
| Comp. Ex. 9 | E-2 | 4.8 | 458 | 7.2 |
| Comp. Ex. 10 | E-3 | 4.6 | 457 | 6.3 |
| Comp. Ex. 11 | E-4 | 3.5 | 454 | 7.4 |
| Comp. Ex. 12 | E-5 | 4.9 | 454 | 7.9 |

As shown in Table 6, it was appreciated that the blue organic EL devices of Examples 35 to 68 using the compound according to the present invention as an electron transport auxiliary layer material exhibit significantly excellent performance in terms of driving voltage, emission peak and current efficiency compared to the blue organic EL device of Comparative Examples 7 to 12, which did not include no electron transport auxiliary layer material or used compounds E-1 to E-4 (which do not include the essential constitution of the present invention) as an electron transport auxiliary material.

Referring to the results of Tables 5 and 6 described above, it was found that the driving voltage of the device was improved when the silane-based compound according to the present invention was used as an electron transport layer material, and the efficiency of the device was significantly increased when the compound was used as an electron transport auxiliary layer material.

More specifically, it was confirmed that the compounds according to the present invention, in which triazine and pyrazine are substituted as dual electron withdrawing group (EWG) units, exhibited superior characteristics compared to Compounds ET-1 to ET-5 used as comparative examples.

As an example, it was confirmed that the devices of the Examples comprising the compound having dual EWG groups on both sides of a silyl group according to the present invention exhibited superior driving voltage characteristics compared to the devices of Comparative Examples 2-4 and 8-10, which use Compounds E-1 to E-3 as materials for the electron transport layer or electron transport auxiliary layer. This is presumed to be because, in the conventional materials E-1 to E-3, one side of the silyl group composed of an sp³ orbital is substituted with an electron-withdrawing group (EWG), while the other side is substituted with an arylene group that increases the molecular size but does not enhance electron mobility, and therefore these materials fail to exhibit sufficient electron mobility.

Meanwhile, in Comparative Examples 5 and 11, in which a compound E-4 having two triazine groups as dual electron-withdrawing groups on both sides of a silyl group is used as an electron transport layer and/or an electron transport auxiliary layer material, driving voltage characteristics similar to those of the devices according to the examples of the present invention were observed, whereas inferior efficiency characteristics were exhibited. This is believed to be attributable to the fact that the compound of the present invention, in which different dual electron-withdrawing groups, for example, triazine and pyrazine, are introduced on opposite sides of a silyl group, exhibits a high triplet (T₁) energy level resulting from structural asymmetry, and a low-voltage characteristic imparted by the pyrazine group, which are combined to reduce the driving voltage of the device, while further enhancing the electron-withdrawing characteristics of the azine groups, thereby significantly improving the efficiency characteristics of the device. In particular, since the compound according to the present invention has an asymmetric molecular structure, no crystallization temperature (Tc) is observed in thermal characteristics, and thus the compound is more advantageous in terms of processability.

Additionally, as a result of comparing Comparative Examples 2 and 6 and Comparative Examples 8 and 12, in which compounds E-1 and E-5 were used as electron transport layer and/or electron transport auxiliary layer materials, respectively, it was confirmed that when the number of silyl groups in a molecule increases, the efficiency characteristics of the device can be improved; however, the increased molecular bulk hinders electron flow, resulting in an unfavorable driving voltage.

Furthermore, as a result of comparing Comparative Examples 8 to 10 and 12, in which compounds E-1 to E-3 and E-5 were used as electron transport auxiliary layer materials, the properties of the silyl group were found to contribute to improving the efficiency characteristics of the device when used as an electron transport auxiliary layer; however, they were disadvantageous in terms of driving voltage. Moreover in Comparative Example 11, in which Compound E-4 was used as the electron transport auxiliary layer material, the symmetric structure resulting from the presence of two triazine groups is believed to lead to a low triplet energy level and unstable thermal characteristics, thereby lowering the overall efficiency of the device despite an improvement in driving voltage.

## Claims

1. A compound represented by Chemical Formula 1 below: 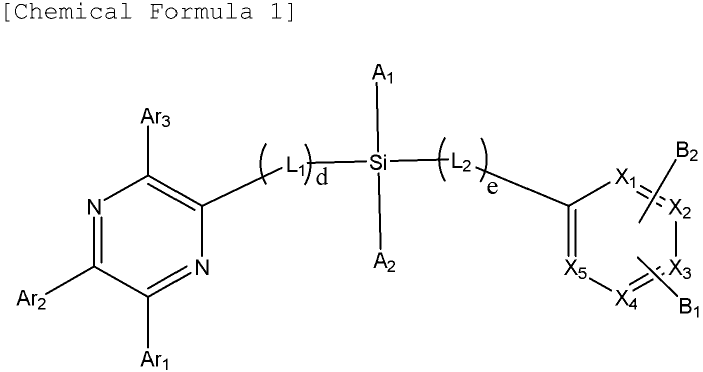 wherein in Chemical Formula 1,
Ar₁ to Ar₃ are the same as or different from each other and are each independently selected from the group consisting of a hydrogen, a deuterium (D), a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 ring atoms, a C₆-C₆₀ aryl group, a heteroaryl group having 5 to 60 ring atoms, a C₁-C₄₀ alkyloxy group, a C₆-C₆₀ aryloxy group, a C₃-C₄₀ alkylsilyl group, a C₆-C₆₀ arylsilyl group, a C₁-C₄₀ alkylboron group, a C₆-C₆₀ arylboron group, a C₆-C₆₀ arylphosphine group, a C₆-C₆₀ arylphosphine oxide group, and a C₆-C₆₀ arylamine group, provided that cases where at least two of Ar₁ to Ar₃ are hydrogen are excluded,
X₁ to X₅ are the same as or different from each other and are each independently C(R₁) or N, provided that at least two of X₁ to X₅ are N;
When there are a plurality of R₁, the plurality of R₁ are the same as or different from one another and are each independently selected from the group consisting of a hydrogen, a deuterium (D), a halogen, a cyano group, a nitro group, a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 ring atoms, a C₆-C₆₀ aryl group, a heteroaryl group having 5 to 60 ring atoms, a C₁-C₄₀ alkyloxy group, a C₆-C₆₀ aryloxy group, a C₃-C₄₀ alkylsilyl group, a C₆-C₆₀ arylsilyl group, a C₁-C₄₀ alkylboron group, a C₆-C₆₀ arylboron group, a C₆-C₆₀ aryl phosphine group, a C₆-C₆₀ arylphosphine oxide group, and a C₆-C₆₀ arylamine group, wherein two of the plurality of R₁ are represented by B₁ and B₂ respectively,
A₁ to A₂ and B₁ to B₂ are the same as or different from one another and are each independently selected from the group consisting of a hydrogen, a deuterium (D), a C₁-C₄₀ alkyl group, a C₂-C₄₀ alkenyl group, a C₂-C₄₀ alkynyl group, a C₃-C₄₀ cycloalkyl group, a heterocycloalkyl group having 3 to 40 ring atoms, a C₆-C₆₀ aryl group, a heteroaryl group having 5 to 60 ring atoms, a C₁-C₄₀ alkyloxy group, a C₆-C₆₀ aryloxy group, a C₃-C₄₀ alkylsilyl group, a C₆-C₆₀ arylsilyl group, a C₁-C₄₀ alkylboron group, a C₆-C₆₀ arylboron group, a C₆-C₆₀ aryl phosphine group, a C₆-C₆₀ arylphosphine oxide group, and a C₆-C₆₀ arylamine group,
L₁ and L₂ are the same as or different from one another and are each independently a single bond, or selected from the group consisting of a C₆ to C₁₈ arylene group and a heteroarylene group having 5 to 18 nuclear atoms,
d and e are each independently an integer of 0 to 4, and
the arylene group, the heteroarylene group of L₁ and L₂; and the alkyl group, alkenyl group, alkynyl group, aryl group, heteroaryl group, aryloxy group, alkyloxy group, cycloalkyl group, heterocycloalkyl group, alkylsilyl group, arylsilyl group, alkylboron group, arylboron group, arylphosphine group, arylphosphine oxide group, and arylamine group of Ar₁ to Ar₃, R₁, A₁ to A₂, and B₁ to B₂ may be each independently substituted with at least one substituent selected from the group consisting of a deuterium (D), a halogen, a cyano group, a nitro group, a C₁ to C₄₀ alkyl group, a C₂ to C₄₀ alkenyl group, a C₂ to C₄₀ alkynyl group, a C₃ to C₄₀ cycloalkyl group, a heterocycloalkyl group having 3 to 40 ring atoms, a C₆ to C₆₀ aryl group, a heteroaryl group having 5 to 60 ring atoms, a C₁ to C₄₀ alkyloxy group, a C₆ to C₆₀ aryloxy group, a C₁ to C₄₀ alkylsilyl group, a C₆ to C₆₀ arylsilyl group, a C₁ to C₄₀ alkylboron group, a C₆ to C₆₀ arylboron group, a C₆ to C₆₀ arylphosphine group, a C₆ to C₆₀ arylphosphine oxide group, and a C₆ to C₆₀ arylamine group, and wherein when the substituent is present in a plural number, they may be the same or different from each other.

2. The compound of Claim 1, wherein the ring containing X₁ to X₅ is any one selected from the following structural formulae: 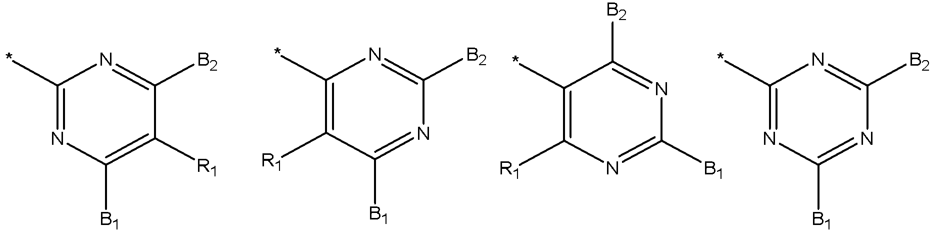 wherein the formulas,
* indicates a site where a bond with Chemical Formula 1 is made,
R₁, B₁ and B₂ are each as defined in claim 1.

3. The compound of Claim 1,
wherein A₁ to A₂ and B₁ to B₂ are the same as or different from each other, and each independently selected from the group consisting of a C₆ to C₆₀ aryl group, and a heteroaryl group having 5 to 60 ring atoms.

4. The compound of Claim 1,
wherein A₁ to A₂ and B₁ to B₂ are the same as or different from each other, and are each independently selected from the following structural formulae: 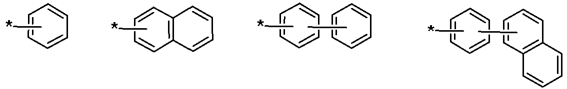 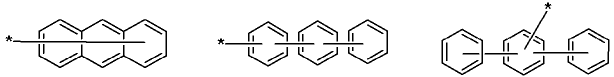 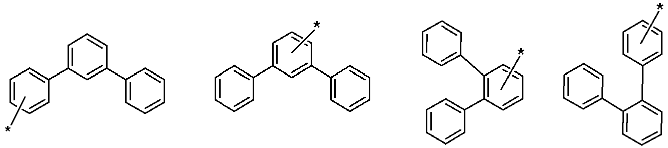 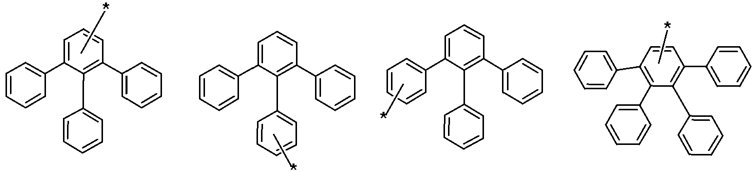 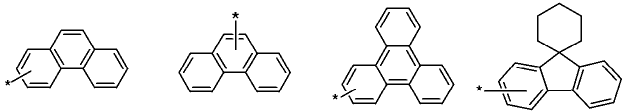 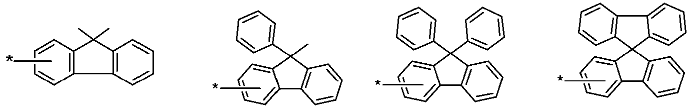 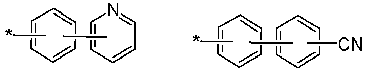 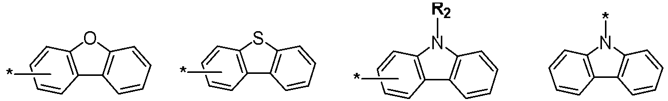 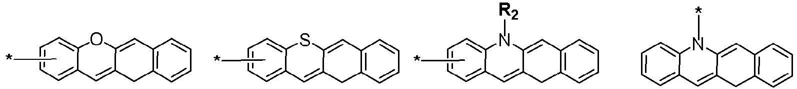 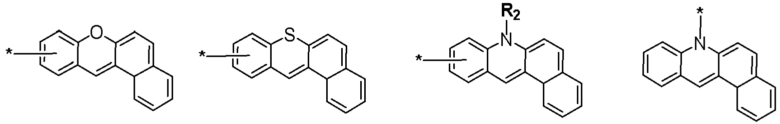 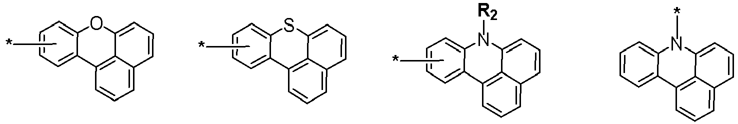 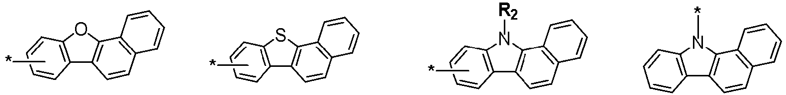 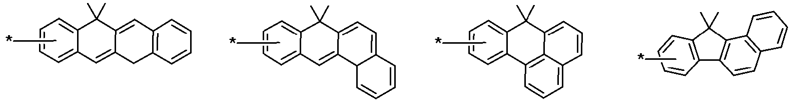
wherein the formulas,
* indicates a site where a bond with Chemical Formula 1 is made, and
R₂ is selected from the group consisting of a hydrogen, a deuterium (D), a C₁-C₄₀ alkyl group, a C₆-C₆₀ aryl group, and a heteroaryl group having 5 to 60 ring atoms.

5. The compound of Claim 1, Ar₁ to Ar₃ are the same as or different from each other, and each independently selected from the group consisting of a hydrogen, a deuterium (D), a C₁-C₄₀ alkyl group, a C₆ to C₆₀ aryl group, and a heteroaryl group having 5 to 60 ring atoms, provided that cases where at least two of Ar₁ to Ar₃ are hydrogen are excluded.

6. The compound of Claim 1, Ar₁ to Ar₃ are the same as or different from each other, and are each independently selected from the following structural formulae: 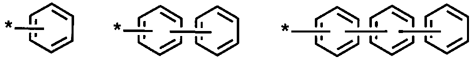 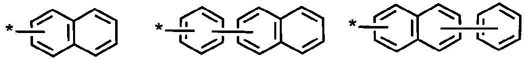 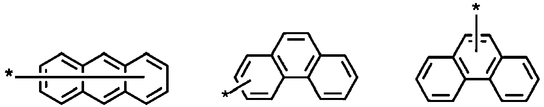 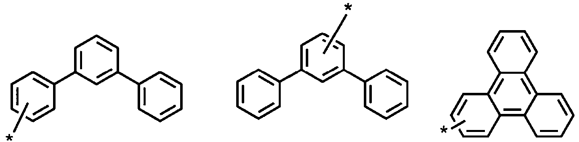 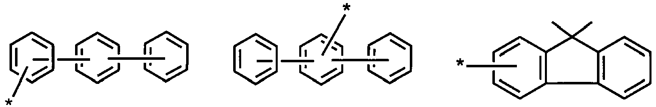 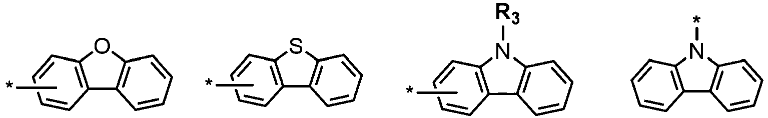 wherein the formulas,
* indicates a site where a bond with Chemical Formula 1 is made, and
R₃ is selected from the group consisting of a hydrogen, a deuterium (D), a C₁-C₄₀ alkyl group, a C₆-C₆₀ aryl group, and a heteroaryl group having 5 to 60 ring atoms.

7. The compound of Claim 1, L₁ and L₂ are the same as or different from each other, and are each independently selected from the following structural formulae: 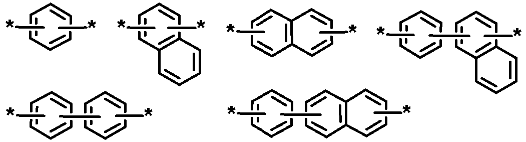 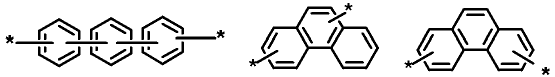 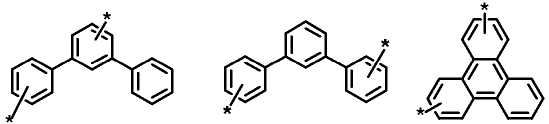 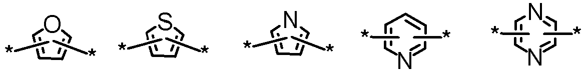 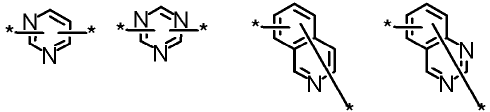 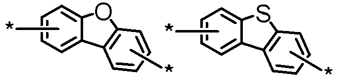 wherein the formulas,
* indicates a site where a bond with Chemical Formula 1 is made.

8. The compound of Claim 1, wherein the compound represented by Chemical Formula 1 is a compound represented by Chemical Formula 2 below: 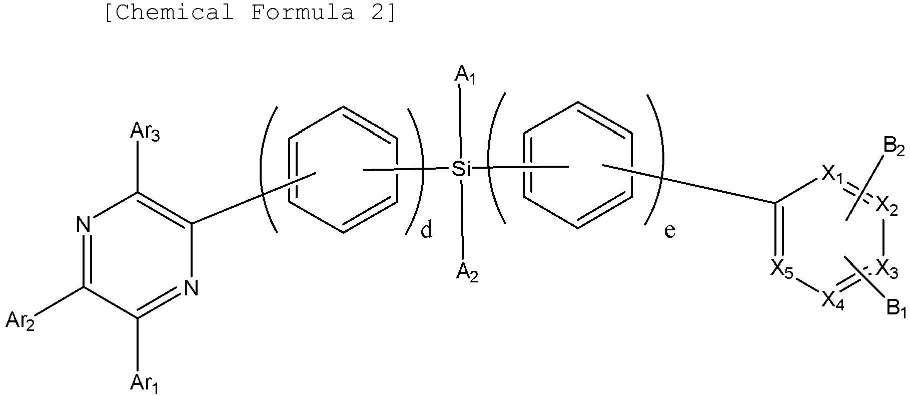 wherein the formula,
X₁ to X₅, Ar₁ to Ar₃, A₁ to A₂, B₁ to B₂, d and e are each as defined in claim 1.

9. The compound of Claim 1,
wherein 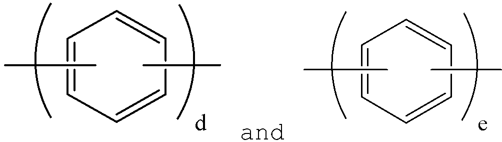 in Chemical formula 2 are are the same as or different from each other, and are each independently selected from the following structural formulae: 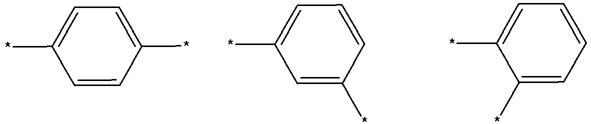 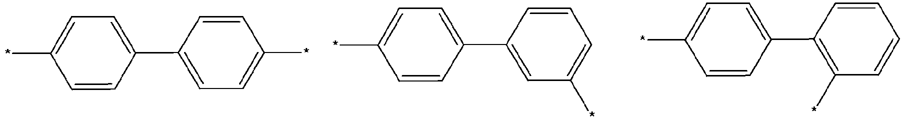 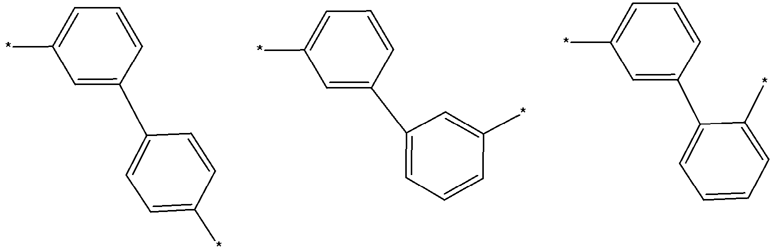 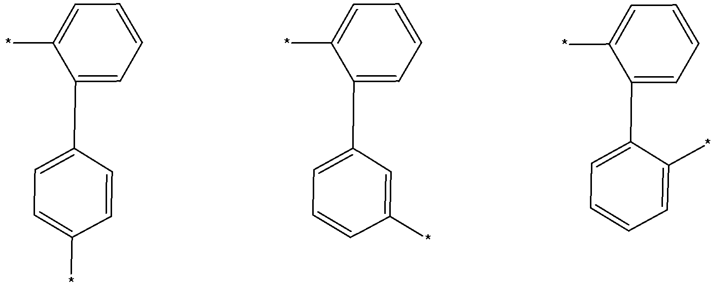
wherein the formulas,
* indicates a site where a bond with Chemical Formula 2 is made.

10. The compound of Claim 1, wherein the compound represented by Chemical Formula 1 is a compound represented by any one of Chemical Formulas 3 to Chemical Formula 5 below: 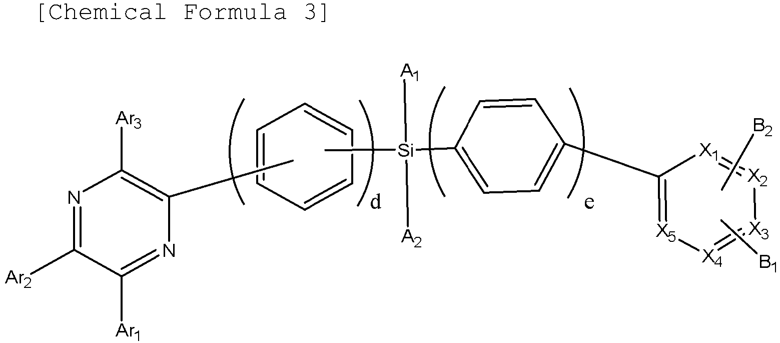 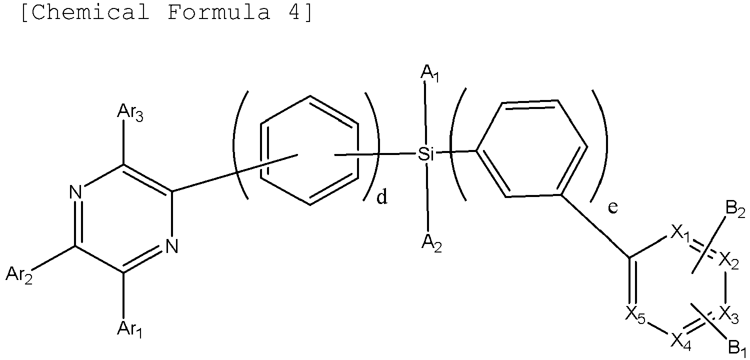 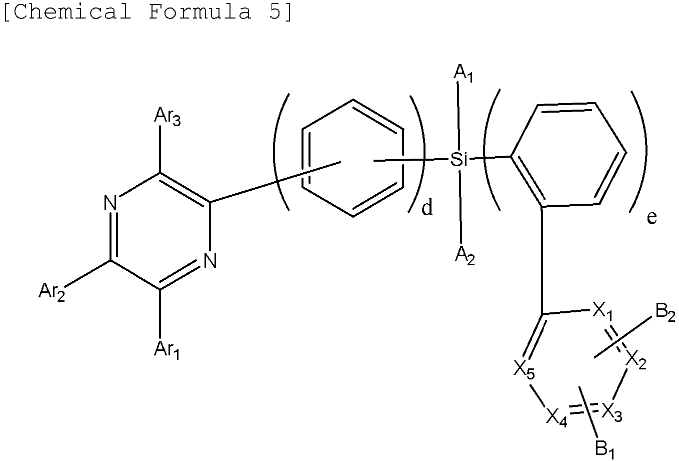 wherein the formulas,
X₁ to X₅, Ar₁ to Ar₃, A₁ to A₂, B₁ to B₂, d and e are each as defined in claim 1.

11. The compound of Claim 1, wherein the compound represented by Chemical Formula 1 is a compound represented by any one of Chemical Formulas 6a to Chemical Formula 6l below: 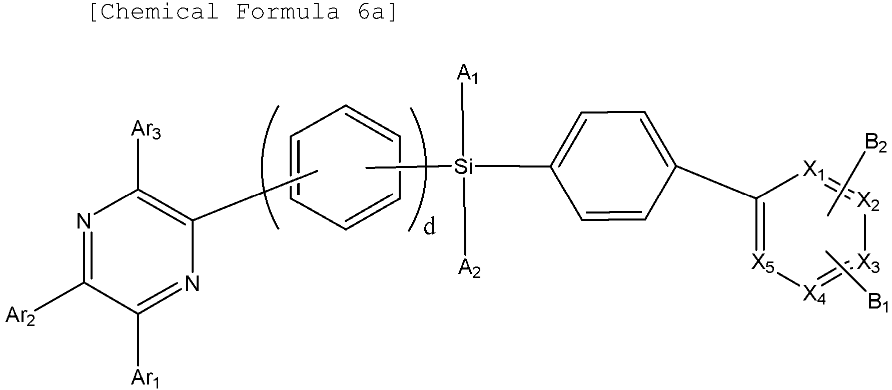 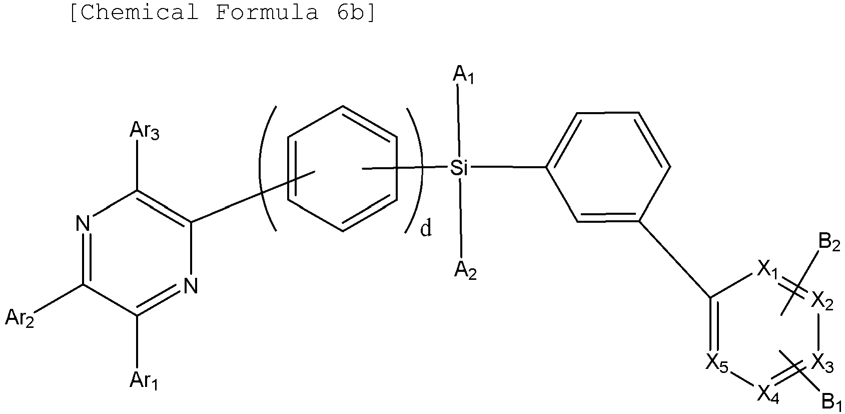 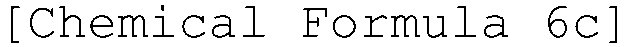 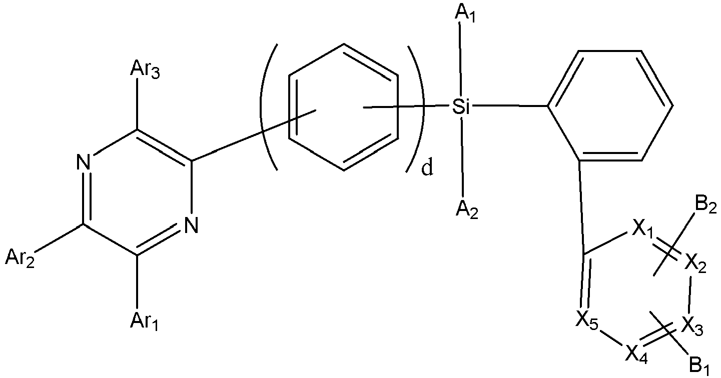 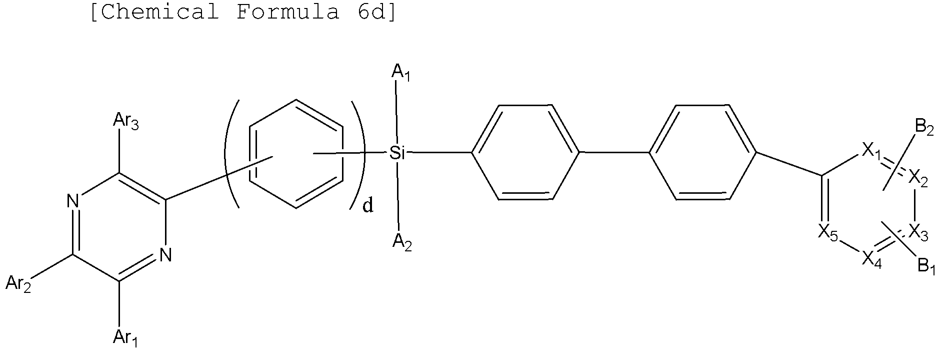 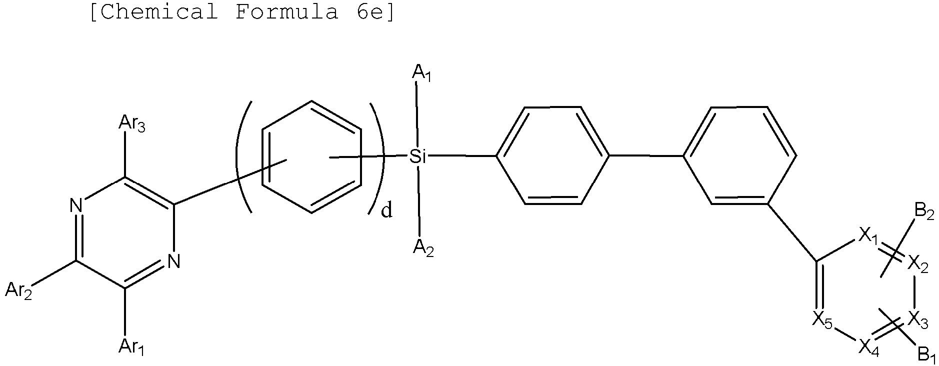 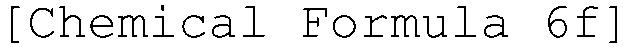 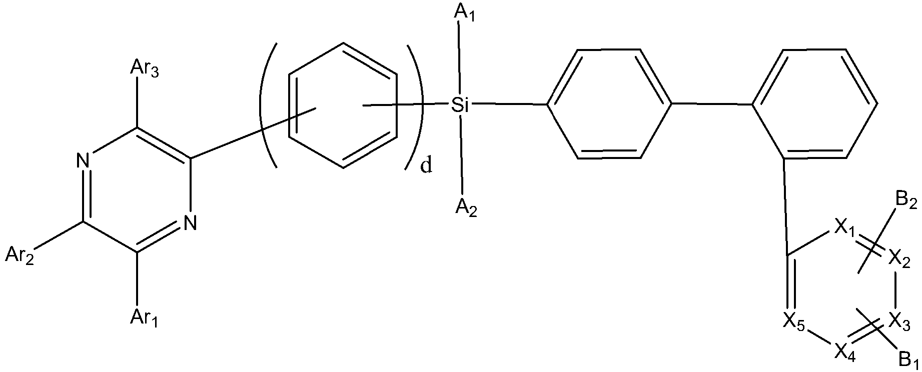 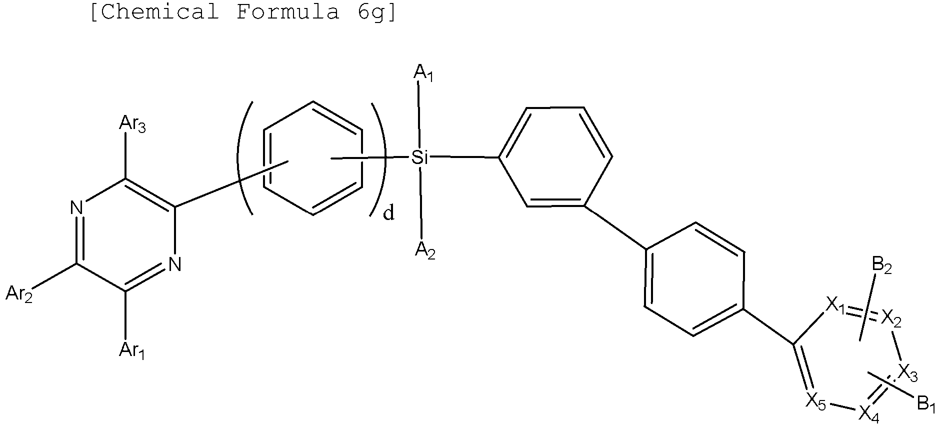 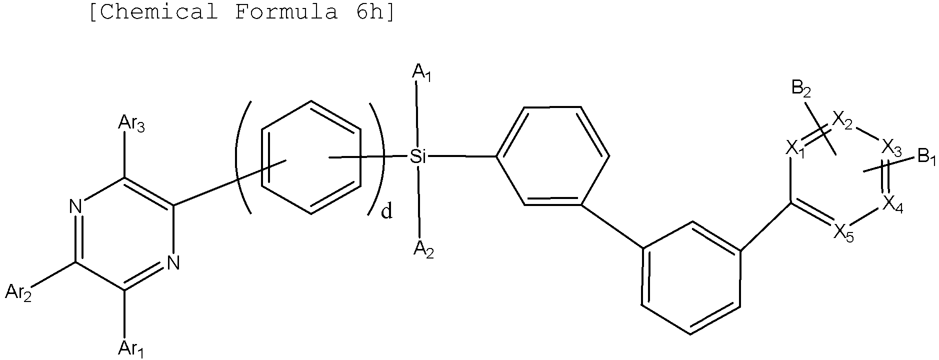 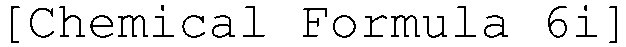 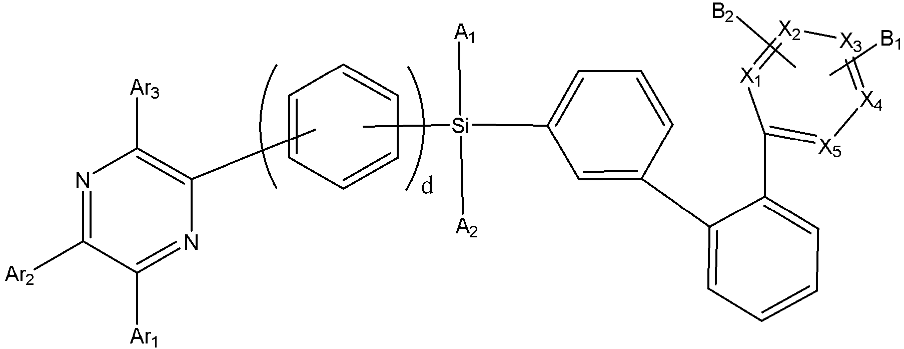 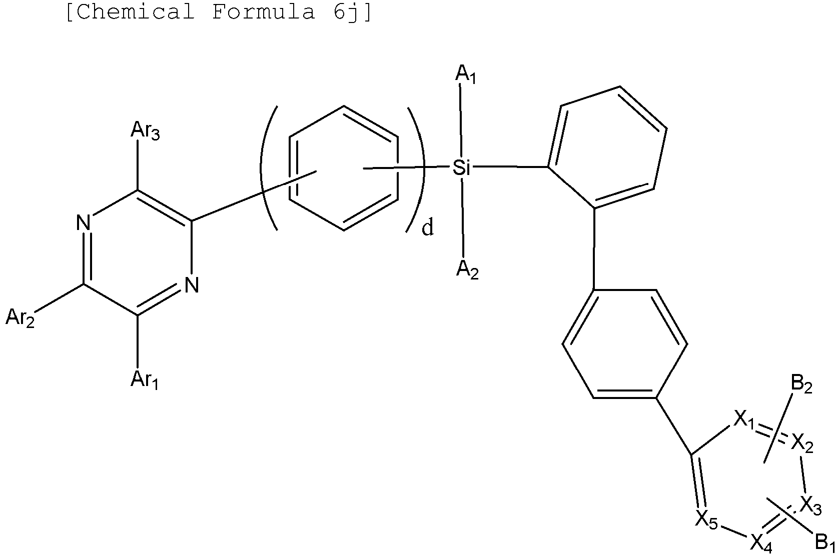 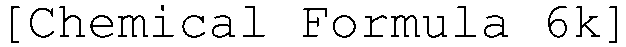 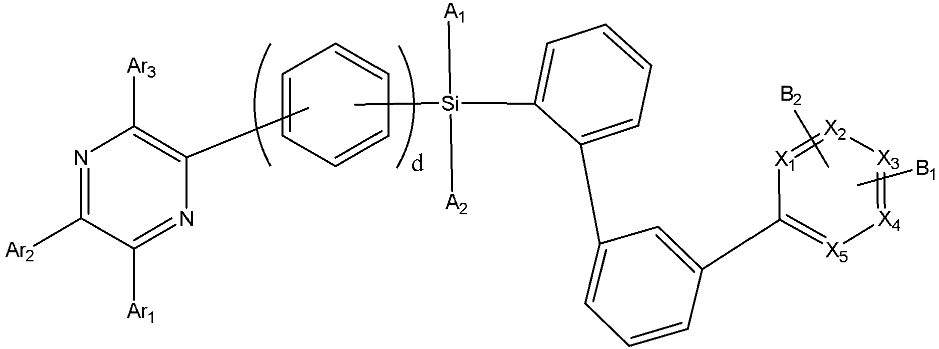 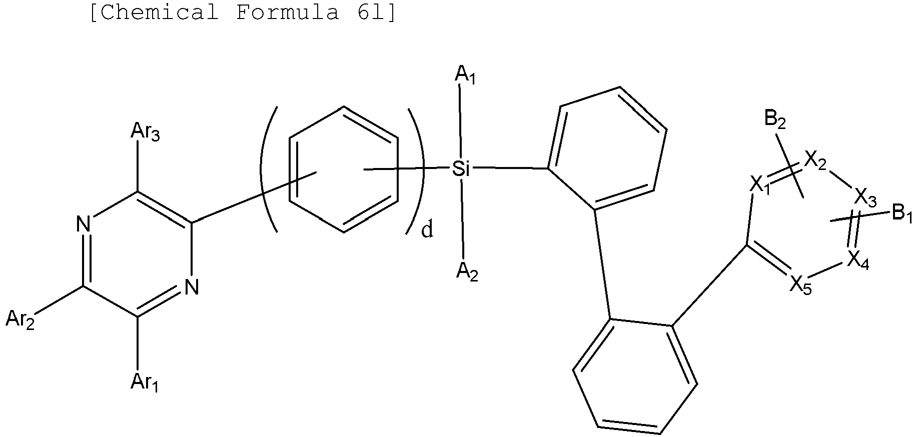 wherein the formulas,
Ar₁ to Ar₃, A₁ to A₂, B₁ to B₂, R₁ and d are each as defined in claim 1.

12. The compound of Claim 1,
wherein the compound represented by Chemical Formula 1 is a compound represented by any one of Chemical Formulas 7 to Chemical Formula 9 below: 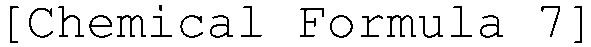 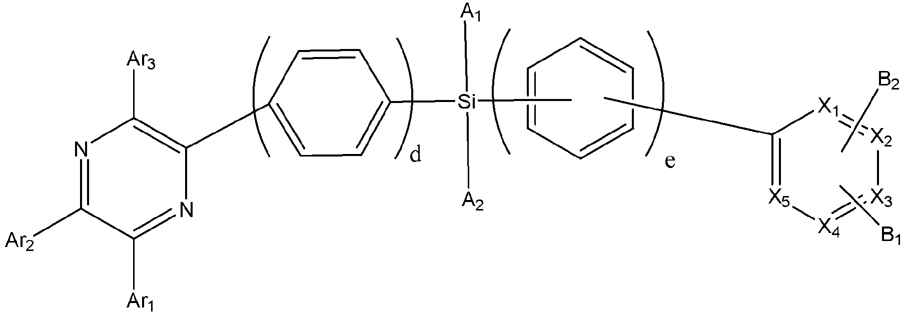 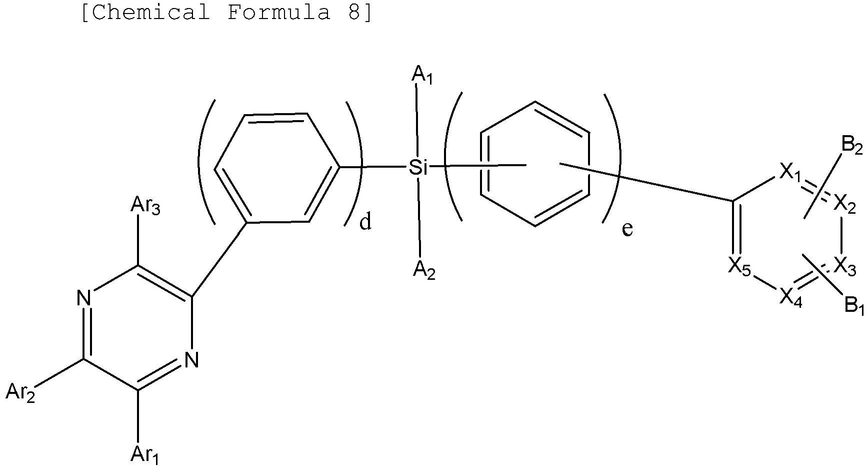 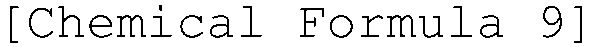 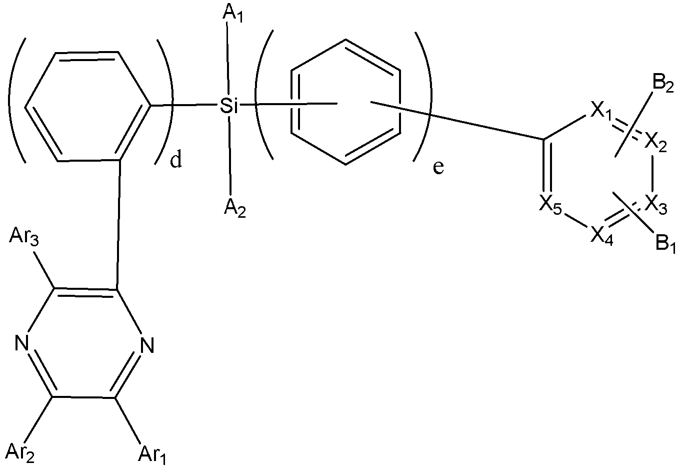
wherein the formulas,
X₁ to X₅, Ar₁ to Ar₃, A₁ to A₂, B₁ to B₂, d and e are each as defined in claim 1.

13. The compound of Claim 1, wherein the compound represented by Chemical Formula 1 is a compound represented by any one of Chemical Formulas 10a to Chemical Formula 10l below: 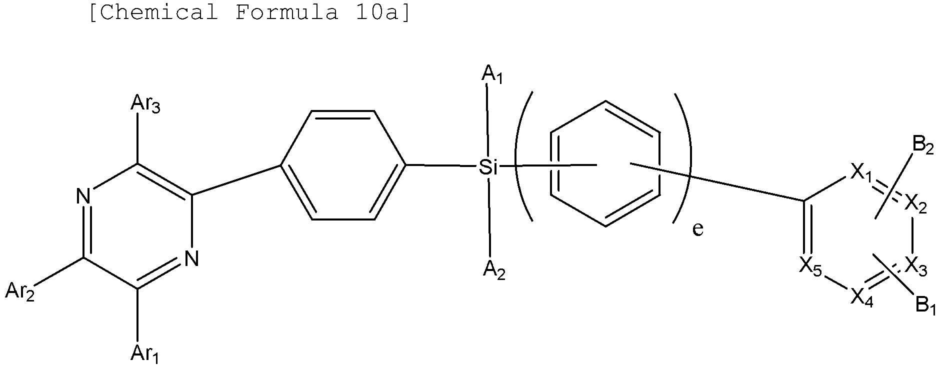 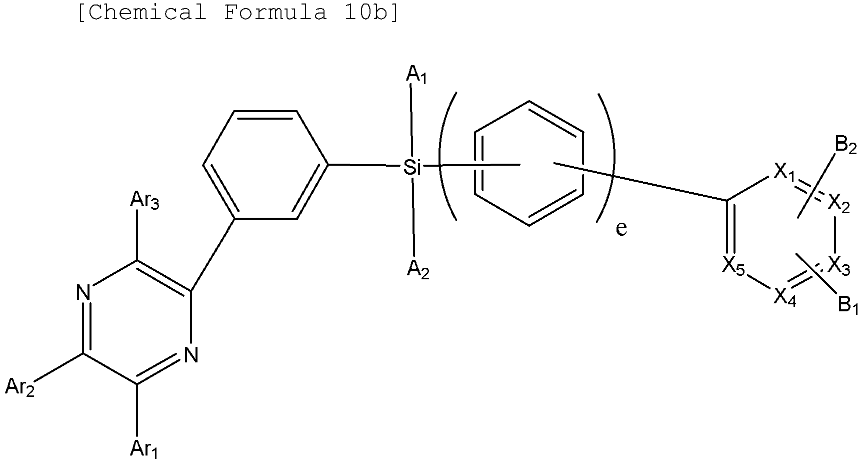 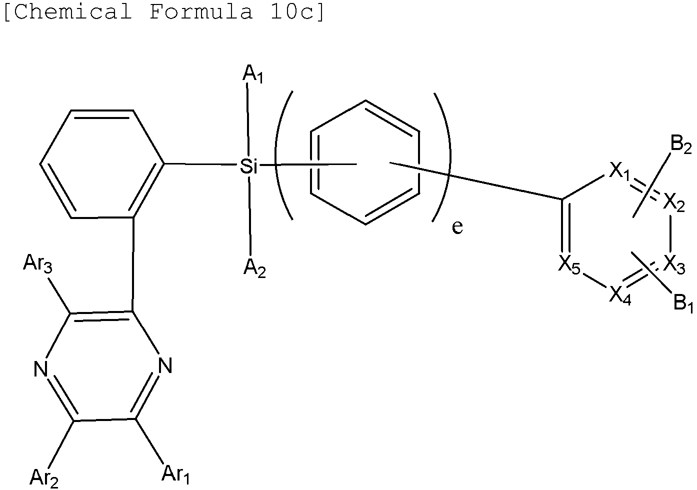 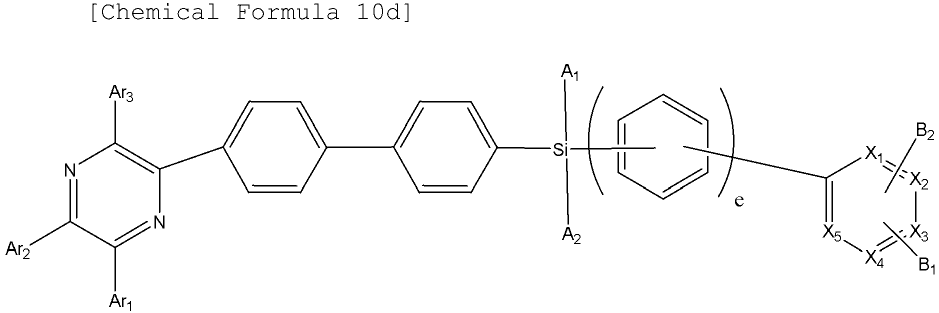 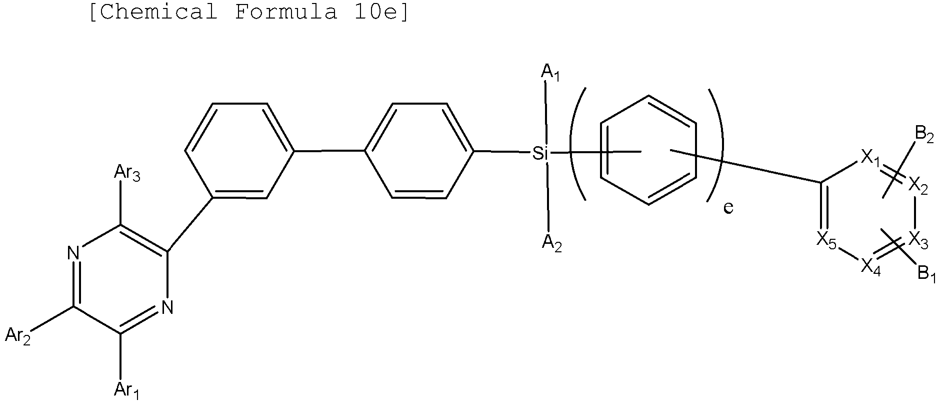 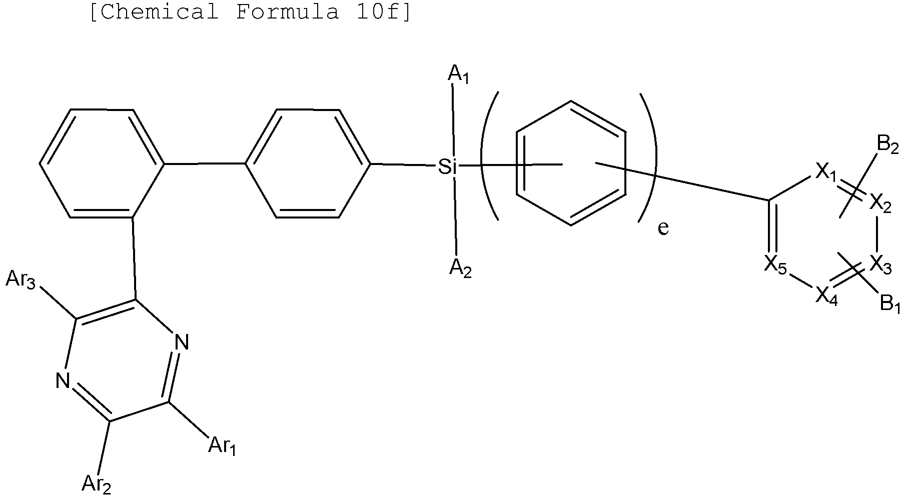 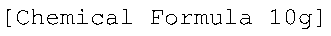 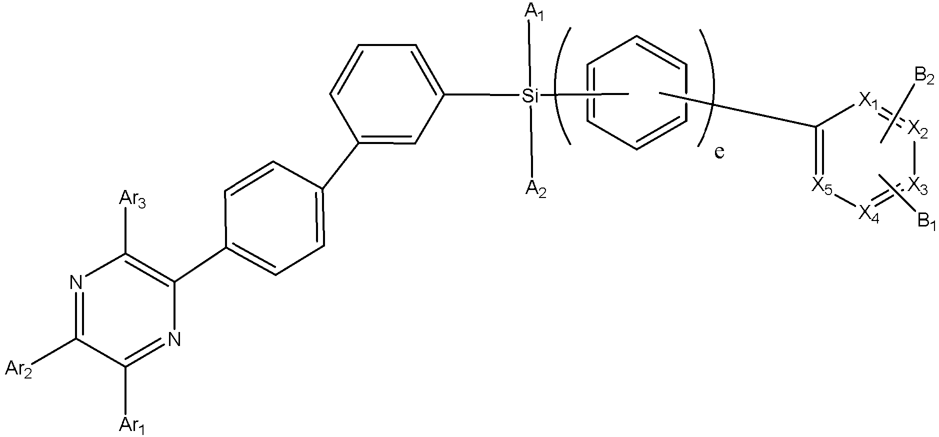 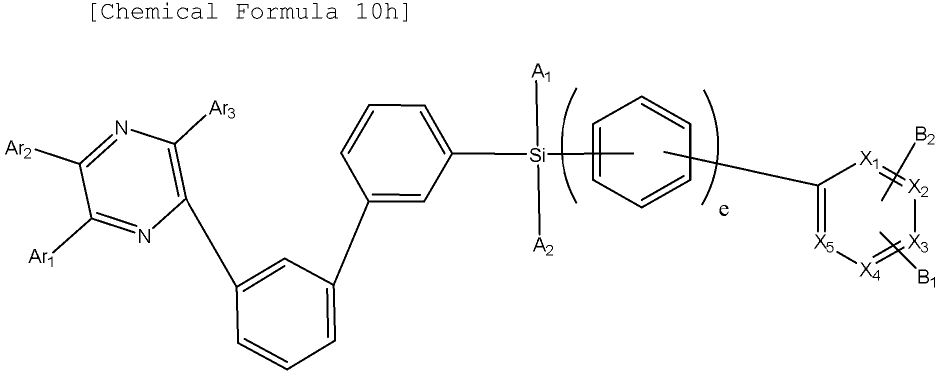 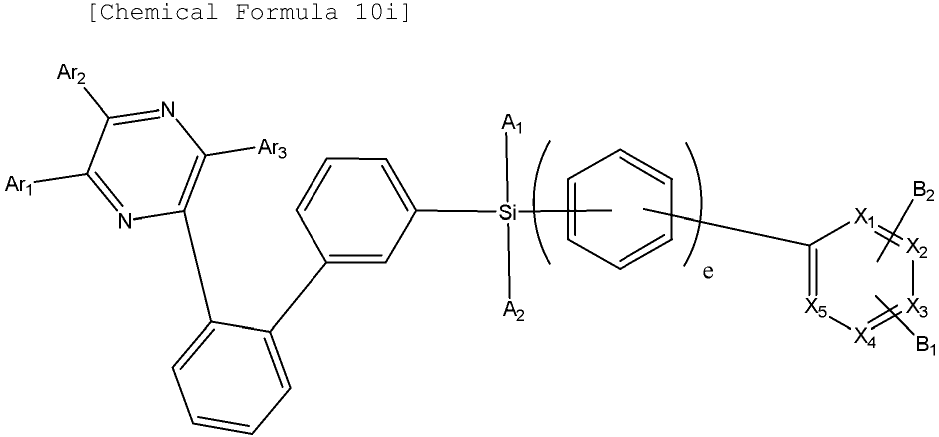 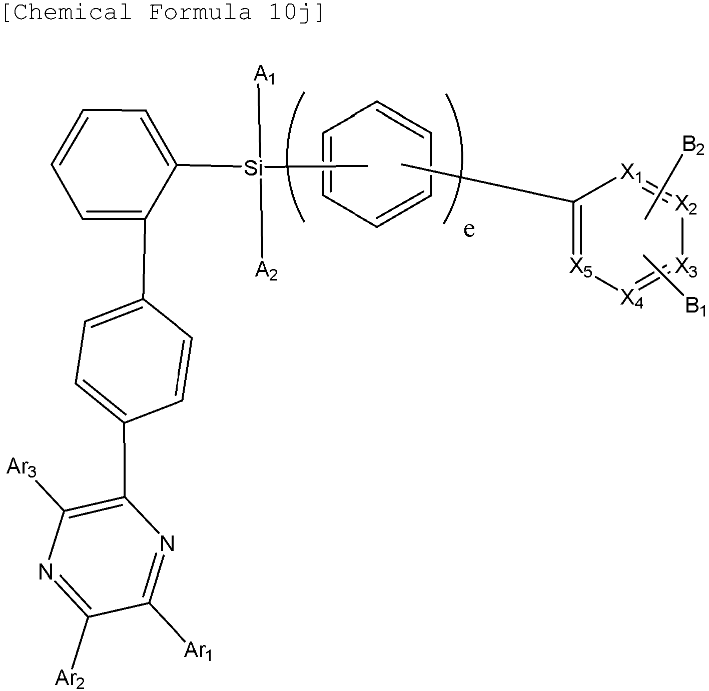 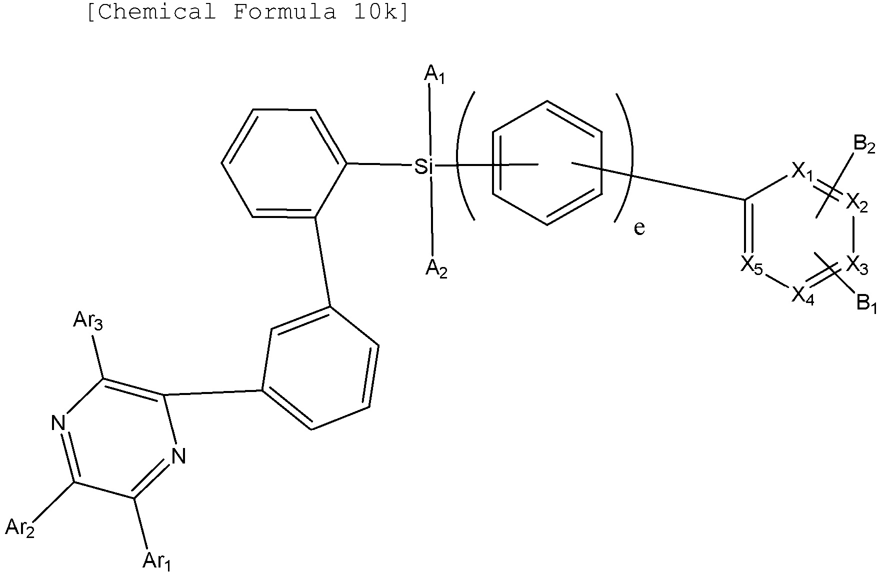 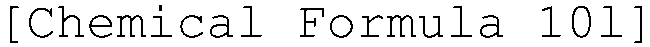 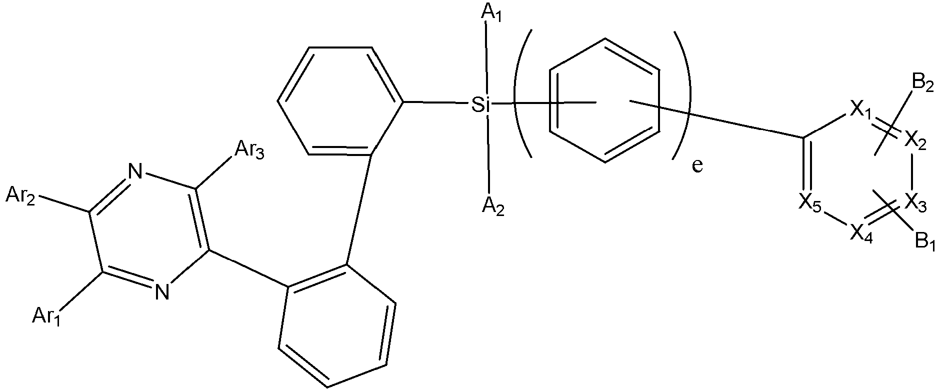 wherein the formulas,
X₁ to X₅, Ar₁ to Ar₃, A₁ to A₂, B₁ to B₂, and e are each as defined in claim 1.

14. The compound of Claim 1, wherein the compound represented by Chemical Formula 1 is a compound represented by any one of Chemical Formulas 11 to Chemical Formula 14 below: 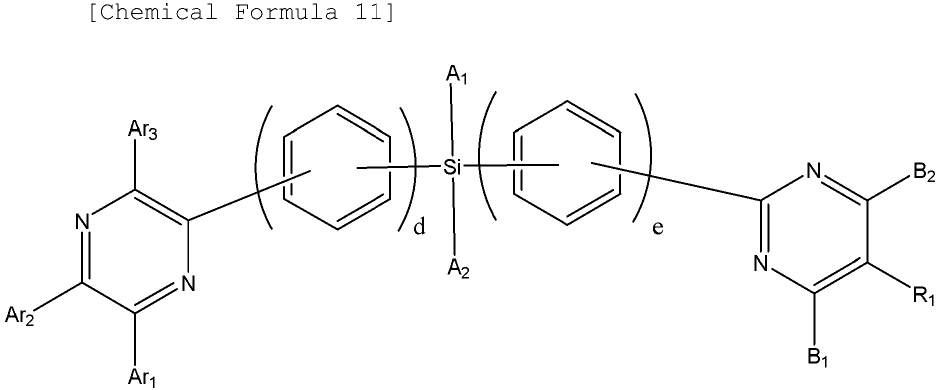 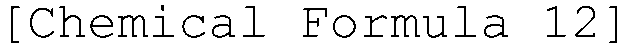 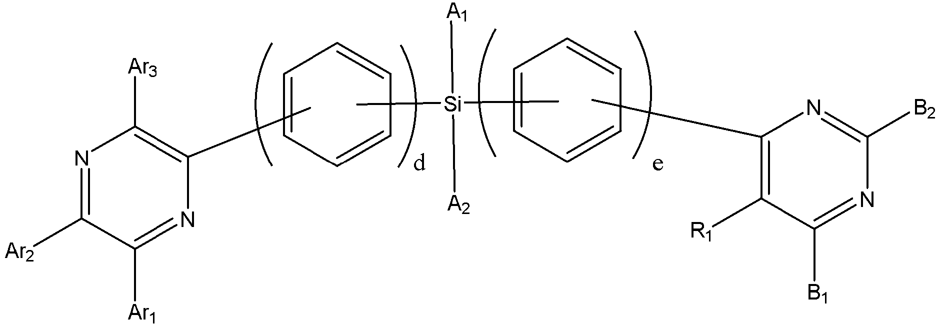 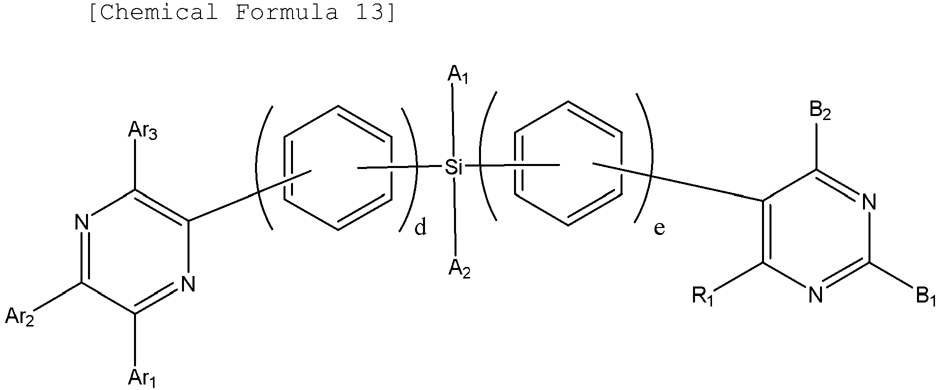 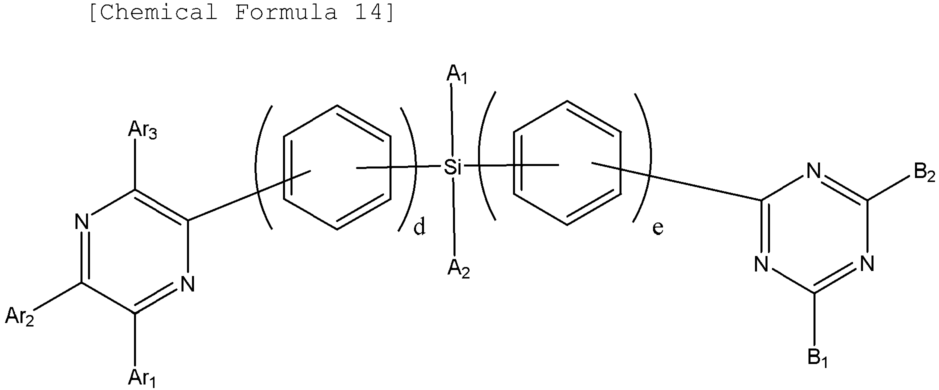 wherein the formulas,
Ar₁ to Ar₃, A₁ to A₂, B₁ to B₂, d and e are each as defined in claim 1.

15. The compound of Claim 1, wherein the compound represented by Chemical Formula 1 is a compound represented by any one of Chemical Formulas 15 to Chemical Formula 18 below: 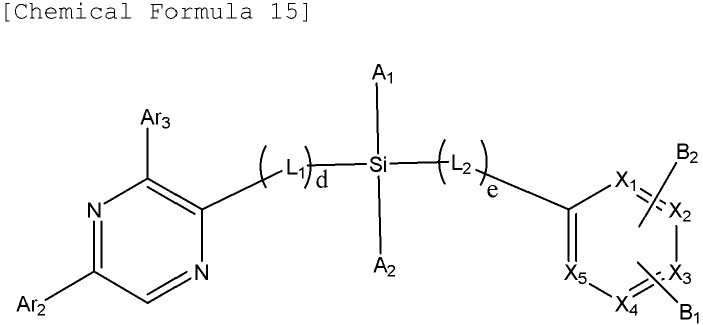 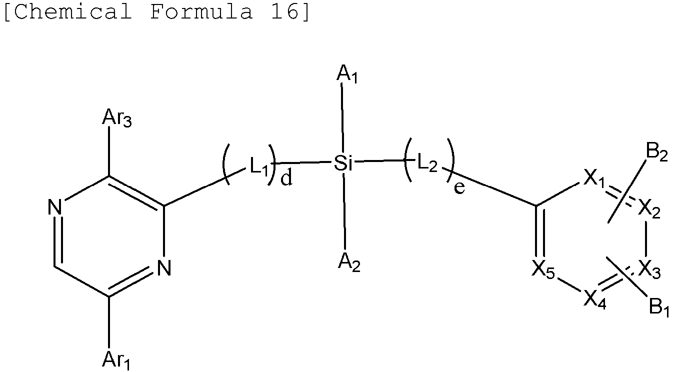 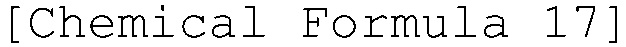 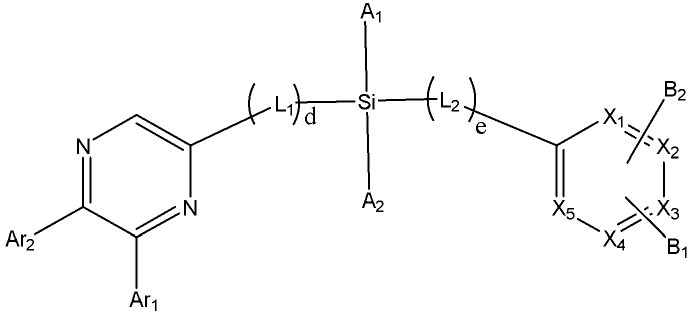 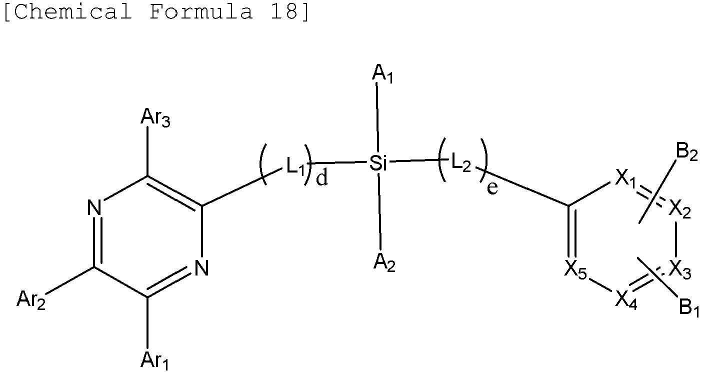 wherein the formulas,
X₁ to X₅, Ar₁ to Ar₃, A₁ to A₂, B₁ to B₂, L₁ to L₂, d and e are each as defined in claim 1, provided that cases where Ar₁ to Ar₃ are hydrogen are excluded.

16. The compound of Claim 1, wherein the compound represented by Chemical Formula 1 is selected from compounds represented by any one of the following Chemical Formulas 1 to 128.

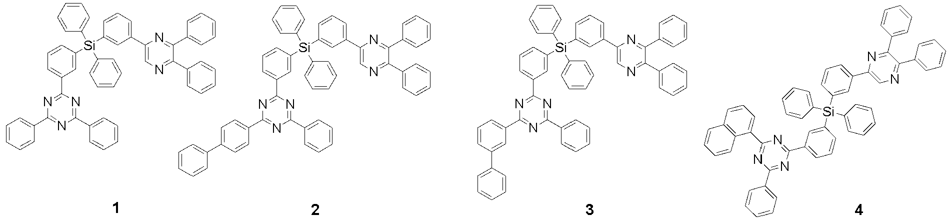

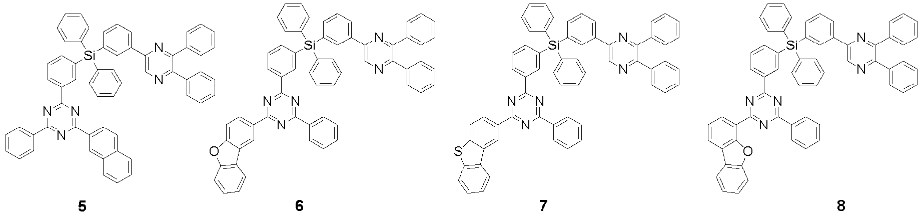

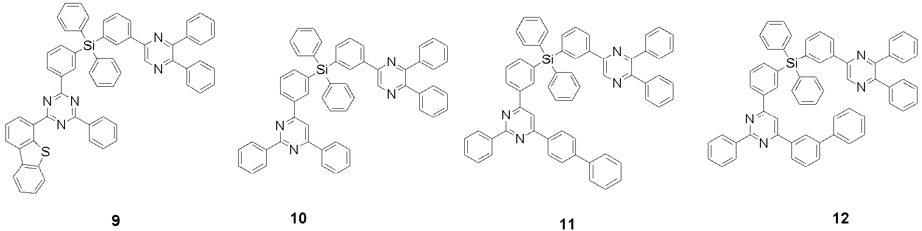

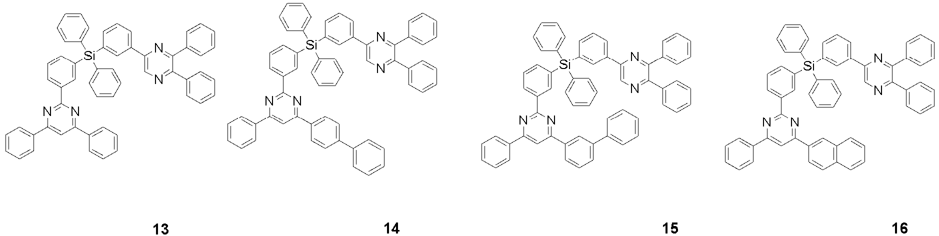

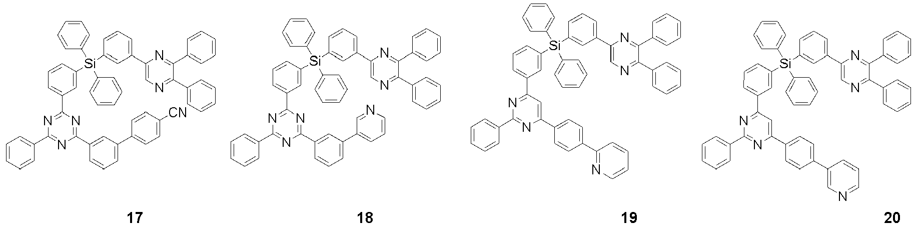

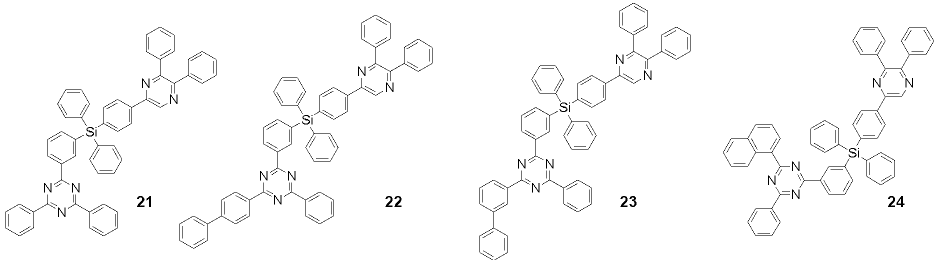

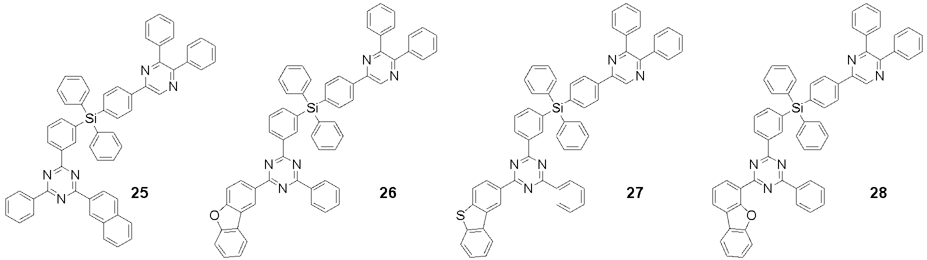

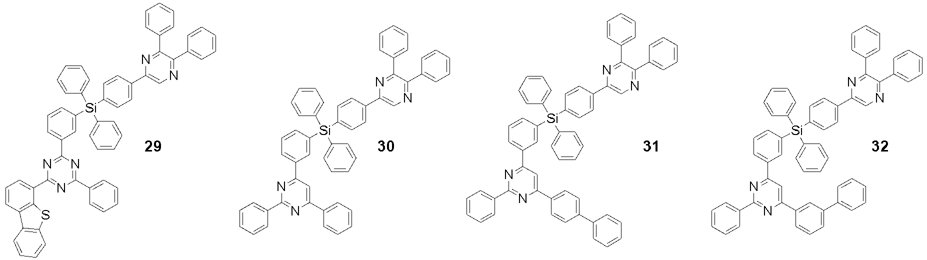

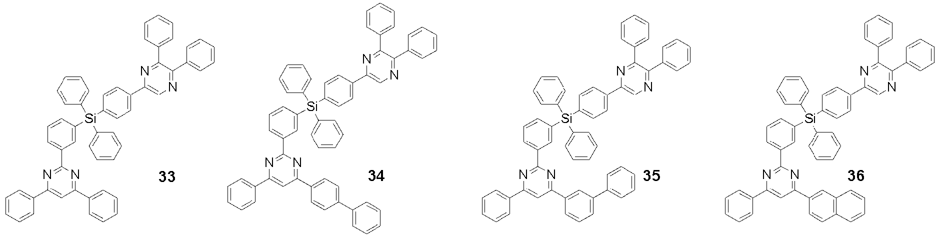

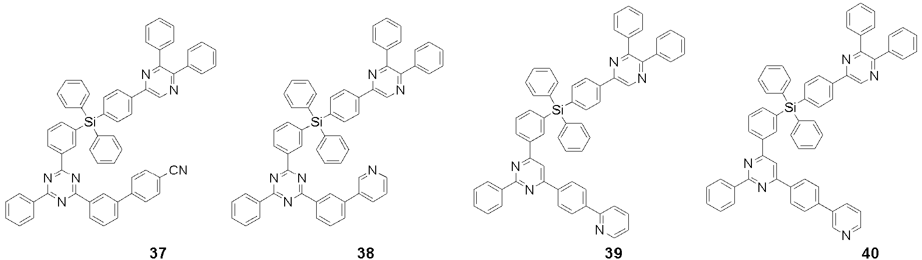

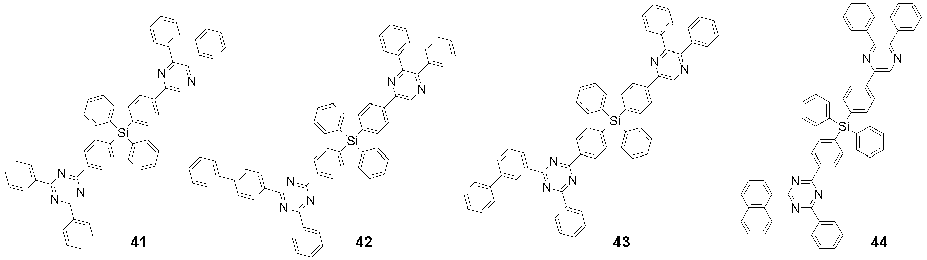

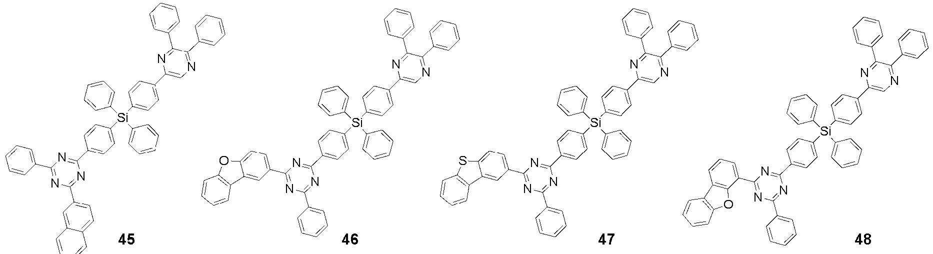

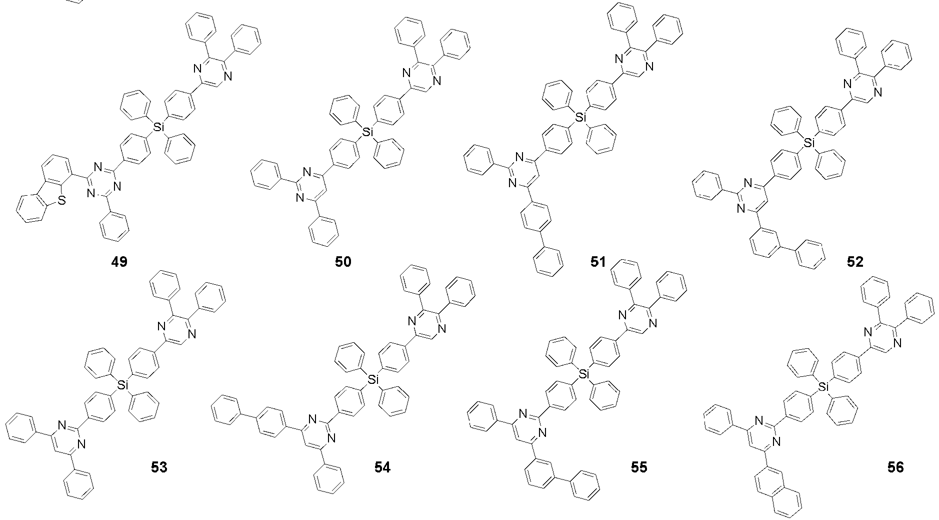

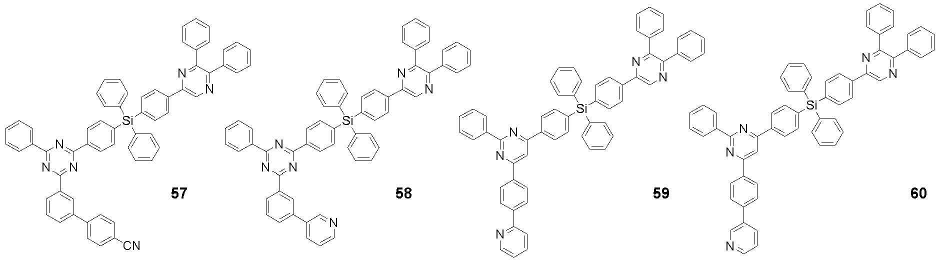

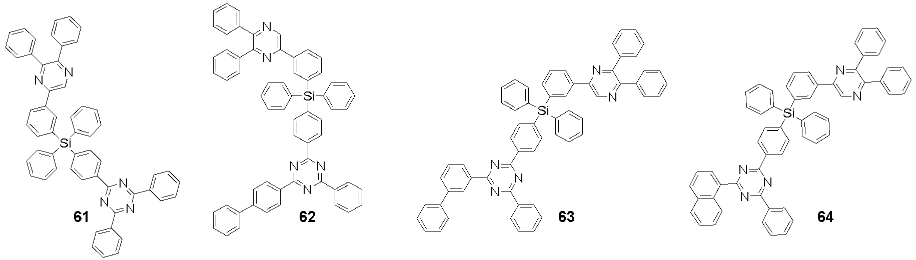

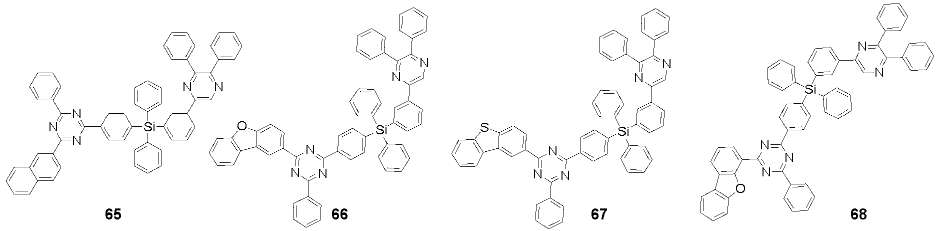

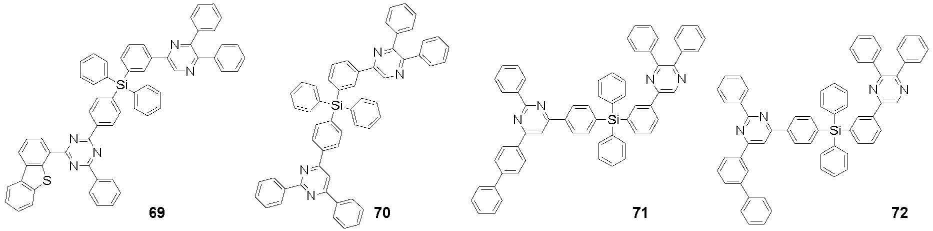

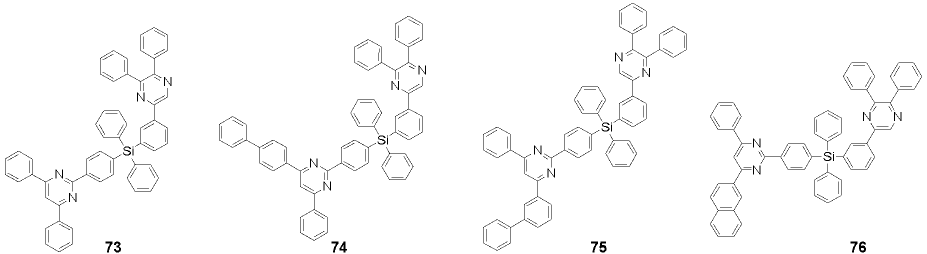

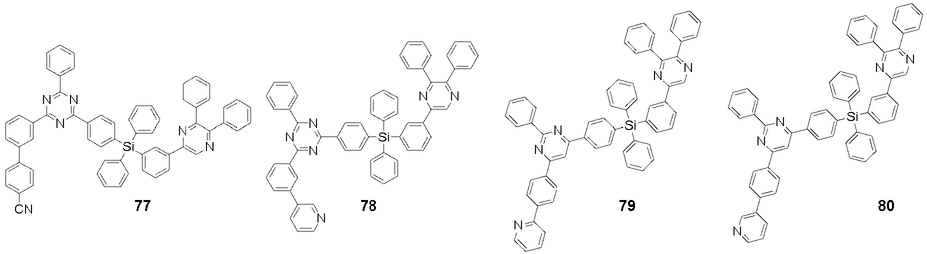

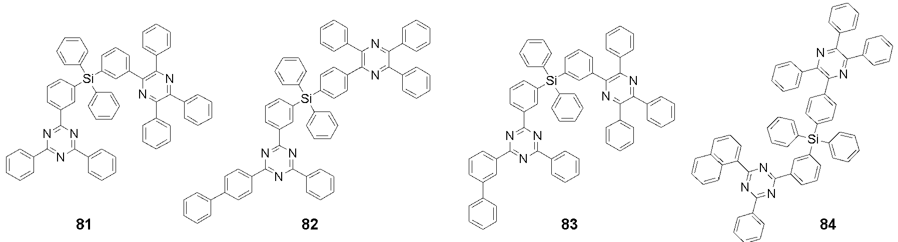

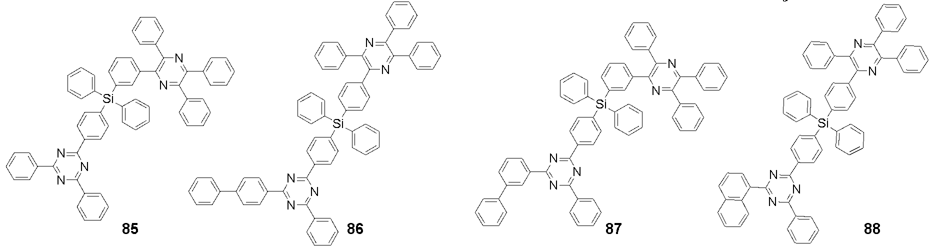

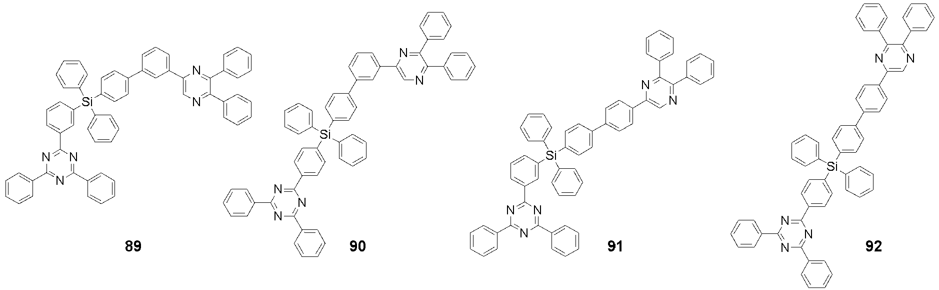

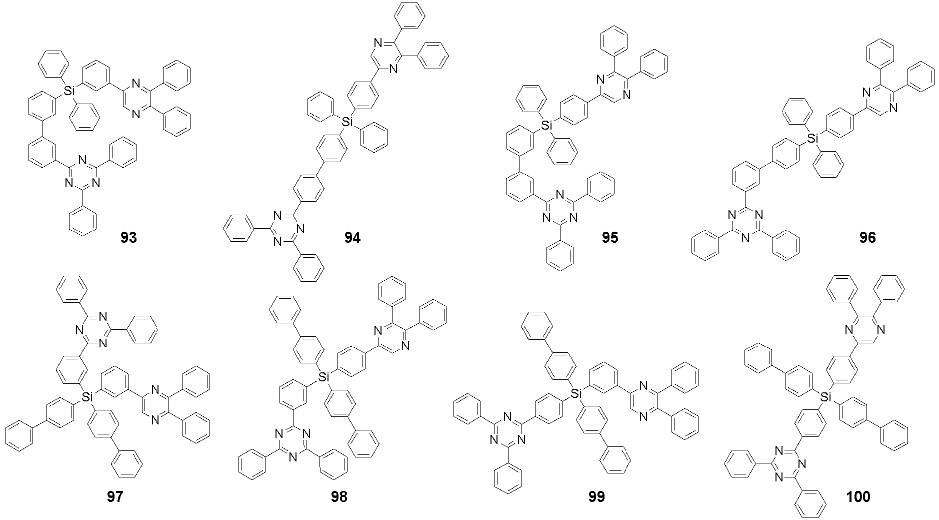

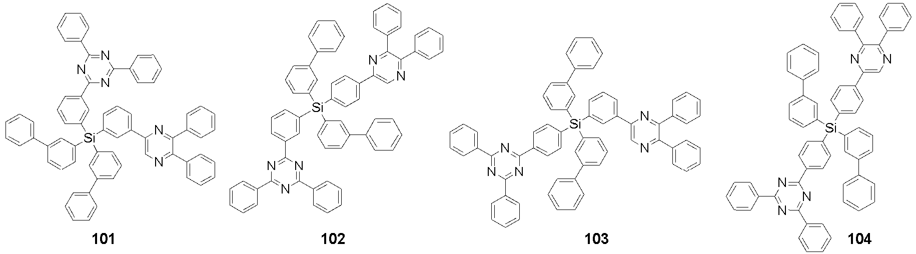

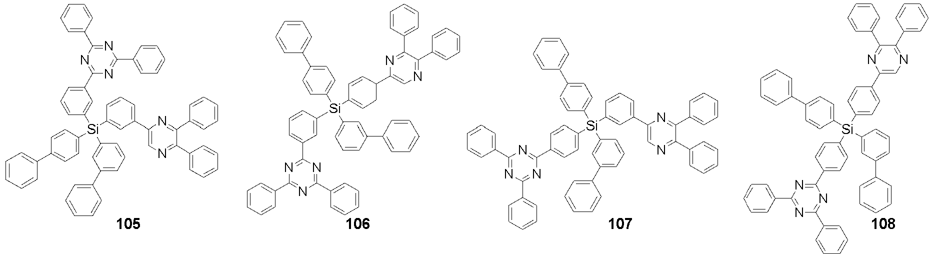

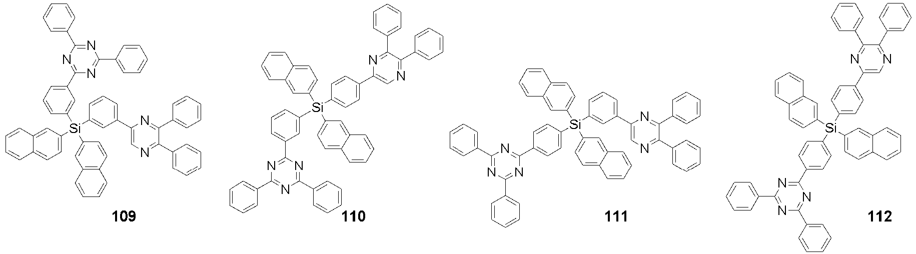

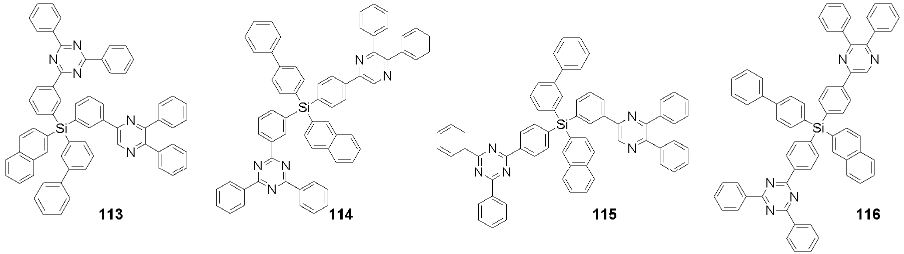

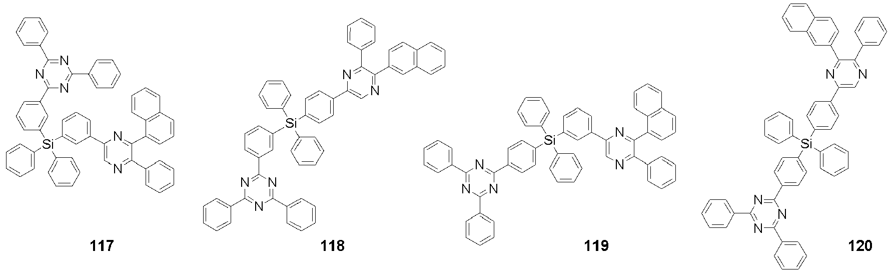

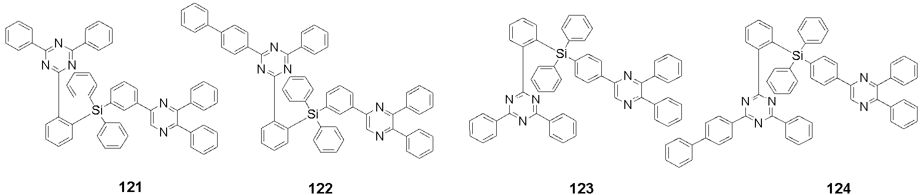

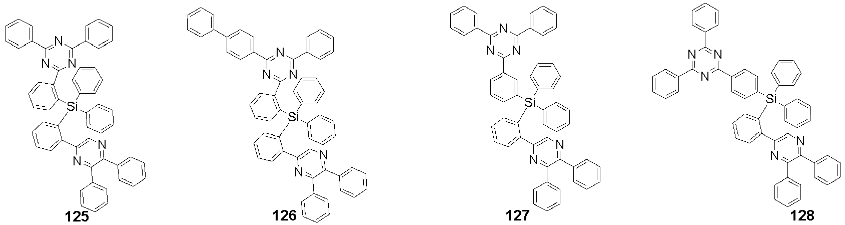

17. The compound of Claim 1, wherein the compound represented by Chemical Formula 1 is used as a material of a light emitting layer, a light emitting auxiliary layer, an electron transport layer, or an electron transport auxiliary layer.

18. An organic electroluminescent device comprising:
an anode;
a cathode; and
one or more organic layers disposed between the anode and the cathode,
wherein at least one of the one or more organic layers comprises the compound according to any one of claims 1 to 17.

19. The organic electroluminescent device of claim 18, wherein the organic layer comprising the compound is selected from the group consisting of a light emitting layer, a light emitting auxiliary layer, a lifespan improvement layer, an electron transport layer, and an electron transport auxiliary layer.
